# EUROPEAN PATENT SPECIFICATION

(11) **EP 4 075 530 B1**
(45) Date of publication and mention of the grant of the patent: **29.05.2024**
(21) Application number: 22167861.8
(22) Date of filing: 12.04.2022
(51) Int. Cl.: H10K 50/11, H10K 50/18, H10K 50/155, H10K 50/165, H10K 50/17

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ET DISPOSITIFS ÉLECTROLUMINESCENTS ORGANIQUES

(30) Priority: 14.04.2021 US 202163174954 P; 04.04.2022 US 202217713141
(43) Date of publication of application: 19.10.2022
(73) Proprietor: Universal Display Corporation, Ewing, NJ 08618 (US)
(72) Inventor: THOMPSON, Nicholas J., Ewing, NJ 08618 (US); WEAVER, Michael S., Ewing, NJ 08618 (US); LIN, Chun, Ewing, NJ 08618 (US)
(74) Representative: Maiwald GmbH

(56) References cited:
- EP-A1- 3 208 861
- US-A1- 2007 231 596
- US-A1- 2020 168 818
- US-A1- 2021 036 065

## Description

### FIELD

The present disclosure generally relates to organometallic compounds and formulations and their various uses including as emitters in devices such as organic light emitting diodes and related electronic devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as flat panel displays, illumination, and backlighting.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

US 2020/168818 A1 discloses an OLED whose emissive layer has a first host and an emitter, where the emitter is a phosphorescent metal complex that is a Pt(II) or Pd(II) complex having a square planar coordinating geometry or has the formula of M(L¹)ₓ(L²)_{y}(L³)_{z}, where E_{H1T}, the T₁ triplet energy of the first host, is higher than E_{ET}, the T₁ triplet energy of the emitter, where E_{ET} is at least 2.50 eV, where the LUMO energy of the first host is higher than the HOMO energy of the emitter, where the absolute value of the difference between the HOMO energy of the emitter and the LUMO energy of the first host is ΔE1, where a≤ΔE1-E_{ET}≤b; and where a≥0.05 eV, and b≤0.60 eV. US 2021/036065 A1 relates to OLED devices and stacks for OLED devices that include a symmetric emissive-layer architecture. In one embodiment, the present invention relates to an emissive stack having three layers, wherein the top and bottom layers emit light in the same or similar color region while the middle layer emits light in a different color region than the other two layers. In such an embodiment, the three layers are in contact with each other with no other layers in between. EP 3 208 861 A1 is directed to an organic light emitting diode comprising: at least one anode electrode; at least one emission layer, wherein the emission layer comprises at least one emitter dopant that emits visible light at operation of the OLED; an electron transport layer stack of at least two electron transport layers, and wherein a) the first electron transport layer comprises i) a first organic aromatic matrix compound having a MW of about ≥ 400 to about ≤ 1000 and a dipole moment of about ≥ 0 Debye and about ≤ 2.5 Debye, wherein the first electron transport layer is free of a polar organic aromatic phosphine compound; and b) the second electron transport layer comprises two organic aromatic matrix compounds, which are a mixture of: i) the first organic aromatic matrix compound; and ii) a polar organic aromatic phosphine compound having a MW of about ≥ 400 to about ≤ 1000, and a dipole moment of about > 2.5 Debye and about ≤ 10 Debye; and at least one cathode electrode layer; wherein the electron transport layer stack is arranged between the emission layer and the cathode electrode layer, the first electron transport layer is in direct contact with the second electron transport layer, and wherein the first electron transport layer is arranged nearer to the emission layer and the second electron transport layer is arranged nearer to the cathode electrode layer. US 2007/231596 A1 discloses and OLED structure that includes a substrate; an anode and a cathode; a light-emitting layer disposed between the anode and cathode; and a hole-transporting structure disposed between the light-emitting layer and the anode including two or more sublayers; a first sublayer in contact with the light-emitting layer and including a first hole-transporting material and a first stabilizing dopant, and a second sublayer including a second hole-transporting material and a second stabilizing dopant, and a third dopant having a bandgap that is smaller than each of the bandgaps of the second hole-transporting material and the second stabilizing dopant, respectively.

### SUMMARY

In one aspect, the present disclosure provides an organic light emitting device (OLED) architecture in which efficient operation is achieved for the OLED having three hosts in the emissive layer by incorporating at least one multi-component functional layer selected from the group consisting of an electron blocking layer, and a hole blocking layer as defined in claim 1.

In yet another aspect, the present disclosure provides a consumer product comprising the OLED of the present disclosure.

### BRIEF DESCRIPTION OF THE DRAWINGS

All figures are schematic and are not intended to show actual dimensions.
FIG. 1 shows an organic light emitting device.
FIG. 2 shows an inverted organic light emitting device that does not have a separate electron transport layer.
FIG. 3 illustrates the interior shape parameters for red, green, yellow, and blue in 1931 CIE coordinate.
FIG. 4 is an illustration of two materials having different HOMO energy levels.
FIG. 5 is an illustration of two materials having different LUMO energy levels.
FIGS. 6A-11F are illustrations of the various energy level diagrams for embodiments of EMLs comprising three or more components that are utilized in combination with blocking layers comprising two or more components.
FIGS. 12A - 12D are illustrations of energy level diagrams for example embodiments, each having a combination of a 2-component EBL with a 3-component EML.
FIGS. 13A - 13D are illustrations of energy level diagrams for example embodiments, each having a combination of a 2-component HBL with a 3-component EML.
FIGS. 14A - 14C are illustrations of energy level diagrams for example embodiments, each having a combination of a 2-component HBL with a 3-component EML, each illustrating a different configuration between the HBL and EML, where the energy level configuration of the 2 components in the HBL is the configuration shown in FIG. 13A.
FIGS. 15A-15F are illustrations of energy level diagrams for example 4-component EMLs. Each diagram illustrates a different energy level configuration among an emitter compound and three host compounds.
FIGS. 16A-16F are illustrations of energy level diagrams for more example 4-component EMLs. Each diagram illustrates a different energy level configuration among an emitter compound and three host compounds.
FIGS. 17A-17F are illustrations of energy level diagrams for more example 4-component EMLs. Each diagram illustrates a different energy level configuration among an emitter compound and three host compounds.
FIGS. 18A-18F are illustrations of energy level diagrams for more example 4-component EMLs. Each diagram illustrates a different energy level configuration among an emitter compound and three host compounds.
FIGS. 19A-19D are illustrations of energy level diagrams for example 3-component EMLs. Each diagram illustrates a different energy level configuration among an emitter compound and two host compounds.
FIGS. 20A-20E are illustrations of energy level diagrams for more example 4-component (EMLs. Each diagram illustrates a different energy level configuration among an emitter compound and three host compounds.
FIG. 21A is an illustration of an example of HOMO/LUMO energy configuration for two materials having different HOMO energy levels and different LUMO energy levels.
FIG. 21B is an illustration of another example of HOMO/LUMO energy configuration for two materials having different HOMO energy levels and different LUMO energy levels.
FIG. 22A is an illustration of another example of HOMO/LUMO energy configuration for two materials having different HOMO energy levels and different LUMO energy levels.
FIG. 22B is an illustration of another example of HOMO/LUMO energy configuration for two materials having different HOMO energy levels and different LUMO energy levels.

### DETAILED DESCRIPTION

### A. Terminology

Unless otherwise specified, the below terms used herein are defined as follows:
As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical (C(O)-Rₛ).

The term "ester" refers to a substituted oxycarbonyl (-O-C(O)-Rₛ or -C(O)-O-Rₛ) radical.

The term "ether" refers to an -ORₛ radical.

The terms "sulfanyl" or "thio-ether" are used interchangeably and refer to a -SR, radical.

The term "selenyl" refers to a -SeRₛ radical.

The term "sulfinyl" refers to a -S(O)-Rₛ radical.

The term "sulfonyl" refers to a -SO₂-Rₛ radical.

The term "phosphino" refers to a -P(Rₛ)₃ radical, wherein each Rₛ can be same or different.

The term "silyl" refers to a -Si(Rₛ)₃ radical, wherein each Rₛ can be same or different.

The term "germyl" refers to a -Ge(Rₛ)₃ radical, wherein each Rₛ can be same or different.

The term "boryl" refers to a -B(Rₛ)₂ radical or its Lewis adduct -B(Rₛ)₃ radical, wherein Rₛ can be same or different.

In each of the above, Rₛ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. Preferred Rₛ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group may be optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more general substituents.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the preferred general substituents are selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, and combinations thereof.

In some instances, the more preferred general substituents are selected from the group consisting of deuterium, fluorine, alkyl, cycloalkyl, alkoxy, aryloxy, amino, silyl, aryl, heteroaryl, sulfanyl, and combinations thereof.

In yet other instances, the most preferred general substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057 describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65 describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

### B. OLED Structures

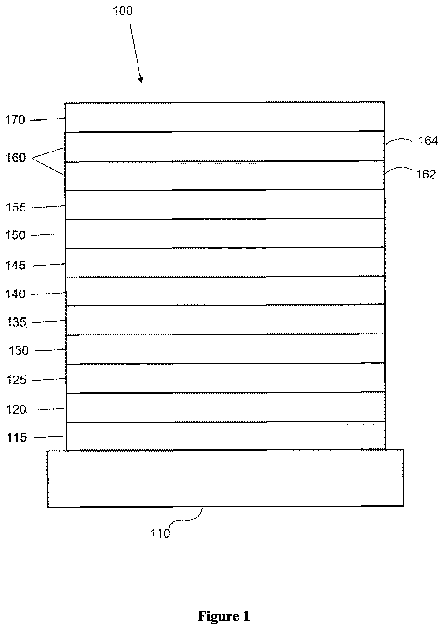

FIG. 1 shows an organic light emitting device **100.** The figures are not necessarily drawn to scale. Device **100** may include a substrate **110,** an anode **115,** a hole injection layer **120,** a hole transport layer **125,** an electron blocking layer **130,** an emissive layer **135,** a hole blocking layer **140,** an electron transport layer **145,** an electron injection layer **150,** a protective layer **155,** a cathode **160,** and a barrier layer **170.** Cathode **160** is a compound cathode having a first conductive layer **162** and a second conductive layer **164.** Device **100** may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al.. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

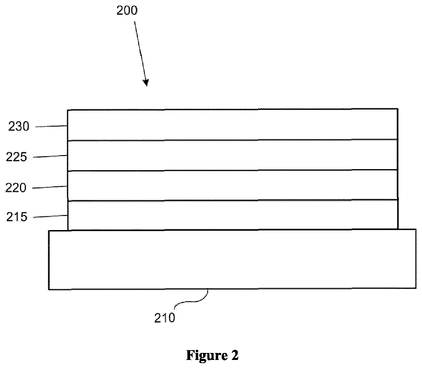

FIG. 2 shows an inverted OLED **200.** The device includes a substrate **210,** a cathode **215,** an emissive layer **220,** a hole transport layer **225,** and an anode **230.** Device **200** may be fabricated by depositing the layers described, in order. Because the most common OLED configuration has a cathode disposed over the anode, and device **200** has cathode **215** disposed under anode **230,** device **200** may be referred to as an "inverted" OLED. Materials similar to those described with respect to device **100** may be used in the corresponding layers of device **200.** FIG. 2 provides one example of how some layers may be omitted from the structure of device **100.**

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device **200,** hole transport layer **225** transports holes and injects holes into emissive layer **220,** and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

### C. The Inventive OLEDs of the Present Disclosure

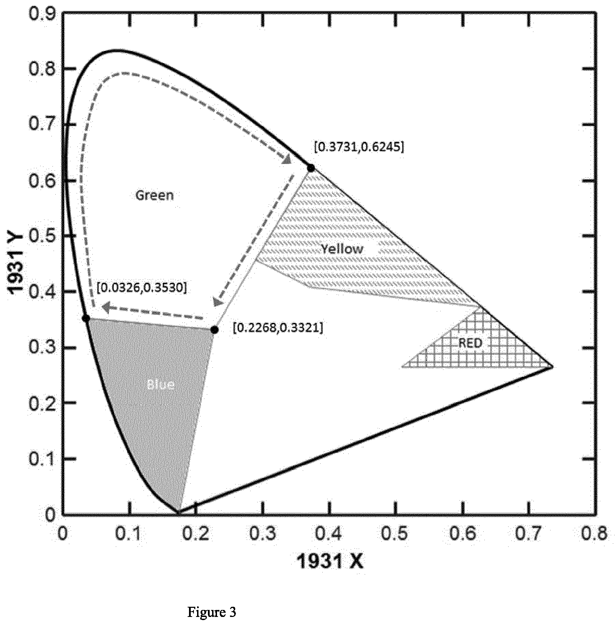

Based on our experimental results presented herein using blue emission phosphorescent OLEDs, we conclude that the efficiency of phosphorescent OLEDs having three host materials in the emissive layer (EML) can be improved by providing a blocking layer (electron blocking layer (EBL) or a hole blocking layer (HBL)) that comprises two or more blocking materials. Blue emission referred to herein is defined as wavelength less than 500 nm. In some cases, it may be preferable to describe the color of a component such as an emissive region, sub-pixel, color altering layer, or the like, in terms of 1931 CIE coordinates. Accordingly, as used herein, a color term also corresponds to a shape in the 1931 CIE coordinate color shape. The shape in 1931 CIE coordinate color space is constructed by following the locus between two color points and any additional interior points. For example, the interior shape parameters for red, green, yellow, and blue in 1931 CIE coordinate can be defined as shown below in Table 1 and as illustrated in FIG. 3.

**Table 1**

| **Color** | **CIE shape parameters** |
|---|---|
| Central Red | Locus: [0.6270,0.3725];[0.7347,0.2653]; Interior:[0.5086,0.2657] |
| Central Green | Locus: [0.0326,0.3530];[0.3731,0.6245]; Interior:[0.2268,0.3321] |
| Central Blue | Locus: [0.1746,0.0052];[0.0326,0.3530]; Interior:[0.2268,0.3321] |
| Central Yellow | Locus: [0.3731,0.6245];[0.6270,0.3725]; |
| | Interior: [0.3700,0.4087];[0.2886,0.4572]; |

Thus, for example, a "red" emissive region will emit light having CIE coordinates within the triangle formed by the vertices [0.6270,0.3725];[0.7347,0.2653]: [0.5086,0.2657]. Where the line between points [0.6270,0.3725] and [0.7347,0.2653] follows the locus of the 1931 color space. More complex color space regions can similarly be defined, such as the case with the green region. For example, the interior shape parameters for red, green, yellow, and blue may be defined as illustrated in FIG. 3.

### [OLED stack that includes at least one multi-component layer between the electrodes]

In one aspect, the present disclosure provides an organic light emitting device (OLED) comprising a light emitting stack that comprises:
a first electrode;
a second electrode; and
a first layer and an emissive layer (EML) disposed between the first electrode and the second electrode, wherein the first layer is an m-EBL comprising at least two components or an m-HBL comprising at least two components;
where when the first layer is an m-EBL, the first layer is adjacent to the EML and the OLED further comprises a HTL and a HIL disposed between the first layer and one of the two electrodes that is an anode or a charge generation layer (CGL)(if this electrode is between the current light emitting stack and another light emitting stack), (where the HTL can be an m-HTL in some embodiments and the HIL can be an m-HIL in some embodiments);
where when the first layer is an m-HBL, the first layer is adjacent to the EML and the OLED further comprises an ETL and an EIL disposed between the first layer and one of the two electrodes that is a cathode or a CGL (if this electrode is between the current light emitting stack and another light emitting stack), (where the ETL can be an m-ETL in some embodiments and the EIL can be an m-EIL in some embodiments)
wherein the EML comprises three host materials and a first emissive material dopant that is a phosphorescent emitter.

As used herein, when a layer is described as being "adjacent" to another layer, the two layers are in direct contact with each other. For example, if a second layer is formed directly on the surface of the first layer, the first and second layers are adjacent to each other.

The positional order of the group of layers EBL, HTL, and HIL and the group of layers HBL, ETL, and EIL in the OLED with respect to the EML and the anode and cathode electrodes are as shown in FIG. 1.

In some embodiments, the OLED is a single-stack device having one light emitting stack defined herein. In some embodiments, the OLED can be a stacked device, which refers to an OLED in which two or more light emitting stacks are stacked in series. In a stacked device the electrode that is situated between two adjacent light emitting stacks is referred to as a CGL.

In the present disclosure, each component in the multi-component layers is referring to a chemical compound and it is intended to mean that the multiple chemical compounds in the layer are mixed together in that layer. In such multi-component layer, each of the chemical compounds can have a uniform concentration throughout the bulk of the layer or can be present with a concentration gradient profile through the thickness of the layer. In other words, if x-y-z coordinate system is applied to a layer with the x-y plane representing the plane of the layer, the concentration gradient profile of a chemical compound defines the variation in the concentration of that chemical compound along the z axis of the layer. Each chemical compound in a given layer independently has its own concentration gradient profile. In some embodiments, the concentration gradient profile of each of the two or more chemical compounds in a given layer can be the same or different.

As a general matter, some of the functional layers (e.g. HIL, HTL, EBL, HBL, EIL, ETL, regardless of whether they are multi-component type or not) may be absent in a given OLED device. However, the functional layer pairs HTL/HIL and/or ETL/EIL are considered as essential layers when their respective EBL and/or HBL are present in the OLED. In other words, EBL and HBL each can only be present where there are at least three different layers present between the respective electrode and the EML, where the three layers include EBL or HBL depending on which electrode side of the OLED. For example, If an OLED has an EBL adjacent the EML between the EML and the anode, there must be an HTL and an HIL between the EBL and the anode. If an OLED has an HBL adjacent the EML between the EML and the cathode, there must be an ETL and an EIL between the HBL and the cathode. The functional layer pairs HTL/HIL and/or ETL/EIL, however, can be present in an OLED without EBL or HBL present.

In some embodiments, when the first layer is a m-EBL, the m-EBL comprises at least two electron blocking materials. In some embodiments, when the first layer is a m-HBL, the m-HBL comprises at least two hole blocking materials.

In some embodiments of the OLED of the present disclosure, the EML can comprise one or more emitter materials and up to three host materials. In some embodiments, the minimum number of components in the EML is selected from the group consisting of 4, 5, 6, 7, and 8.

In some embodiments, the minimum number of components in each of the m-EBL, and the m-HBL is independently selected from the group consisting of 2, 3, 4, 5, and 6.

In some embodiments, light emitting stack of the OLED can further comprise a second layer disposed between the two electrodes; where the second layer is configured to be one of the layers in the following Functional Layer Group: a multi-component hole injecting layer (m-HIL), a multi-component hole transporting layer (m-HTL), a multi-component electron blocking layer (m-EBL), a multi-component hole blocking layer (m-HBL), a multi-component electron transporting layer (m-ETL), and a multi-component electron injecting layer (m-EIL); and is a different type of layer from the first layer;
wherein the m-EBL and m-HBL each comprises at least two components, and the m-HIL, m-HTL, m-EIL, and m-ETL each comprises at least three components;
wherein when the second layer is an m-EBL, the second layer is adjacent to the EML and the OLED further comprises a HTL and a HIL disposed between the second layer and one of the two electrodes that is an anode or a CGL (if this electrode is between the light emitting stack and another light emitting stack), (where the HTL and the HIL can independently be an m-HTL and an m-HIL);
wherein when the second layer is an m-HBL, the second layer is adjacent to the EML and the OLED further comprises an ETL and an EIL disposed between the second layer and one of the two electrodes that is a cathode or a CGL (if this electrode is between the light emitting stack and another light emitting stack), (where the ETL and the EIL can independently be an m-ETL and an m-EIL). As used herein, "a different type of layer" means, for example, if the first layer is a m-HIL, then the second layer can only be one of the layers in the Functional Layer Group other than the m-HIL.

In some embodiments, the minimum number of components in each of the m-HIL, the m-HTL, the m-ETL, and the m-EIL is independently selected from the group consisting of 3, 4, 5, and 6.

In some embodiments, each component in a layer in direct contact with (i.e., directly adj acent to) the EML has a higher T₁ energy than any component in the EML by at least 0.1 eV. In some embodiments, each component in a layer in direct contact with the EML has a higher T₁ energy than any component in the EML by at least 0.2 eV. In some embodiments, each component in a layer in direct contact with the EML has a higher T₁ energy than any component in the EML by at least 0.3 eV.

In some embodiments, the at least two components in the m-EBL have HOMO energy levels that are within 0.4 eV, within 0.3 eV, preferably within 0.2 eV, or more preferably within 0.1 eV of each other. In some embodiments, the at least two components in the m-EBL have LUMO energy levels that are within 0.4 eV, within 0.3 eV, preferably within 0.2 eV, or more preferably within 0.1 eV of each other.

In some embodiments, the at least two components in the m-HBL have LUMO energy levels that are within 0.4 eV, within 0.3 eV, preferably within 0.2 eV, or more preferably within 0.1 eV of each other. In some embodiments, the at least two components in the m-HBL have HOMO energy levels that are within 0.4 eV, within 0.3 eV, preferably within 0.2 eV, or more preferably within 0.1 eV of each other.

In some embodiments, when the second layer is a m-EBL, the m-EBL comprises at least two electron blocking materials. In some embodiments, when the second layer is a m-HBL, the m-HBL comprises at least two hole blocking materials.

In some embodiments, the EML comprises an emitter, a hole transporting host, and an electron transporting host.

In some embodiments, the EML comprises an emitter, a hole transporting host, an electron transporting host, and a wide-band gap host.

In some embodiments, the EML comprises an acceptor which also functions as an emitter, a sensitizer, and/or a host.

In some embodiments, the EML comprises an acceptor, an emitter which receives the exciton energy from the acceptor, a sensitizer, and/or a host. The acceptor in this device receives the energy from the sensitizer, and transfer it to another compound (emitter) which eventually emits the light. The acceptor here may also partially emit the light, or may not emit the light at all.

In some embodiments, the EML comprises an acceptor, a sensitizer, a hole transporting host, and an electron transporting host.

In some embodiments, two of the components of the EML other than the emitter form an exciplex.

In some embodiments, the at least two components of the m-EBL comprises at least two electron blocking materials. In some embodiments, the at least two components of the m-HBL comprises at least two hole blocking materials. In some embodiments, each of the m-EBL and m-HBL comprises at least one hole transporting material, and at least one electron transporting material.

Some embodiments of the OLED of the present disclosure comprises an m-EBL comprising at least two electron blocking materials and the EML comprises up to three organic host materials, and a first emissive material dopant that is an organic phosphorescent emitter. Some embodiments of the OLED of the present disclosure comprises an m-EBL comprising at least two electron blocking materials and the EML comprises three organic host materials, and a first emissive material dopant that is an organic phosphorescent emitter. In some embodiments, the organic phosphorescent emitter can be a blue phosphorescent emitter. In some embodiments, the three host materials in the EML includes at least one electron transporting host and at least one hole transporting host.

Some embodiments of the OLED of the present disclosure comprises an m-HBL comprising at least two hole blocking materials and the EML comprises up to three organic host materials, and a first emissive material dopant that is an organic phosphorescent emitter. Some embodiments of the OLED of the present disclosure comprises an m-HBL comprising at least two hole blocking materials and the EML comprises three organic host materials, and a first emissive material dopant that is an organic phosphorescent emitter. In some embodiments, the organic phosphorescent emitter can be a blue phosphorescent emitter. In some embodiments, the three host materials in the EML includes at least one electron transporting host and at least one hole transporting host.

### [Multi-component EBL]

In some embodiments, the m-EBL further comprises a hole transporting material and an electron transporting material. In some embodiments, the energetics of these materials are such that there would be an off-set between the LUMO of the electron transporting material in the m-EBL and the deepest LUMO in the EML.

Generally, a material selected for the m-EBL, m-HBL, or as a host for a phosphorescent emitter has a triplet energy level T₁. The triplet energy level T₁ can be obtained from emission onset taken at 20% of the peak height of the gated emission of a frozen sample in 2-MeTHF at 77 K. For example, the gated emission spectra can be collected on a Horiba Fluorolog-3 spectrofluorometer equipped with a Xenon Flash lamp with a flash delay of 10 milliseconds and a collection window of 50 milliseconds with the sample excited at 300nm. If the triplet energy level T₁ of the materials in the blocking layers exceeds the triplet energy level T₁ of the emissive material in the EML by at least 0.2 eV, then the triplet energy level T₁ of the blocking layer material is enough to limit quenching. In these cases, the materials are considered 'high triplet energy' materials as they will not substantially lower the efficiency of the OLED device.

In some embodiments, the difference between the triplet energy levels T₁ of any two materials in the m-EBL is greater than 0.2 eV. By having one material with a higher triplet energy than the other components in the m-EBL there will be a reduction of the exciton quenching from the emissive layer to the components in the m-EBL. Reduced exciton quenching leads to higher device efficiency and longer device lifetime because less current will be required to achieve the same brightness or through minimizing detrimental reactions that can occur when a triplet exciton is placed on a material that is not an emitter.

In some embodiments, there are two electron blocking materials in the m-EBL. The two electron blocking materials are chosen such that they complement each other and add to the performance of the m-EBL. For example, if one of the two electron blocking materials of the m-EBL is a high triplet energy material then the second of the two electron blocking materials can be a hole transporting material, which is selected to help lower the operating voltage of the OLED by facilitating hole transport through the EBL.

In another embodiment where there are two electron blocking materials in the m-EBL, the one of the two electron blocking materials is a hole transporting material and the second of the two electron blocking materials is an electron transporting material. The second electron blocking material adds the benefit of electron transport to the m-EBL and it also provides a material in the m-EBL that is stable to electrons that can leak from the EML.

In another embodiment of the m-EBL, the two electron blocking materials are both hole transporting materials but one has a greater hole mobility but a deeper HOMO level than the other one. In this embodiment, the addition of the higher hole mobility material reduces operating voltage of the device. However, the m-EBL will perform better than if only the second material was used as the m-EBL because the shallow HOMO level of the first material allows for more efficient injection of holes into the emissive layer. If an organometallic complex is utilized as the second material in the m-EBL, it may have the shallowest HOMO level such that it will be the hole transporting material in the m-EBL.

In some embodiments, in addition to the two or more electron blocking materials, the m-EBL can further include another type of material (i.e., not an electron blocking material) or an organometallic complex. The third material is designed to add additional capabilities to the m-EBL layer. For example, if the first two materials in the m-EBL contain first a high triplet material and second an electron transporting material, then the third material may be a hole transporting material, which is selected to help lower the operating voltage of the OLED.

In some embodiments where there are three electron blocking materials in the m-EBL, if the first material is a hole transporting material and the second material is an inert material with high triplet energy, then the third material could be an electron transporting material. In this case, the third material is chosen to add the benefit of electron transport to the m-EBL or a material component in the m-EBL that is stable to electrons that can leak from the EML.

In another embodiment having three materials in the m-EBL, the m-EBL is composed of one hole transporting material and one electron transporting material. Another hole transporting material is added which has a greater hole mobility but a deeper HOMO level. In this embodiment, the addition of the higher hole mobility material reduces operating voltage of the device. However, the m-EBL will perform better than if it did not have the first hole transporting material with a more shallow HOMO level because the shallow HOMO level of the first hole transporting material allows for more efficient injection of holes into the emissive layer. If an organometallic complex is utilized as the third component in the m-EBL, it may have the shallowest HOMO level such that it will be the hole transporting material in the m-EBL. In some cases, the organometallic complex has a greater hole mobility than the other EBL materials in the m-EBL, and the organometallic complex functions as a hole transporting material and carry holes. In some embodiments, the same organometallic complex is the emitter in the EML.

In some embodiments, the m-EBL has two electron blocking materials and they form an exciplex. An exciplex is an excited state that is shared between two molecules. Generally, an exciplex can form when the energy difference between the shallowest HOMO and deepest LUMO is great er than 1.9 eV. Exciplex formation can be observed by measuring the photoluminescence (PL) spectrum of a solid state, one to one, mixture of the two materials can comparing that to the PL of the individual components. An exciplex has formed when there is emission from a lower energy species present in the mixture of materials that is not present from each component. In some embodiments, the PLQY of the exciplex formed is greater than 30% and in other embodiments it is greater than 70%. Exciplex formation within the blocking layers can be beneficial as it provides a stable excited state for any hole or electrons pairs that arrive in the blocking layer. Further, if the exciplex energy is high enough, it could energy transfer to the emitter in the emissive layer, thereby increase efficiency of the OLED device.

In some embodiments, there are three materials in the m-EBL and one of the materials is an organometallic complex.

In some embodiments, the m-EBL can include a fluorescent emitter material.

In some embodiments, the m-EBL includes a material that non-radiatively recombines excitons. The material which non-radiatively recombine excitons have a photoluminescent quantum yield (PLQY) preferentially below 30%, more preferably below 15%, most preferably below 10%. Because materials that are utilized in EBLs typically have long triplet excited state lifetimes, by non-radiatively recombining excitons which are formed in the m-EBL, this reduces the excited state duration for excitons in the m-EBL, thereby increase the stability of the device.

### [Multi-component HBL]

In some embodiments, the m-HBL further comprises a hole transporting material and an electron transporting material. In some embodiments, the energetics of these materials are such that there would be an off-set between the LUMO of the hole transporting material in the m-HBL and the deepest LUMO in the EML. In some embodiments, the difference between the triplet energy levels T₁ of any two materials in the m-HBL is greater than 0.2 eV. By having one material component with a higher triplet energy than the other components in the m-HBL there will be a reduction of the exciton quenching from the emissive layer to the components in the m-HBL. Reduced exciton quenching leads to higher device efficiency and longer device lifetime because that will reduce the amount of current required in the device to reach the same brightness or through minimizing detrimental reactions that can occur when a triplet exciton is placed on a material that is not an emitter.

In some embodiments, there are two hole blocking materials in the m-HBL. The two hole blocking materials are chosen such that they complement each other and add to the performance of the m-HBL. For example, if one of the two hole blocking materials of the m-HBL is a high triplet energy material then the second of the two hole blocking materials can be an electron transporting material, which is selected to help lower the operating voltage of the OLED by facilitating electron transport through the m-HBL.

In another embodiment where there are two hole blocking materials in the m-HBL, one of the two hole blocking materials is an electron transporting material and the second of the two hole blocking materials is a hole transporting material. The second hole blocking material adds the benefit of hole transport to the m-HBL and it also provides a material in the m-HBL that is stable to holes that can leak from the EML.

In another embodiment of the m-HBL, the two hole blocking materials are both electron transporting materials but one has a greater electron mobility but a shallower LUMO level than the other one. In this embodiment, the presence of the higher electron mobility material reduces operating voltage of the OLED by increasing the conductivity of electrons through the m-HBL layer. The m-HBL having these two hole blocking materials will perform better than if only the second material was used as a hole blocking material only because the deeper LUMO level of the first hole blocking material allows for more efficient injection of electrons into the emissive layer. If an organometallic complex is utilized as the second hole blocking material component in the m-HBL, it can be a material having the deepest LUMO level in the m-HBL such that it will be the electron transporting material in the m-HBL.

In some embodiments, in addition to the two or more hole blocking materials, the m-HBL can further include another type of material (i.e., not a hole blocking material) or an organometallic complex. The third material is designed to add additional capabilities to the m-HBL layer. For example, if the first two materials in the m-HBL contain first a high triplet material and second an hole transporting material, then the third material may be an electron transporting material, which is selected to help lower the operating voltage of the OLED. If the additional component is an organometallic complex, it is selected to have a greater electron mobility than the other components in the m-HBL. Because the organometallic complex has a greater electron mobility than the other components, the organometallic complex functions as an electron transporting material and carry electrons while being dispersed in a high T₁ energy material which will prevent quenching by the EML. In some embodiments, the same organometallic complex is the emitter in the EML.

In some embodiments where there are three hole blocking materials in the m-HBL, if the first material is an electron transporting material and the second material is an inert material with high triplet energy T₁, then the third material could be a hole transporting material. In this case, the third material is chosen to add the benefit of hole transport to the m-HBL or a material component in the m-HBL that is stable to holes that can leak from the EML.

In another embodiment of the m-HBL, the m-HBL is composed of one electron transporting material and one hole transporting material. Another electron transporting material is added which has a greater electron mobility but a shallower LUMO level. In this embodiment, the addition of the higher electron mobility material reduces operating voltage of the device. However, the m-HBL will perform better than if it did not have the first electron transporting material with a deeper LUMO level because the deep LUMO level electron transporting material allows for more efficient injection of electrons into the emissive layer. If an organometallic complex is utilized as the third component in the m-HBL, it may have the deepest LUMO level such that it will be the electron transporting material in the m-HBL. In some cases, the organometallic complex has a greater electron mobility than the other HBL materials in the m-HBL, and the organometallic complex functions as an electron transporting material and carry electrons. In some embodiments, the same organometallic complex is the emitter in the EML.

In some embodiments, the m-HBL has two hole blocking materials and they form an exciplex. Exciplex formation within the m-HBLs can be beneficial as it provides a stable excited state for any hole pairs that arrive in the blocking layer. Further, if the exciplex energy is high enough, it could energy transfer to the emitter in the emissive layer, thereby increase efficiency of the OLED device.

In some embodiments, the m-HBL can include a fluorescent emitter material.

In some embodiments, the m-HBL includes a material that non-radiatively recombines excitons. The material which non-radiatively recombine excitons have a photoluminescent quantum yield (PLQY) preferentially below 30%, more preferably below 15%, most preferably below 10%. Because materials that are utilized in HBLs typically have long triplet excited state lifetimes, by non-radiatively recombining excitons which are formed in the m-HBL, this reduces the excited state duration for excitons in the m-HBL, thereby increase the stability of the device.

In some embodiments, the phosphorescent emitter material in the EML may be a blue emitter material. In some embodiments of the OLED with an EML that includes a phosphorescent emitter material and an m-EBL, the OLED can include a single-component HBL, an m-HBL, or no HBL. In some embodiments of the OLED with an EML that includes a phosphorescent emitter material and an m-HBL, the OLED can include a single-component EBL, a m-EBL, or no EBL.

In some embodiments, in addition to the two hole blocking materials, the m-HBL can further include a material that is an organometallic complex.

In some embodiments, there are two hole blocking materials in the m-HBL and they form an exciplex.

In some embodiments, there are three materials in the m-HBL and one of the materials is an organometallic complex.

### [OLED including both an m-EBL and an m-HBL]

In some embodiments of the OLED with an EML that includes a phosphorescent emitter material can include both an m-EBL and an m-HBL. Thus, also provided herein is an OLED comprising a light emitting stack that comprises:
a first electrode;
a second electrode;
an EML disposed between the first and second electrodes;
an m-EBL disposed between the first and second electrodes EML and the anode;
wherein the m-EBL is adjacent to the EML and the OLED further comprises a HTL and a HIL disposed between the m-EBL and one of the two electrodes that is an anode or a CGL;
an m-HBL disposed between the first and second electrodes EML and the cathode; and
wherein the m-HBL is adjacent to the EML and the OLED further comprises an ETL and an EIL disposed between the m-HBL and one of the two electrodes that is a cathode or a CGL, wherein the m-EBL and the m-HBL each have at least two components. In some embodiments the HIL, the HTL, the EIL, and the ETL each can be independently selected to be a multi-component layer comprising at least three components. In some embodiments, the EML can comprise three hosts and a phosphorescent emitter dopant.

### [Multi-component HIL]

In some embodiments, the m-HIL comprises three or more materials. In some embodiments, the m-HII, contains three materials, two of which are a hole transporting material and a conductivity dopant, and the third material is chosen to maximize the performance of the OLED. For example, some hole conductivity dopants drastically increase the hole mobility of the m-HII, layer. If the hole mobility becomes too large with just the hole transporting material and the conductivity dopant, then the exciton distribution within the EML could be impacted. If the exciton distribution is shifted so that there is preferential recombination only at the m-ETL side of the EML, then the lifetime of the OLED device could be reduced compared to a device with the exciton distribution more spread over the thickness of the EML. In this case, the third material added to the m-HIL would be chosen to lower the mobility of holes. Since the concentration of the third material can be very well controlled, the lowering of hole mobility due to its inclusion can be precisely tuned. Thus, the hole mobility of the m-HIL can be more precisely tuned than through varying the concentration of the conductivity dopant.

### [Multi-component HTL]

In some embodiments, the m-HTL comprises three or more materials. In some embodiments, the HTL contains three materials, two of which are a hole transporting material and a conductivity dopant, and the third material is chosen to maximize the performance of the OLED. For example, some hole conductivity dopants drastically increase the hole mobility of the m-HTL layer. If the hole mobility becomes too large with just the hole transporting material and the conductivity dopant, then the exciton distribution within the EML could be impacted. If the exciton distribution is shifted so that there is preferential recombination only at the m-ETL side of the EML, then the lifetime of the OLED device could be reduced compared to a device with the exciton distribution more spread over the thickness of the EML. In this case, the third material added to the m-HTL would be chosen to lower the mobility of holes. Since the concentration of the third material can be very well controlled, the lowering of hole mobility due to its inclusion can be precisely tuned. Thus, the hole mobility of the m-HTL can be more precisely tuned than through varying the concentration of the conductivity dopant.

In some embodiments, the m-HTL contains three materials, two of which are a hole transporting material and a conductivity dopant while the third material is a material with a triplet energy greater than the T₁ energy of the emitter in the EML. Often HTL materials have a low T₁ triplet energy, so if the m-HTL is adjacent to the EML, it is advantageous to add at least one more material which has a triplet energy greater than the T₁ triplet energy of the emitter in the EML to reduce quenching and increase the efficiency of the OLED device.

### [Multi-component EIL]

In some embodiments, the m-EIL comprises three or more materials. In some embodiments, the m-EIL contains three materials, two of which are an electron transporting material and a conductivity dopant, and the third material is chosen to maximize the performance of the OLED. For example, some electron conductivity dopants drastically increase the electron mobility of the m-EIL layer. If the electron mobility becomes too large, then the exciton distribution within the EML could be impacted. For example, with a large electron mobility in the m-EIL, the exciton distribution may be shifted preferential recombination towards the HTL side of the EML. In this case, the lifetime of the OLED device could be reduced compared to a device with the exciton distribution more spread over the thickness of the EML. The third material to add to the m-EIL would be a material that lowers the mobility of electrons in the layer. Since the concentration of the third material can be very well controlled there will be very precise control over the modulation of the electron mobility. Thus, the electron mobility of the m-EIL can be more precisely tuned than through varying the concentration of the conductivity dopant.

In some embodiments, the multi-component m-EIL comprises three or more materials and is in direct contact with an electrode. In some embodiments the electrode is the cathode and the cathode is composed of silver. It is well known in the art that the quality of a silver cathode can greatly impact the efficiency of an OLED device. The quality is particularly important when the electrode is semi-transparent. For example, a semi-transparent Ag containing cathode is typically utilized in top emitting microcavity OLED devices. In this embodiment, an m-EIL which is composed only of an electron transporting material and a conductivity dopant may not have the surface energy required to form a quality Ag cathode. A quality Ag cathode will have higher transmission and lower surface roughness. To achieve these properties, a third component can be added to the m-EIL. The concentration of this third component can be optimized to have minimal to no impact on the OLED's electrical performance while increasing the OLED efficiency due to the increased quality of the cathode.

### [Multi-component ETL]

In some embodiments, the m-ETL comprises three or more materials. In some embodiments, the m-ETL contains three materials, two of which are an electron transporting material and a conductivity dopant, and the third material is chosen to maximize the performance of the OLED. For example, some electron conductivity dopants drastically increase the electron mobility of the m-ETL layer. If the electron mobility becomes too large, then the exciton distribution within the EML could be impacted. For example, with a large electron mobility in the m-ETL, the exciton distribution may be shifted preferential recombination towards the HTL side of the EML. In this case, the lifetime of the OLED device could be reduced compared to a device with the exciton distribution more spread over the thickness of the EML. The third material to add to the m-ETL would be a material that lowers the mobility of electrons in the layer. Since the concentration of the third material can be very well controlled there will be very precise control over the modulation of the electron mobility. Thus, the electron mobility of the m-ETL can be more precisely tuned than through varying the concentration of the conductivity dopant.

In some embodiments, the m-ETL contains three materials, two of which are an electron transporting material and a conductivity dopant while the third material is a material with a triplet energy greater than the T₁ energy of the emitter in the EML. Often ETL materials have a low T₁ triplet energy, so if the m-ETL is adjacent to the EML, it is advantageous to add at least one more material which has a triplet energy greater than the T₁ triplet energy of the emitter in the EML to reduce quenching and increase the efficiency of the OLED device.

### [The EML]

In some embodiments of the OLED with an EML, an m-EBL and/or an m-HBL, the EML can contain more than one emissive material. In some embodiments, the EML comprises two emissive materials. The first emissive material and the second emissive material are selected so that the first emissive material can fully or partially energy transfer to the second emissive material. If the energy transfer process occurs via Dexter energy transfer, then the two materials need to have orbital overlap. If the energy transfer process occurs via Forster Resonance Energy Transfer (FRET) then the second emissive material's absorption spectrum needs to partially overlap with the emission spectrum of the first emissive material. In some embodiments, the first emissive material is selected from the group consisting of: thermally activated delayed fluorescent (TADF) materials, phosphorescent materials, and doublet materials whose S₁ > T₁ for the lowest excited state energy. In some embodiments, the second emissive material is selected from the group consisting of: fluorescent materials, TADF materials, multi-resonant materials, doublet materials, and phosphorescent materials.

In some embodiments, the EML contains an organometallic complex that contains one of the following metals: Ag, Au, Cu, Ir, Rh, Os, Pt, Pd, or Al.

In some embodiments, one or more materials in the OLED contain at least one deuterium atom. In some embodiments, one or more materials in one or more of the EML, m-EBL, and m-HBL contain at least one deuterium atom. For example, in some embodiments, one or more materials in the EML contain at least one deuterium atom. In some embodiments, one or more materials in the m-EBL contain at least one deuterium atom. In some embodiments, one or more materials in each of the EML and m-EBL contain at least one deuterium atom. In some embodiments, one or more materials in the m-HBL contain at least one deuterium atom. In some embodiments, one or more materials in each of the EML and m-HBL contain at least one deuterium atom. In some embodiments, one or more materials in each of the EML, m-EBL, and m-HBL contain at least one deuterium atom. In some embodiments, one or more materials in each of the m-EBL and m-HBL contain at least one deuterium atom. Increasing the stability of the OLED is important for all colors of operation. Reactions between molecules within the OLED are one possible cause of the loss in device stability. In some reactions, the removal of a proton is part of the reaction pathway. In these reactions, incorporating deuterium atoms in materials of the OLED will lower the rate at which this reaction can occur, increasing the stability of the OLED.

In one aspect, the present disclosure provides an OLED in which the EML is composed of three host materials, two of which can be of the same type, and the OLED also includes an m-EBL and/or an m-HBL that each comprises two or more blocking materials.

For example, the EML can have two hole transporting host materials and one electron transporting host material. In some embodiments, the two hole transporting hosts have HOMO levels that within 0.1 eV of each other. In another embodiment, the HOMO levels of the two hole transporting hosts differ by more than 0.1 eV but less than 0.7 eV.

In some embodiments, the HOMO level of the electron transporting host is lower than the HOMO levels of the two hole transporting hosts. In some embodiments, the HOMO level of the electron transporting host is higher than one of the two hole transporting hosts but lower than the other of the two hole transporting hosts.

In some embodiments, the EML can have one hole transporting host material and two electron transporting host materials. In some embodiments, the two electron transporting hosts have LUMO levels that are within 0.1 eV of each other. In another embodiment, the LUMO levels of the two electron transporting hosts differ by more than 0.1 eV but less than 0.7 eV.

In another embodiment, the HOMO levels of the three host materials in the EML differ by more than 0.1 eV but less than 0.5 eV. In another embodiment, the LUMO level of the three host materials in the EML differ by more than 0.1 eV but less than 0.5 eV.

### ENERGY LEVEL CONFIGURATIONS FOR EML AND EBL FOR VARIOUS EMBODIMENTS OF THE OLED ACCORDING TO THE PRESENT DISCLOSURE

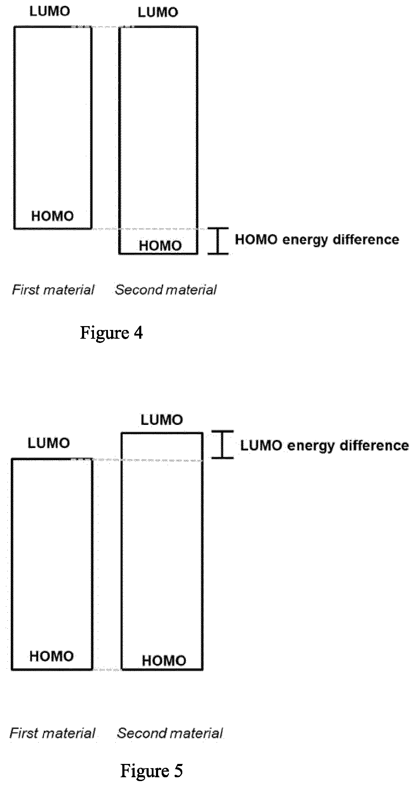

FIG. 4 is an illustration of an energy diagram showing an example of two materials having different HOMO energy levels. The second material in FIG. 4 has a deeper HOMO level than the first material. FIG. 5 is an illustration of an energy level diagram showing an example of two materials having different LUMO energy levels. The second material in FIG. 5 has a shallower LUMO level than the first material.

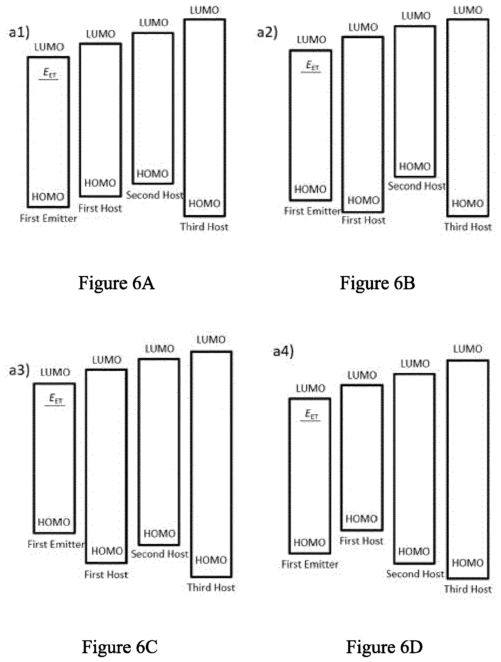

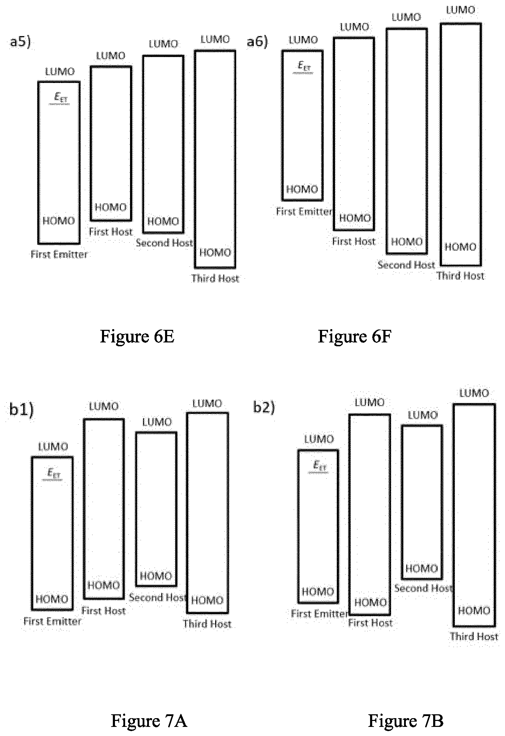

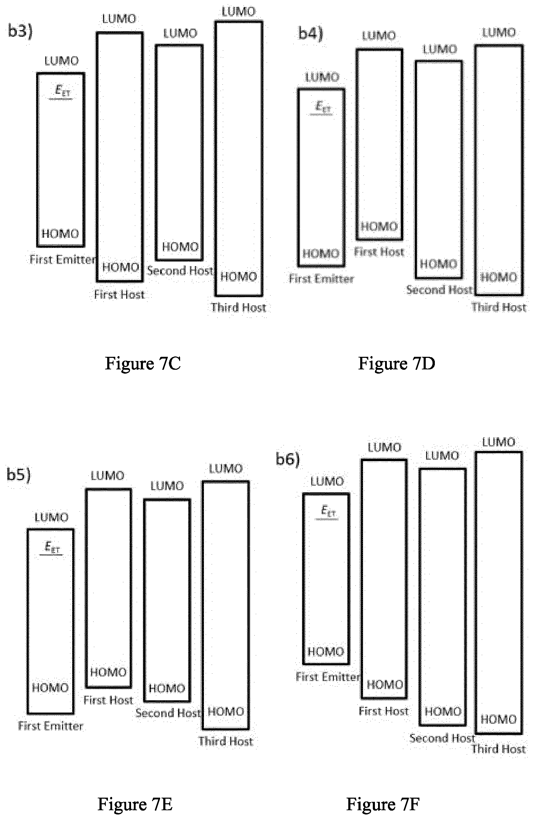

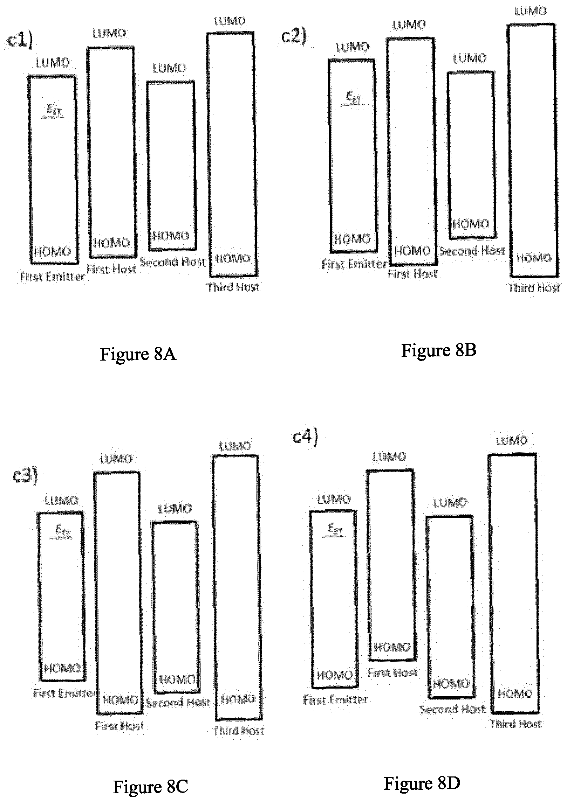

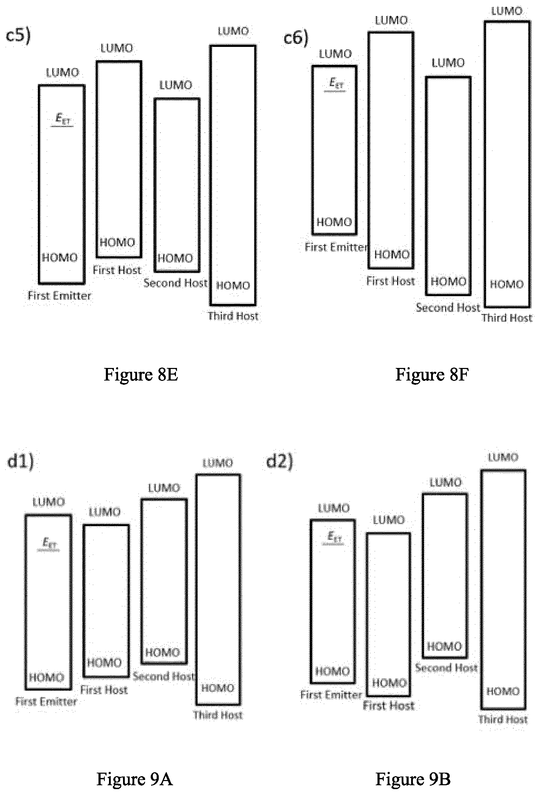

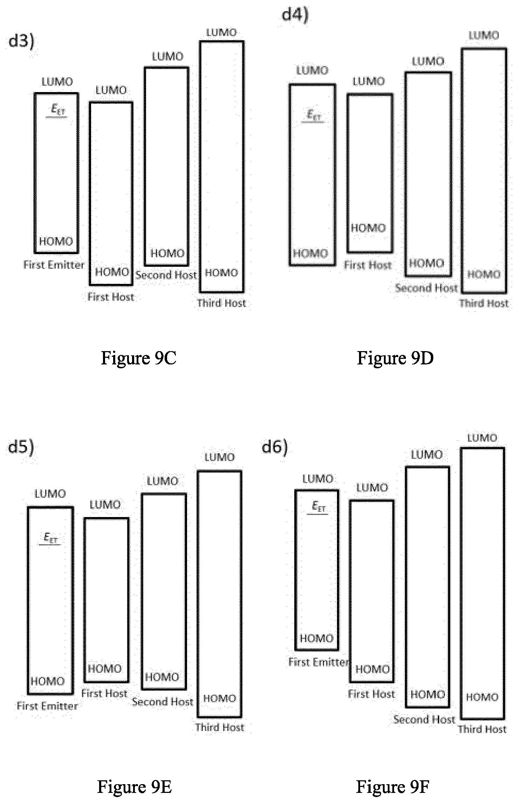

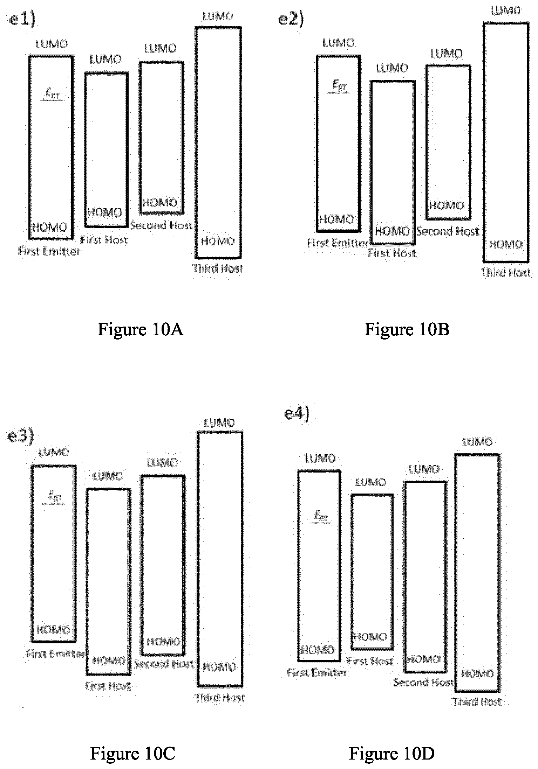

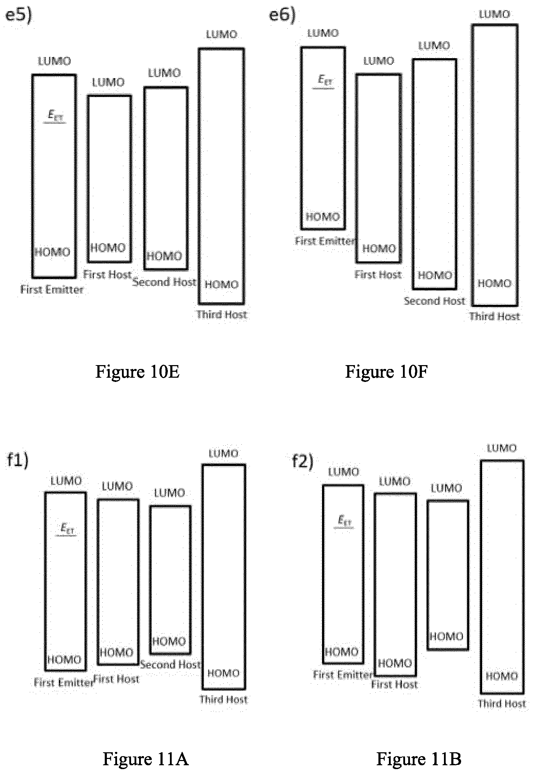

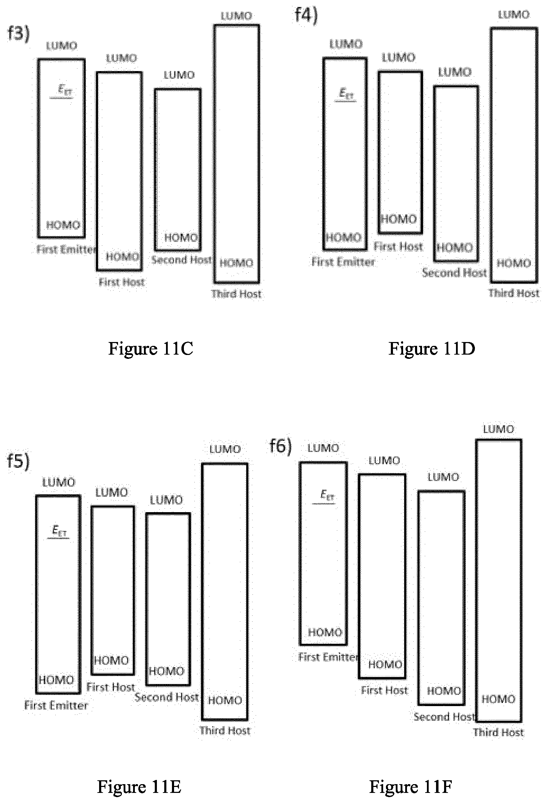

FIGS. 6A-11F are illustrations of various energy level diagrams for embodiments of EMLs comprising three or more components that are utilized in combination with the multi-component layers in the OLED.

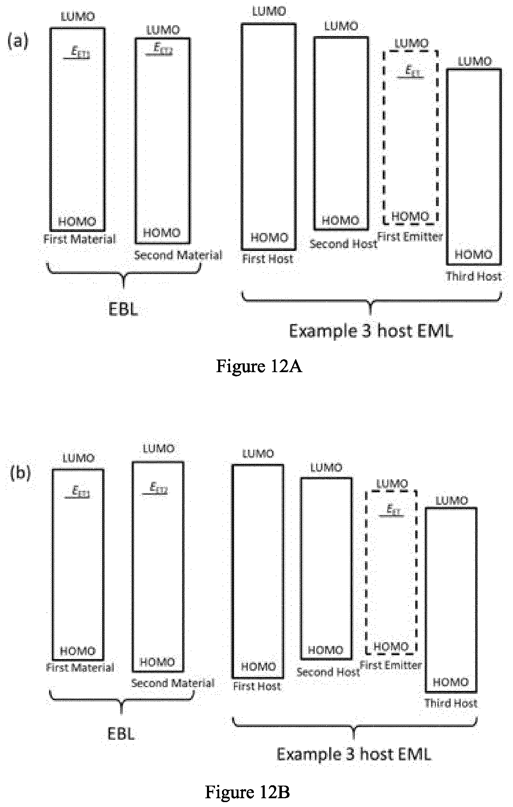

FIGS. 12A - 12D are illustrations of energy level diagrams for example embodiments, each having a combination of an m-EBL with a 4-component EML. In FIG. 12A, the embodiment of an m-EBL where the 2^{nd} material has a deeper HOMO level and a deeper LUMO level than the first material and the triplet energy level T₁ of the second material is higher than the triplet energy level T₁ of the first material. In some embodiments of the energy level configuration depicted in FIG. 12A, the shallowest HOMO level in the m-EBL is the same energy or deeper than the shallowest HOMO level in the 4-component EML. In other embodiments of FIG. 12A, the shallowest HOMO level in the m-EBL is more shallow than the shallowest HOMO level material in the 4-component EML.

In FIG. 12B, the embodiment of a 2-component m-EBL where the second material has a deeper HOMO level and a shallower LUMO level than the first material and the triplet energy level T₁ of the second material is higher than the triplet energy level T₁ of the first material. In some embodiments of the energy level configuration depicted in FIG. 12B, the shallowest HOMO level in the m-EBL is the same energy or deeper than the shallowest HOMO level in the 4-component EML. In other embodiments of FIG. 12B, the shallowest HOMO level in the m-EBL is more shallow than the shallowest HOMO level material in the 4-component EML.

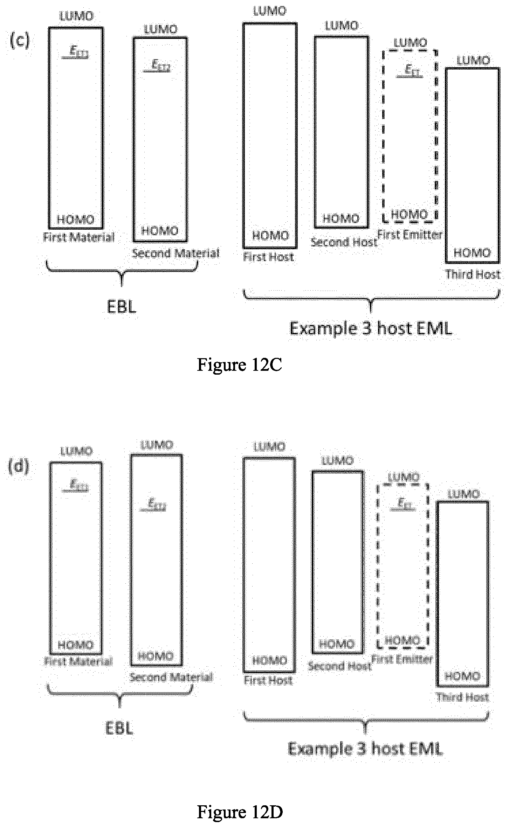

In FIG. 12C, the embodiment of an m-EBL where the second material has a deeper HOMO level and a deeper LUMO level than the first material and the triplet energy level T₁ of the second material is lower than the triplet energy level T₁ of the first material. In some embodiments of the energy level configuration depicted in FIG. 12C, the shallowest HOMO level in the m-EBL is the same energy or deeper than the shallowest HOMO level in the 4-component EML. In other embodiments of FIG. 12C, the shallowest HOMO level in the m-EBL is more shallow than the shallowest HOMO level material in the 4-component EML.

In FIG. 12D, the embodiment of an m-EBL where the second material has a deeper HOMO level and a shallower LUMO level than the first material and the triplet energy level of the second material is lower than the triplet energy level of the first material. In some embodiments of the energy level configuration depicted in FIG. 12D, the shallowest HOMO level in the m-EBL is the same energy or deeper than the shallowest HOMO level in the 4-component EML. In other embodiments of FIG. 12D, the shallowest HOMO level in the m-EBL is more shallow than the shallowest HOMO level material in the 4-component EML.

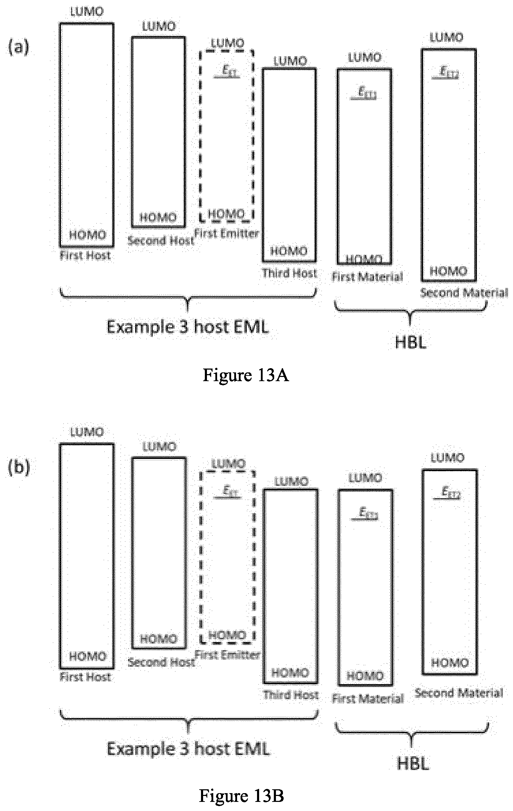

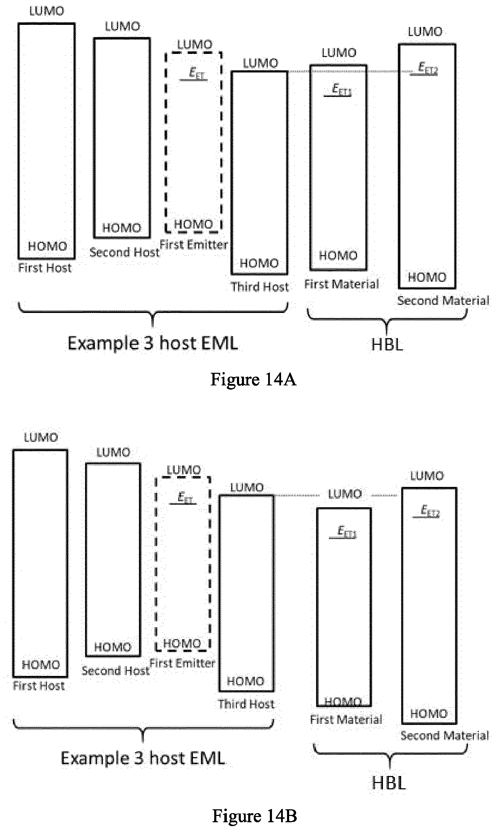

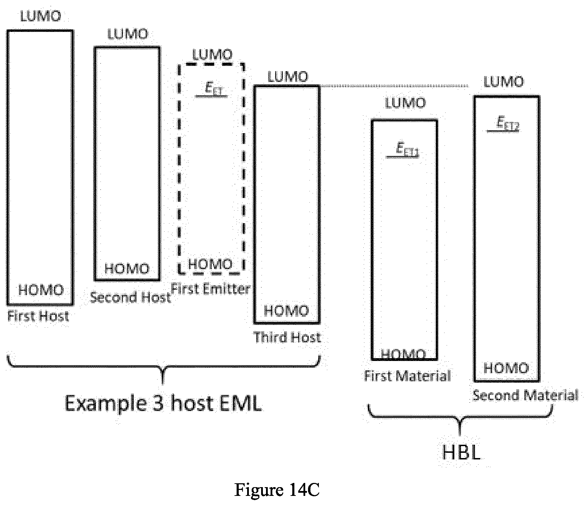

FIGS. 13A - 13D are illustrations of energy level diagrams for example embodiments, each having a combination of an m-HBL with a 4-component EML. In FIG. 13A, the embodiment of an m-HBL where the second material has a shallower LUMO level and a deeper HOMO level than the first material and the triplet energy level of the second material is higher than the triplet energy level of the first material. In some embodiments of the energy level configuration depicted in FIG. 13A, the shallowest LUMO level in the m-HBL is the same energy or shallower than the deepest LUMO level in the 4-component EMLas depicted in FIG. 14A. In other embodiments of FIG. 13A, the deepest LUMO level in the m-HBL is deeper than the deepest LUMO level in the 4-component EML as depicted in FIG. 14B. In other embodiments of FIG. 13A, the shallowest LUMO in the m-HBL is deeper than the deepest LUMO in the 4-component EML as depicted in FIG. 14C.

In FIG. 13B, the embodiment of an m-HBL where the second material has shallower LUMO and a shallower HOMO level than the first material and the triplet energy level of the second material is higher than the triplet energy level of the first material. In some embodiments of the energy level configuration depicted in FIG. 13B, the shallowest LUMO level in the m-HBL is the same energy or shallower than the deepest LUMO level in the 4-component EML. In other embodiments of FIG. 13B, the deepest LUMO level in the m-HBL is deeper than the deepest LUMO level in the 4-component EML. In other embodiments of FIG. 13B, the shallowest LUMO in the m-HBL is deeper than the deepest LUMO in the 4-component EML.

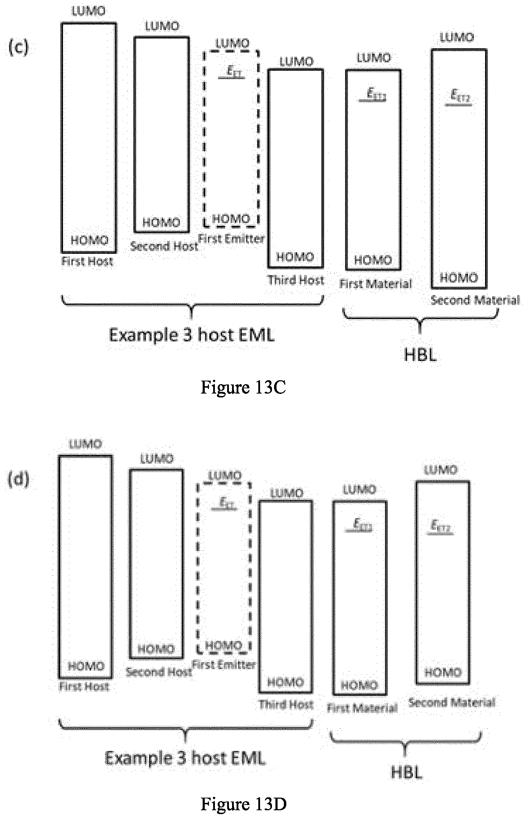

FIG. 13C matches the energy level configuration of FIG. 13A but where the triplet energy level of the second material in the m-HBL is lower than the triplet energy of the first material. FIG. 13D matches the energy level configuration of FIG. 13B but where the triplet energy level of the second material in the m-HBL is lower than the triplet energy of the first material. In some embodiments of the energy level configuration depicted in FIG. 13C and 13D, the shallowest LUMO level in the m-HBL is the same energy or shallower than the deepest LUMO level in the 4-component EML. In other embodiments of FIG. 13C and 13D, the deepest LUMO level in the m-HBL is deeper than the deepest LUMO level in the 4-component EML. In other embodiments of FIG. 13C and 13D, the shallowest LUMO in the m-HBL is deeper than the deepest LUMO in the 4-component EML.

FIGS. 14A - 14C are illustrations of energy level diagrams for example embodiments, each having a combination of an m-HBL with a 4-component (3 hosts) EML, each illustrating a different configuration between the m-HBL and the 4-component EML, where the energy level configuration of the m-HBL is the configuration shown in FIG. 13A.

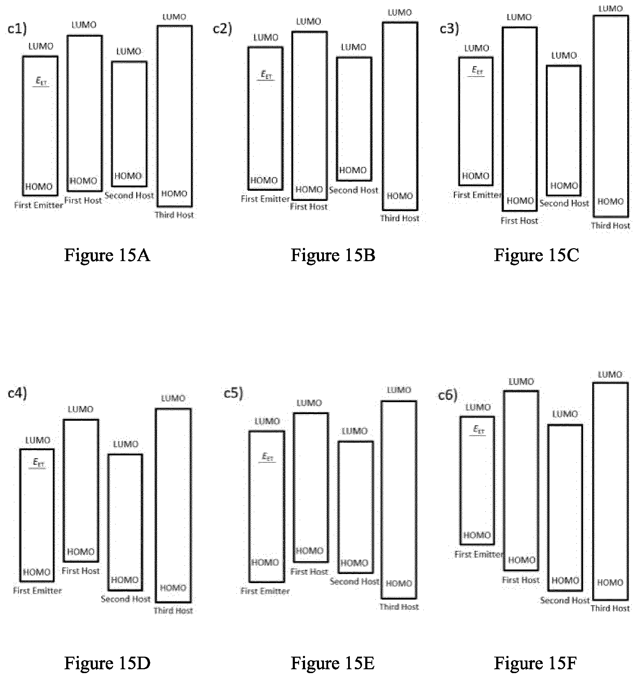

FIGS. 15A-15F are illustrations of energy level diagrams for example 4-component (3 hosts) EMLs. Each diagram illustrates a different energy level configuration among an emitter compound and three host compounds.

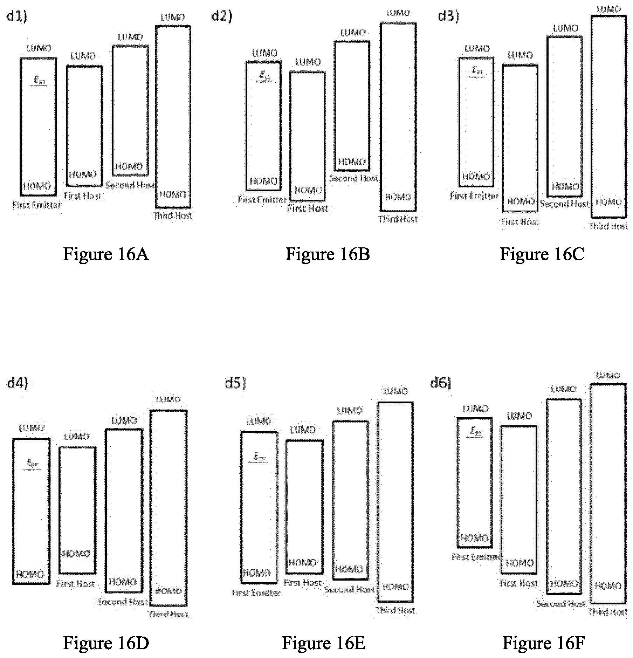

FIGS. 16A-16F are illustrations of energy level diagrams for more example 4-component (3 hosts) EMLs. Each diagram illustrates a different energy level configuration among an emitter compound and three host compounds.

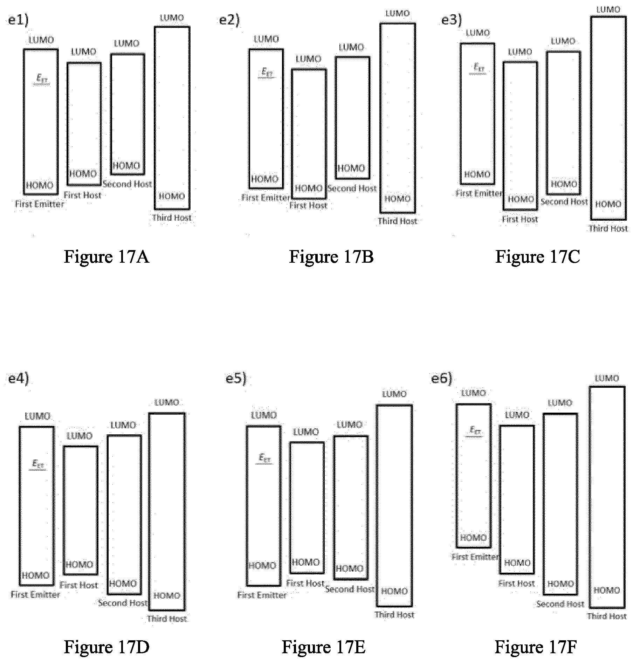

FIGS. 17A-17F are illustrations of energy level diagrams for more example 4-component (3 hosts) EMLs. Each diagram illustrates a different energy level configuration among an emitter compound and three host compounds.

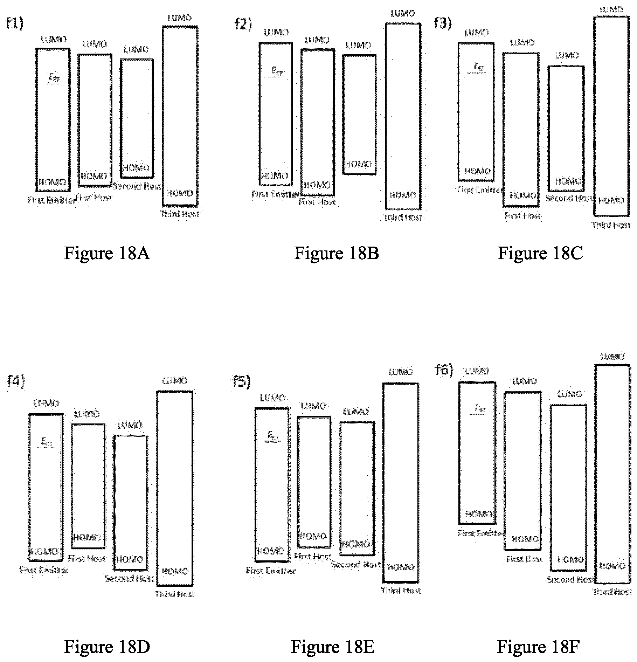

FIGS. 18A-18F are illustrations of energy level diagrams for more example 4-component (3 hosts) EMLs. Each diagram illustrates a different energy level configuration among an emitter compound and three host compounds.

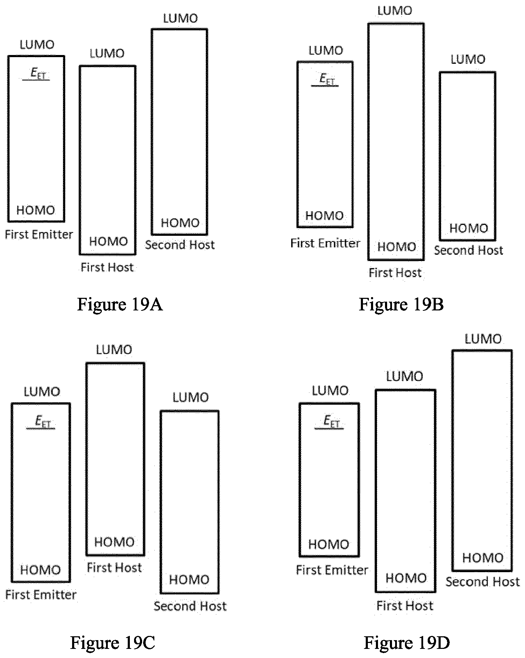

FIGS. 19A-20D are illustrations of energy level diagrams for various embodiments of an EML that can be incorporated into an OLED of the present disclosure that includes a first layer disposed between the two electrodes of the OLED along with the EML, wherein the first layer is selected from the group consisting of an m-HIL, an m-HTL, an m-EBL, an m-HBL, an m-ETL, and an-m EIL, as defined herein,

Referring to FIG. 19A, in some embodiments of the OLED of the present disclosure, the EML comprises two hosts and one emitter, wherein the LUMO energy of the emitter is higher than that of the first host, but deeper than that of the second host, while the HOMO energy of the emitter is higher than those of both the first host and the second host, and the HOMO energy of the first host is deeper than that of the second host.

Referring to FIG. 19B, in some embodiments of the OLED of the present disclosure, the EML comprises two hosts and one emitter, wherein the LUMO energy of the emitter is deeper than that of the first host, but higher than that of the second host, and the LUMO energy of the first host is higher than that of the second host, while the HOMO energy of the emitter is higher than those of both the first host and the second host, and the HOMO energy of the first host is deeper than that of the second host.

Referring to FIG. 19C, in some embodiments of the OLED of the present disclosure, the EML comprises two hosts and one emitter, wherein the LUMO energy of the emitter is deeper than that of the first host, but higher than that of the second host, and the LUMO energy of the first host is higher than that of the second host, while the HOMO energy of the emitter is deeper than the HOMO energy of the first host but higher than that of the second host, and the HOMO energy of the first host is higher than that of the second host.

Referring to FIG. 19D, in some embodiments of the OLED of the present disclosure, the EML comprises two hosts and one emitter, wherein the LUMO energy of the emitter is deeper than that of the first host and the second host while the LUMO of the first host is deeper than that of the second host, while the HOMO energy of the emitter is shallower than the first and second host while the HOMO energy of the first host is deeper than that of the second host.

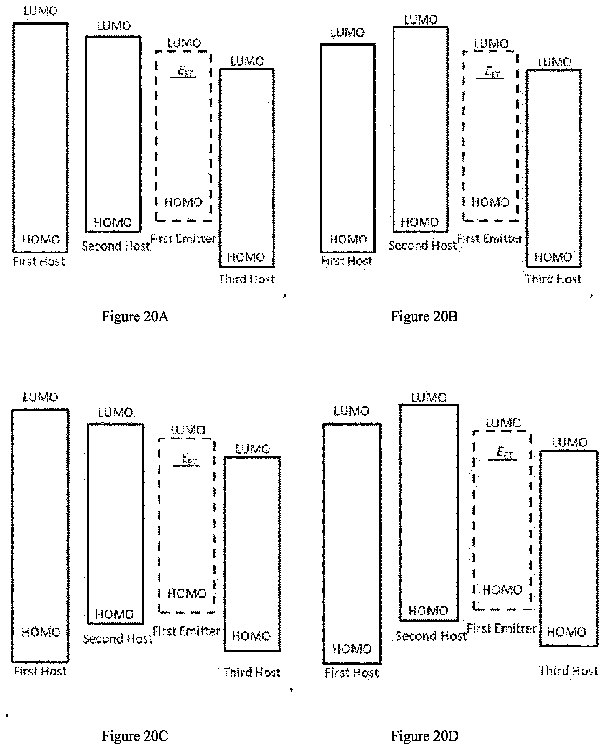

Referring to FIG. 20A, in some embodiments of the OLED of the present disclosure, the EML comprises four components that are an emitter, and three hosts: a first host, a second host, and a third host, wherein the LUMO energies of the four components in the EML are in the following order: the LUMO of the third host (the deepest LUMO energy) < the LUMO of the emitter < the LUMO of the second host < the LUMO of the first host, while the HOMO energies of the four components are in the following order: the HOMO of the emitter > the HOMO of the second host > the HOMO of the first host > the HOMO of the third host.

Referring to FIG. 20B, in some embodiments of the OLED of the present disclosure, the EML comprises four components that are an emitter, and three hosts: a first host, a second host, and a third host, wherein the LUMO energies of the four components in the EML are in the following order: the LUMO of the third host (the deepest LUMO energy) < the LUMO of the emitter < the LUMO of the first host < the LUMO of the second host, while the HOMO energies of the four components are in the following order: the HOMO of the emitter > the HOMO of the second host > the HOMO of the first host > the HOMO of the third host.

Referring to FIG. 20C, in some embodiments of the OLED of the present disclosure, the EML comprises four components that are an emitter, and three hosts: a first host, a second host, and a third host, wherein the LUMO energies of the four components in the EML are in the following order: the LUMO of the third host (the deepest LUMO energy) < the LUMO of the emitter < the LUMO of the second host < the LUMO of the first host, while the HOMO energies of the four components are in the following order: the HOMO of the emitter > the HOMO of the second host > the HOMO of the third host > the HOMO of the first host.

Referring to FIG. 20D, in some embodiments of the OLED of the present disclosure, the EML comprises four components that are an emitter, and three hosts: a first host, a second host, and a third host, wherein the LUMO energies of the four components in the EML are in the following order: the LUMO of the third host (the deepest LUMO energy) < the LUMO of the emitter < the LUMO of the first host < the LUMO of the second host, while the HOMO energies of the four components are in the following order: the HOMO of the emitter > the HOMO of the second host > the HOMO of the third host > the HOMO of the first host.

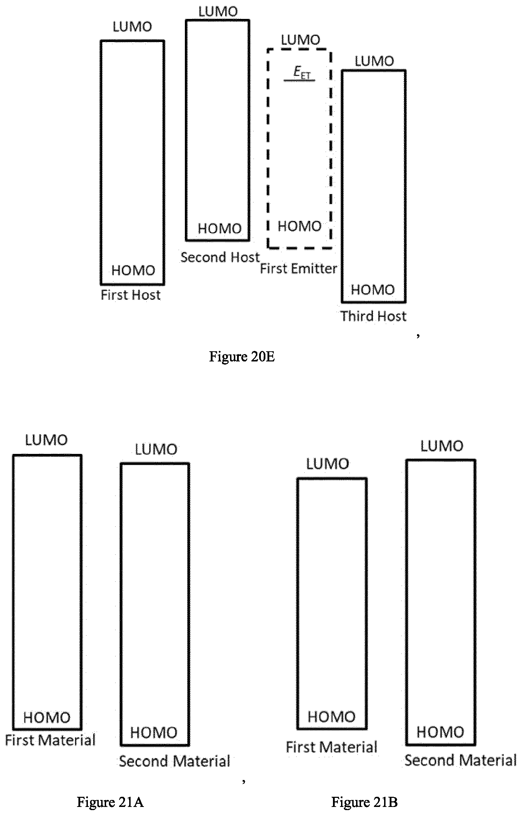

Referring to FIG. 20E, in some embodiments of the OLED of the present disclosure, the EML comprises four components that are an emitter, and three hosts: a first host, a second host, and a third host, wherein the LUMO energies of the four components in the EML are in the following order: the LUMO of third host (the deepest LUMO energy) < the LUMO of the emitter < the LUMO of the first host < the LUMO of the second host, while the HOMO energies of the four components are in the following order: the HOMO of the second host > the HOMO of the emitter > the HOMO of the first host > the HOMO of the third host.

Referring to each of the four-component EML systems shown in FIGS. 20A-20E, in some embodiments of each of those EML systems, the LUMO energies of two or three of the four components in the EML can be equal. In some embodiments of each of those EML systems, the HOMO energies of two or three of the four components in the EML can be equal.

Referring to FIG. 21A, in some embodiments of the OLED of the present disclosure that includes a multi-component EBL and/or a multi-component HBL, the EBL comprises two components, wherein the LUMO energy of the second component material is deeper than that of the first component material, while the HOMO energy of the first component material is higher than that of the second component material.

Referring to FIG. 21B, in some embodiments of the OLED of the present disclosure that includes an m-EBL and/or an m-HBL, the m-EBL comprises two components, wherein the LUMO energy of the first component material is deeper than that of the second component material, while the HOMO energy of the first component material is higher than that of the second component material.

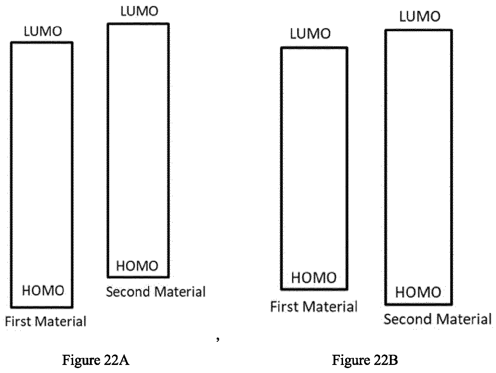

Referring to FIG. 22A, in some embodiments of the OLED of the present disclosure that includes an m-EBL and/or an m-HBL, the m-HBL comprises two components, wherein the LUMO energy of the first component material is deeper than that of the second component material, while the HOMO energy of the first component material is also lower than that of the second component material.

Referring to FIG. 22B, in some embodiments of the OLED of the present disclosure that includes an m-EBL and/or an m-HBL, the m-HBL comprises two components, wherein the LUMO energy of the first component material is deeper than that of the second component material, while the HOMO energy of the first component material is higher than that of the second component material.

In some embodiments of the OLED of the present disclosure, at least one of the materials in the EML, m-EBL, and m-HBL collectively can contain at least one of the following moieties or fused analogues of the moieties:

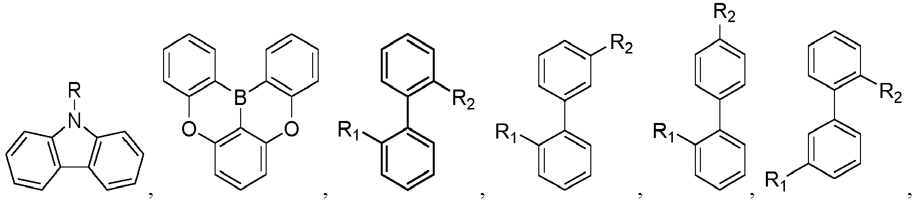

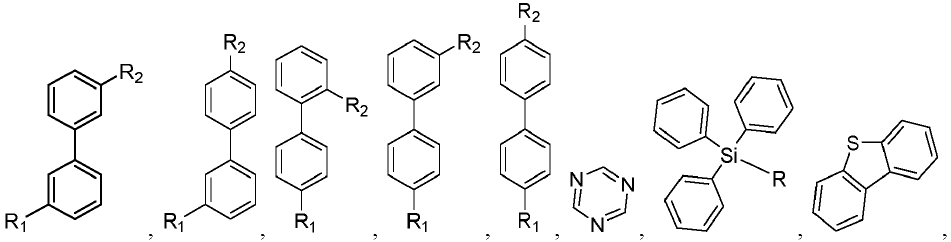

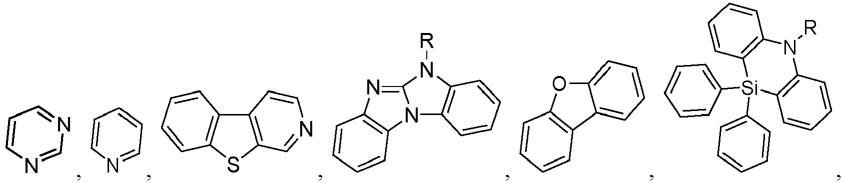

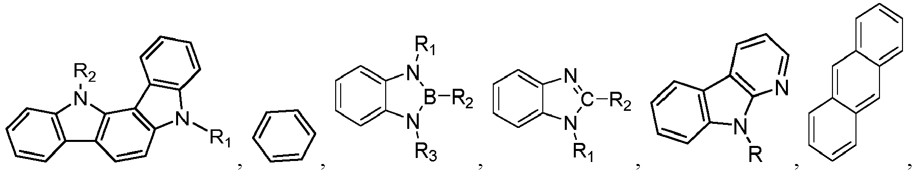

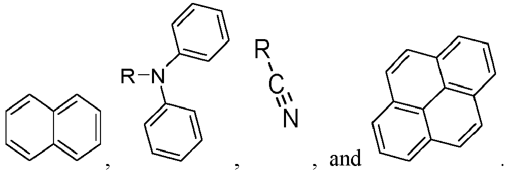

In some embodiments, one or more materials in the EML, m-EBL, and m-HBL contain at least one deuterium atom.

In some embodiments, the phosphorescent emitter material of the present disclosure can be selected from the group consisting of: 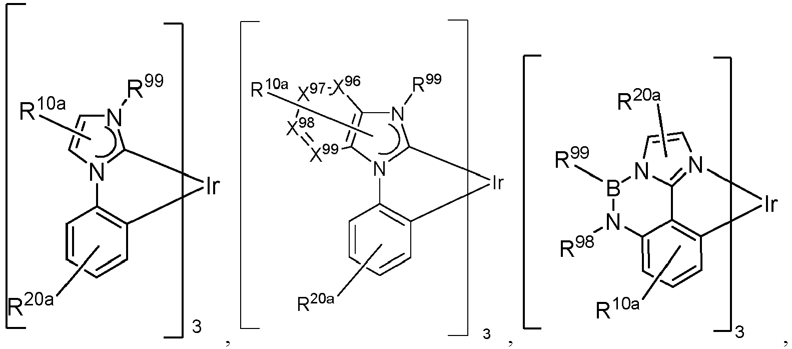 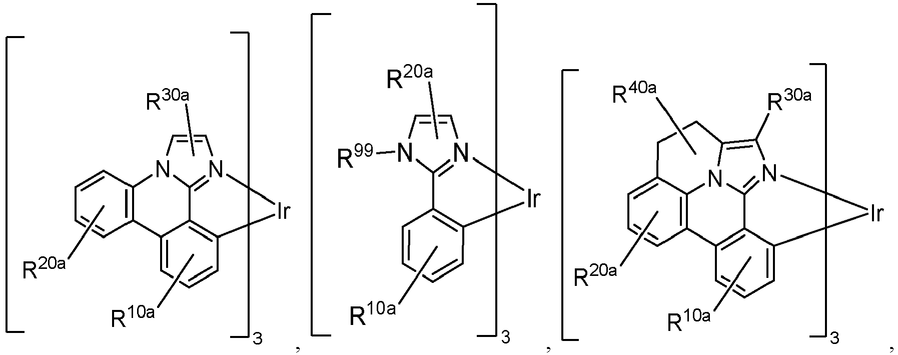 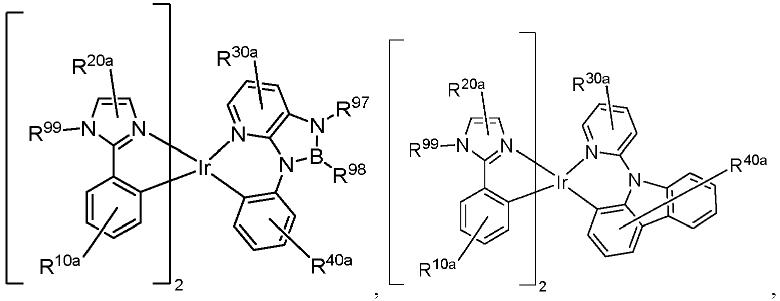 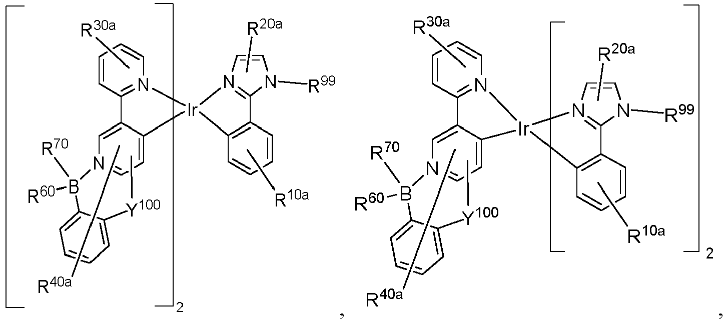 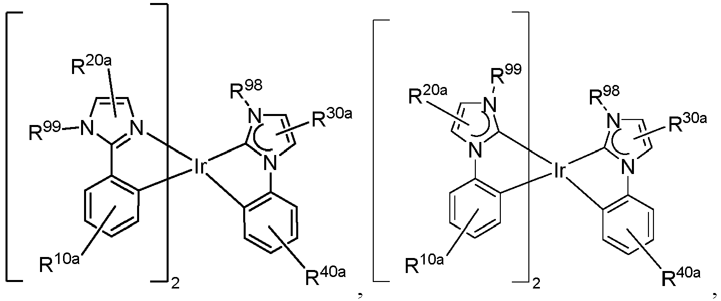 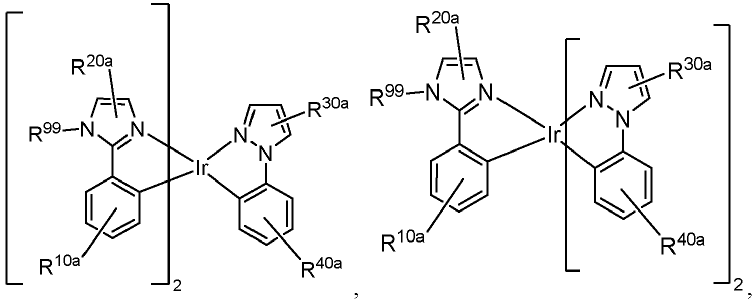 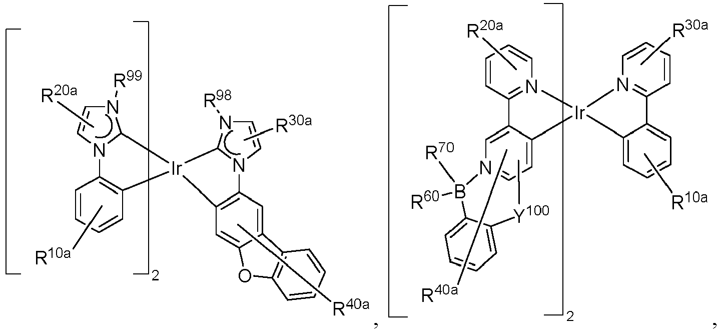 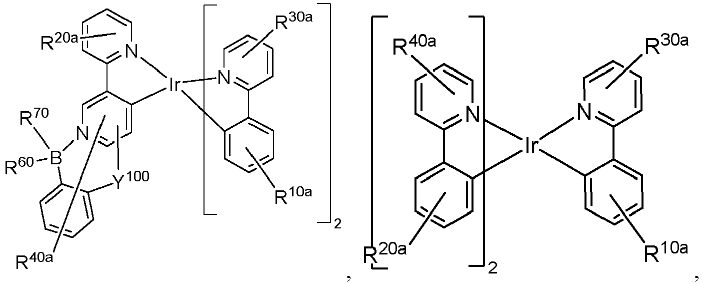 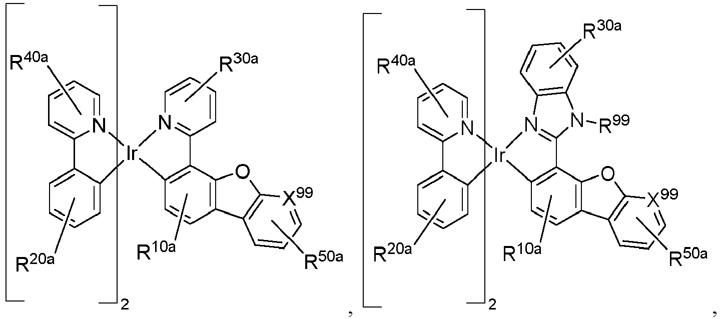 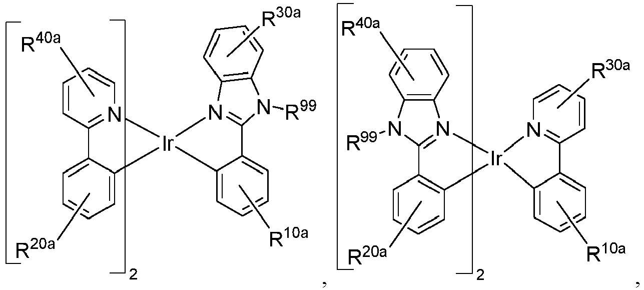 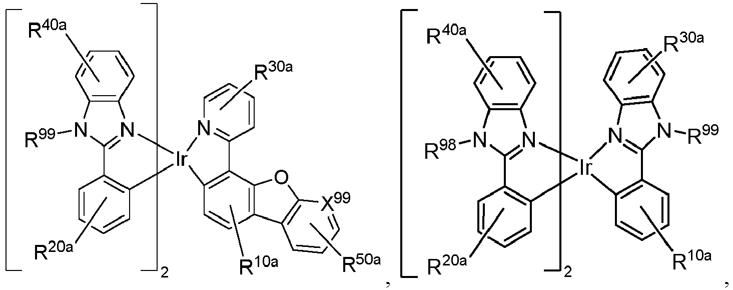 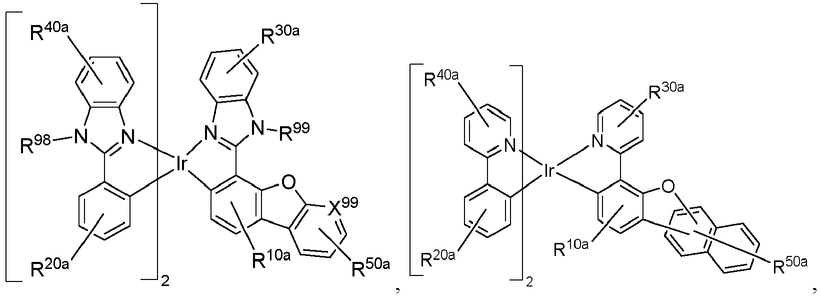 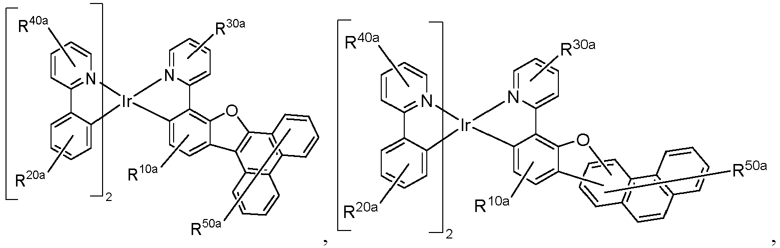 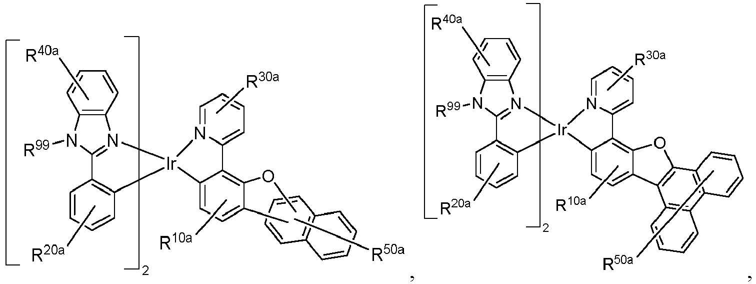 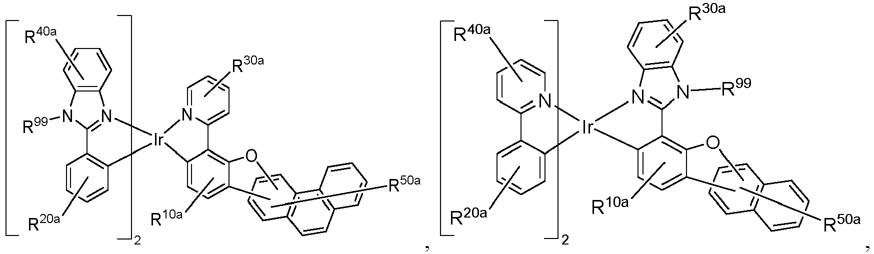 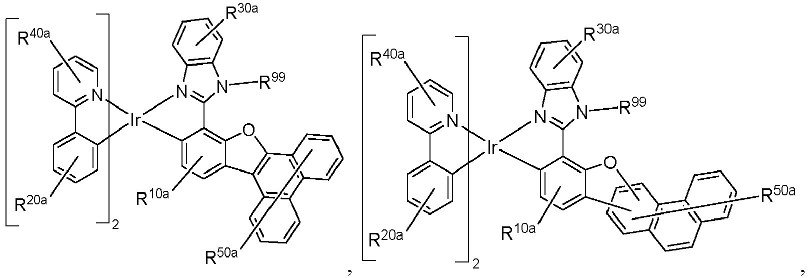 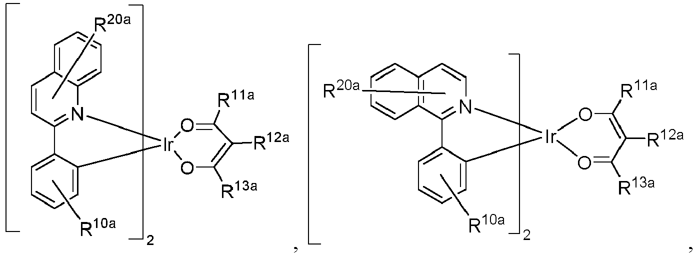 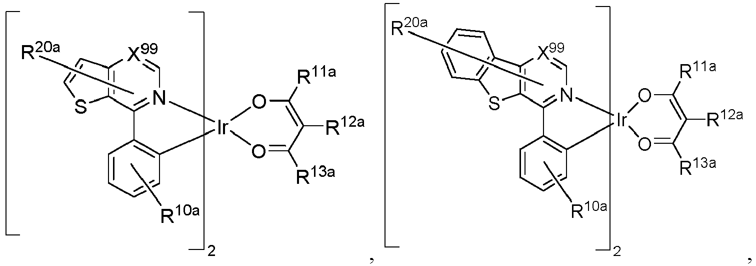 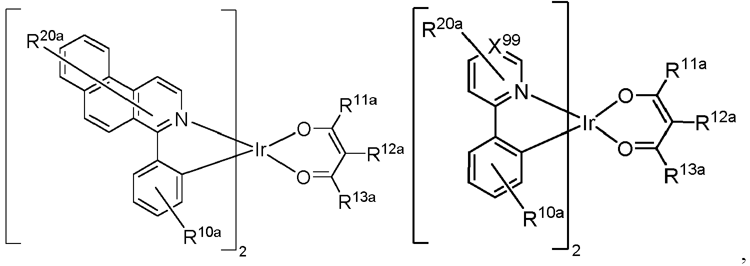 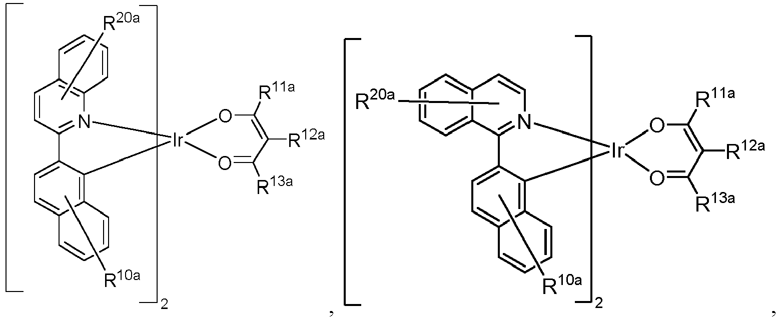 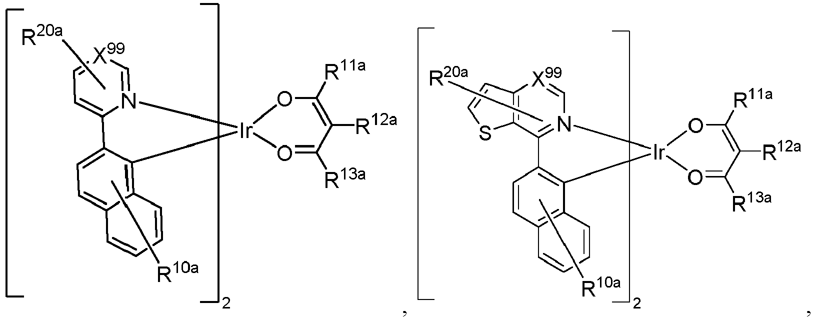 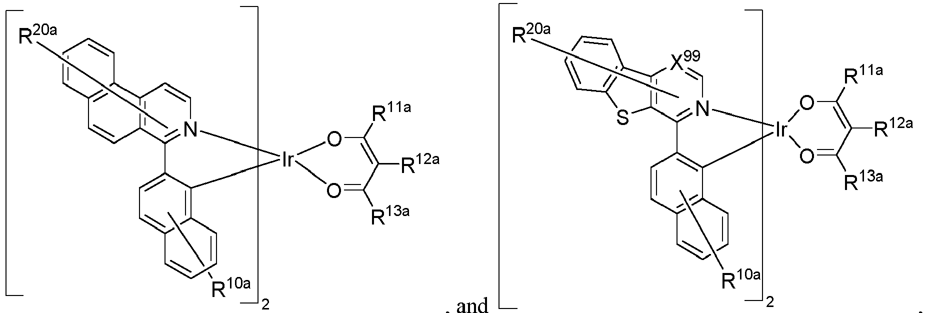 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof; and
two adjacent R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ are optionally joined or fused to form a ring.

In some embodiments, the phosphorescent emitter material may be selected from the group consisting of: 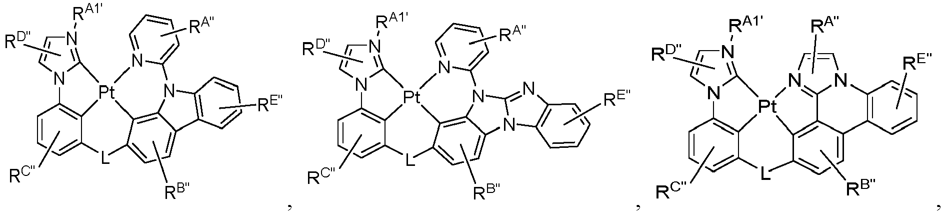 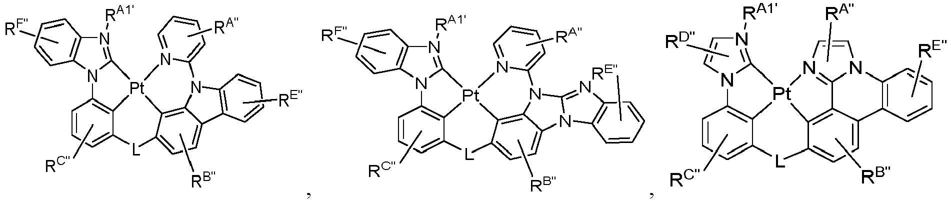 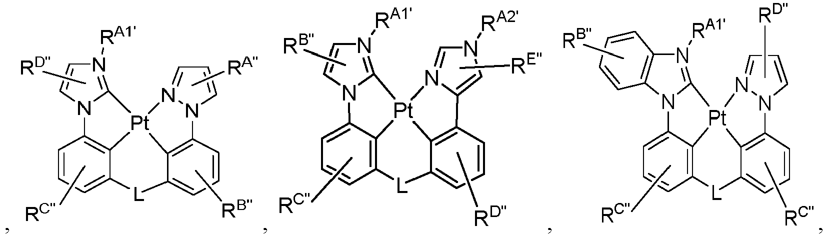 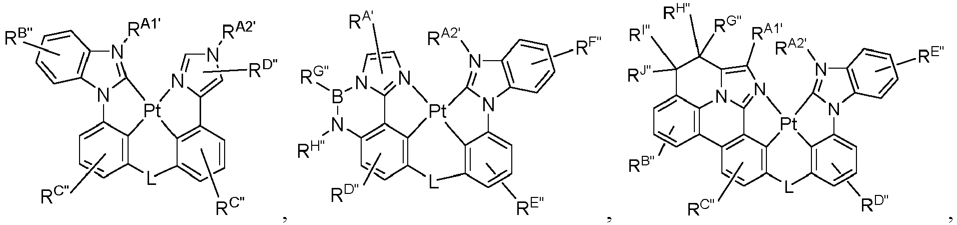 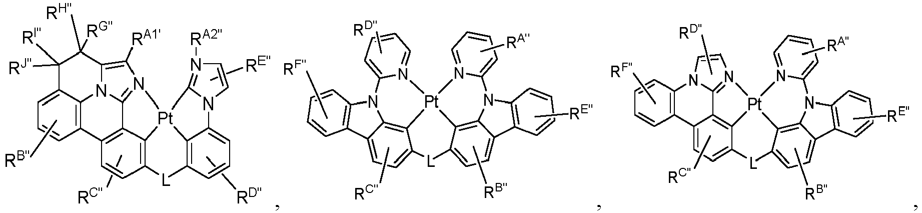 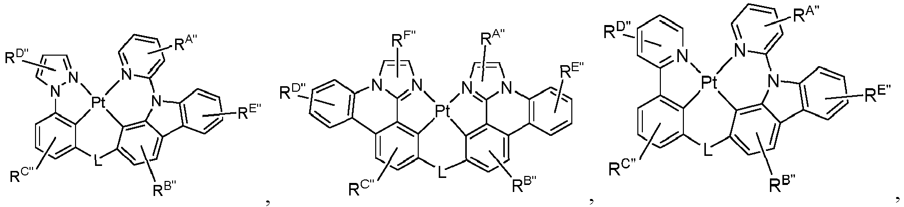 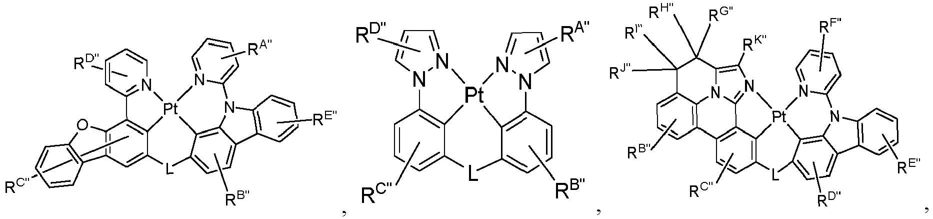 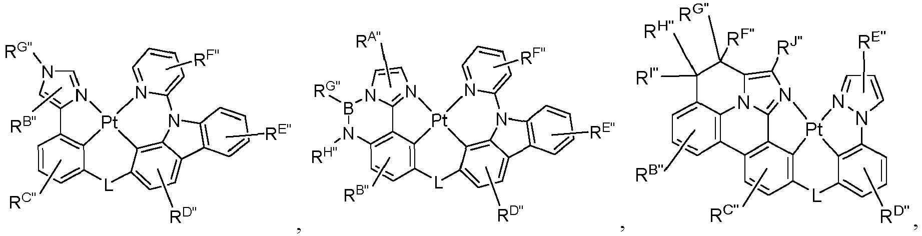 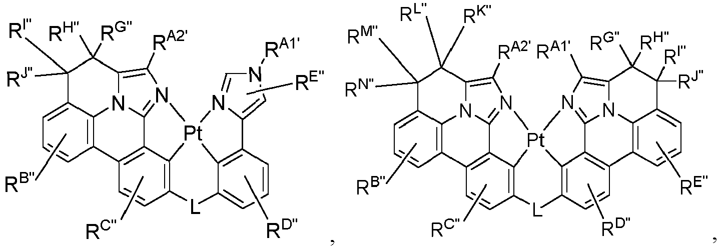 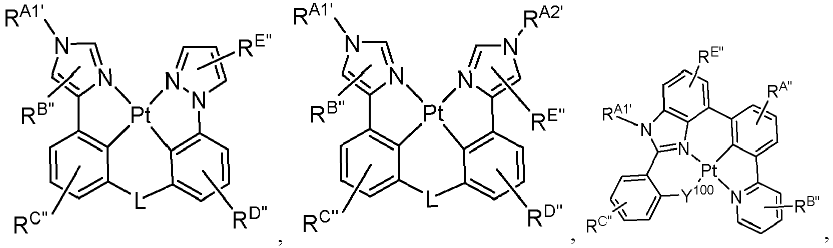 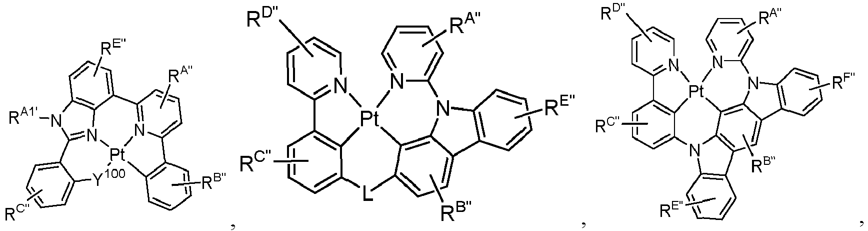 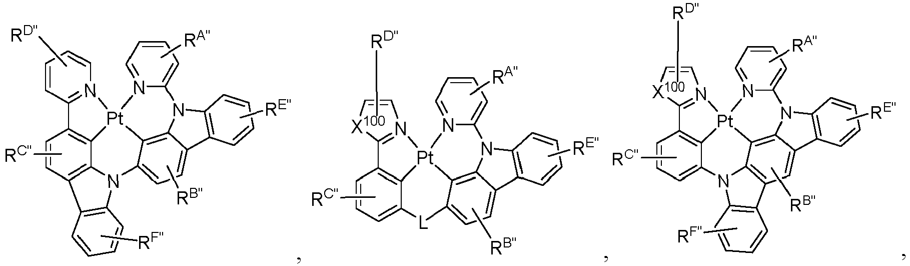 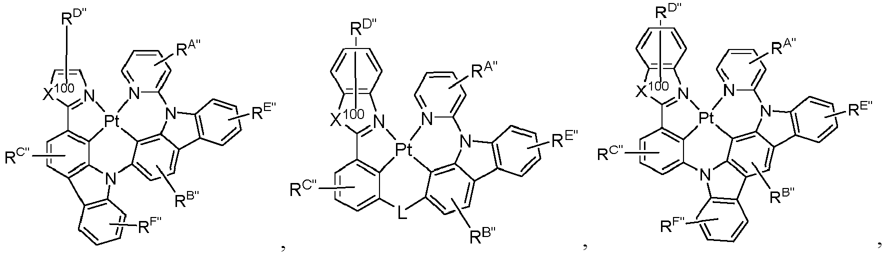 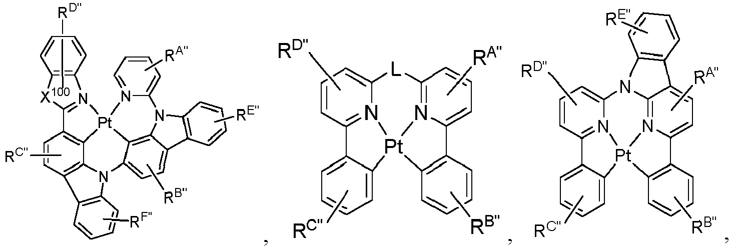 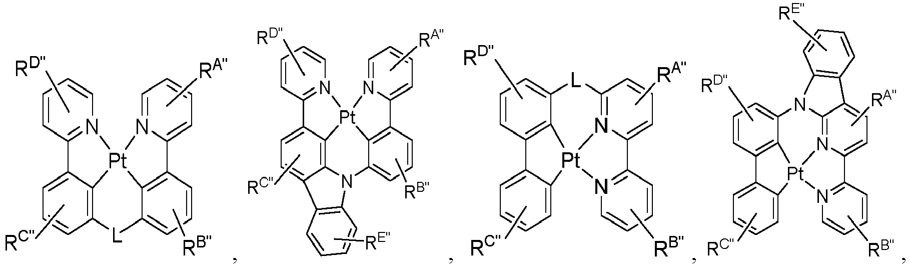 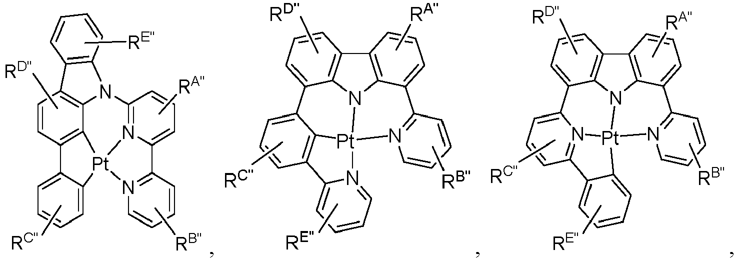 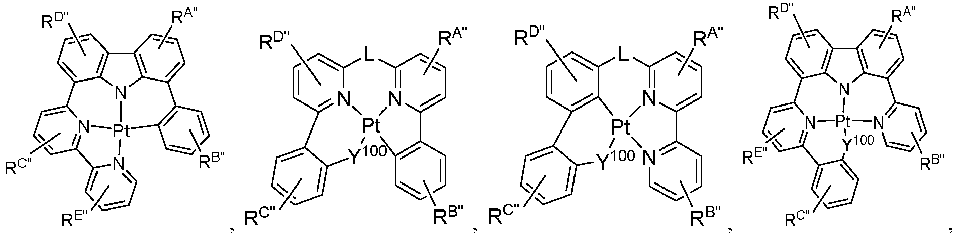 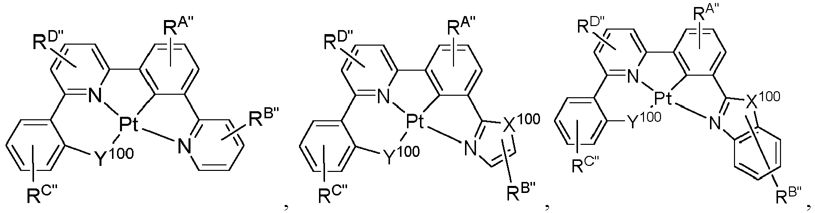 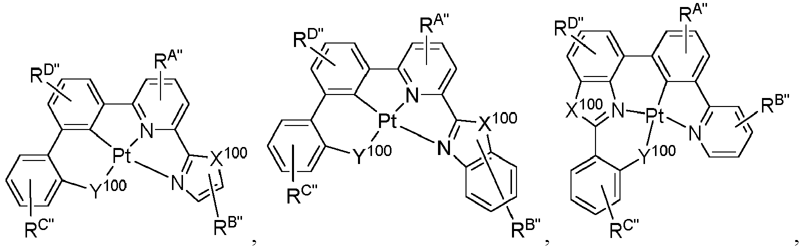 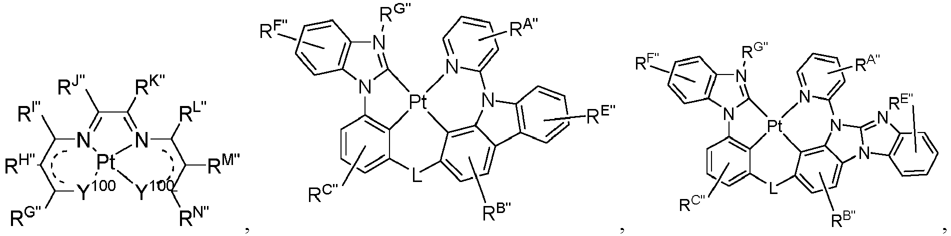 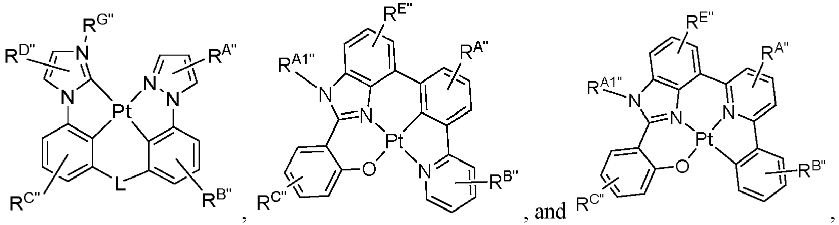 wherein:
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R"', SiR"R‴, GeR"R"', alkyl, cycloalkyl, aryl, heteroaryl, and combinations thereof;
X¹⁰⁰ for each occurrence is selected from the group consisting of O, S, Se, NR", and CR"R‴;
each R^{A"}, R^{B"}, R^{C"}, R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof; and
two adjacent R, R', R", R‴, R^{A1'}, R^{A2'}, R^{A"}, R^{B"}, R^{C"}, R^{D"}, R^{E"}, R^{F"}, R^{G"}, R^{H"}, R^{1"}, R^{J"}, R^{K"}, R^{L"}, R^{M"}, and R^{N"} may be optionally joined to form a ring.

In some embodiments, the phosphorescent emitter material for the OLED according to the present disclosure can be selected from the group consisting of the following blue phosphorescent emitter materials: 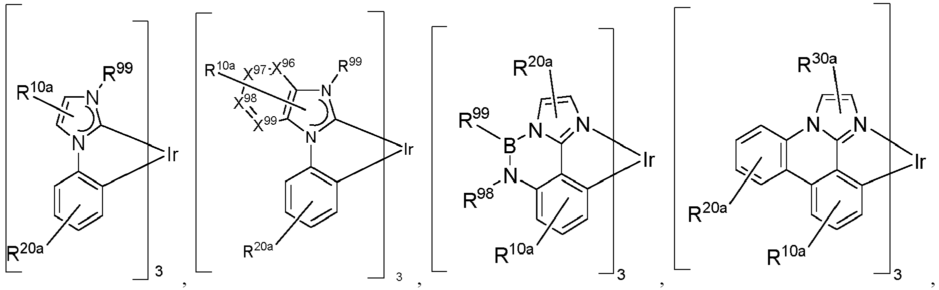 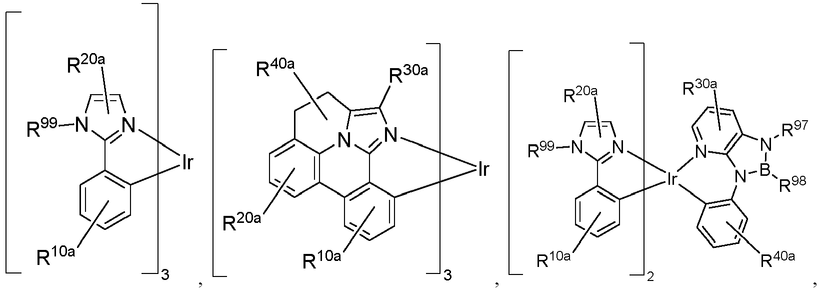 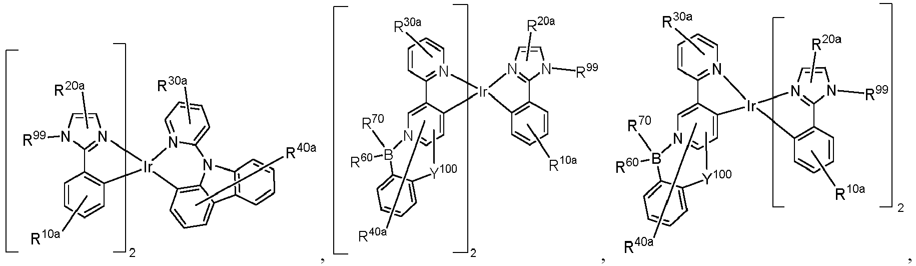 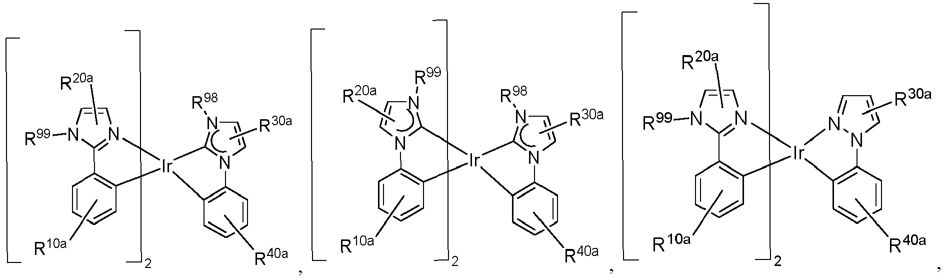 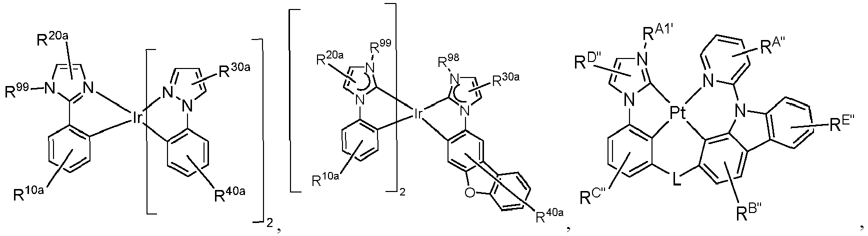 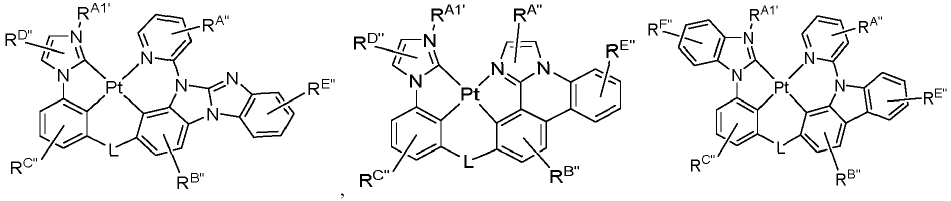 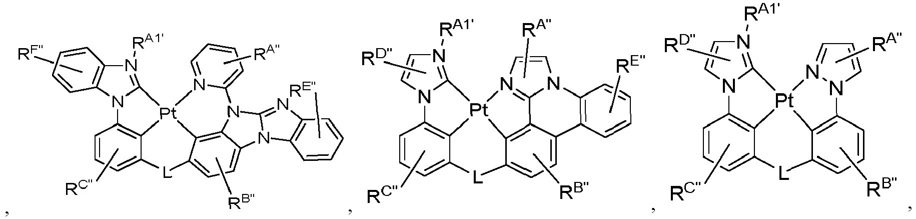 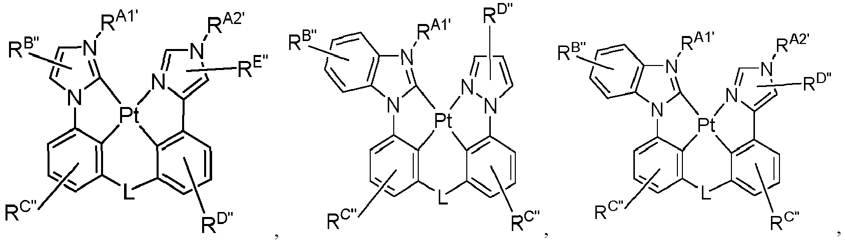 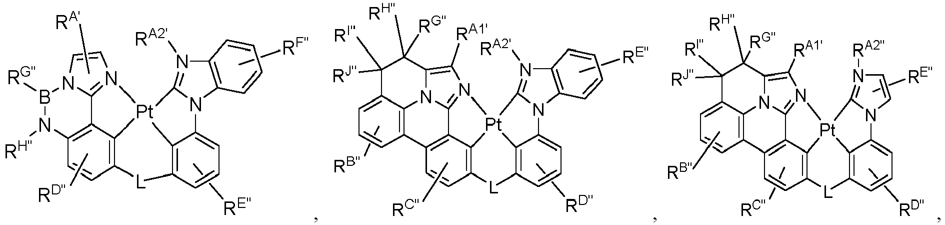 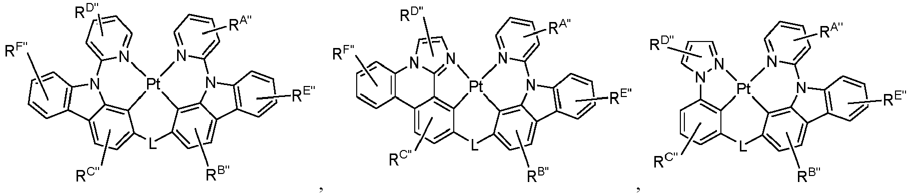 , and 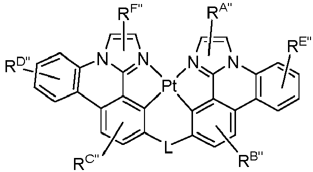 , wherein all the variables are the same as defined above.

### D. Blocking Layers and Materials

### EBL

The EBL family of materials can be used to block electrons and excitons when used as an EBL in an OLED in combination with an adjacent EML containing one or more of phosphorescent, fluorescent, and thermally activated delayed fluorescence (TADF) emitters, or a combination of these emitter classes on the anode side. The EBL family of materials has commercial level of stability and can help increase OLEDs' efficiency by confining electrons and/or excitons within a given EML by blocking or reducing the movement of electrons and excitons out of the EML on the anode side of the device. Many embodiments of the EBL family have a HOMO level that is between the HOMO levels of the typical HTL material and the typical host material in the EML, and higher LUMO level than those materials in the EML. This energy level alignment facilitates the injection of holes into the EML and can assist in obtaining charge balance in the OLED at all brightness levels, while blocking electrons leaking away from the EML. The EBL family materials are usually high triplet energy materials. This means that the triplet energy T₁ of the EBL family is greater than the triplet energies T₁s of all materials in the EML. Examples of the compounds that can be used as EBL family materials in the m-EBL of the OLED of the present disclosure are not particularly limited, and any compounds may be used as long as the compounds can carry out the electron blocking function as described above. Examples of suitable EBL family materials include, but are not limited to, those contain carbazole group, triarylamine-substituted carbazole group, or any common functional groups used in HTL and host as described herein, each of these groups can be further substituted with various functional groups, such as but not limited to: triarylamine, triphenylene, carbazole, indolocarbazole, dibenzothiphene, dibenzofuran, and dibenzoselenophene.

### HBL

The HBL family of materials can be used to block electrons and excitons when used as a HBL in an OLED in combination with an adjacent EML containing one or more of phosphorescent, fluorescent, and thermally activated delayed fluorescence (TADF) emitters, or a combination of these emitter classes on the cathode side. The HBL family of materials has commercial level of stability and can help increase OLEDs' efficiency by confining electrons and/or excitons within a given EML by blocking or reducing the movement of electrons and excitons out of the EML on the cathode side of the device. Many embodiments of the HBL family have a LUMO level that is between the LUMO levels of the typical ETL material and the typical host material in the EML, and lower HOMO level than those materials in the EML. This energy level alignment facilitates the injection of electrons into the EML and can assist in obtaining charge balance in the OLED at all brightness levels, while blocking holes leaking away from the EML. The HBL family materials are usually high triplet energy materials. This means that the triplet energy T₁ of the HBL family is greater than the triplet energies T₁s of all materials in the EML. Examples of the compounds that can be used as the HBL family materials in the m-HBL of the OLED of the present disclosure are not particularly limited, and any compounds may be used as long as the compounds can carry out the hole blocking function as described above. Examples of suitable HBL family materials include, but are not limited to, those containing the same molecule or the same functional groups used as host described above, or those containing at least one of the following groups in the molecule: 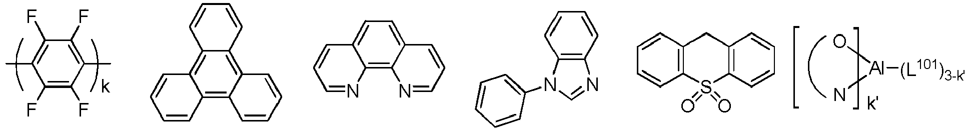 wherein k is an integer from 1 to 20; L¹⁰¹ is another ligand, k' is an integer from 1 to 3.

### E. Emitters

Examples of the emitter dopants that can be used as the emissive material in the EML of the OLED of the present disclosure are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

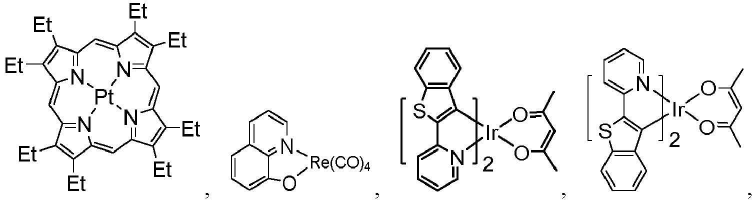

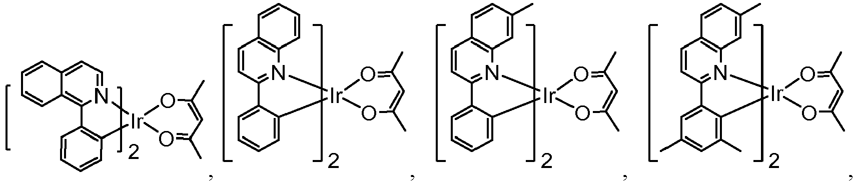

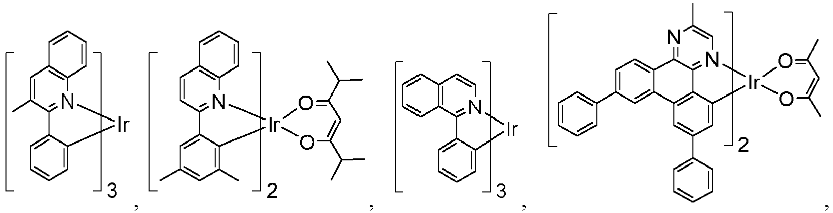

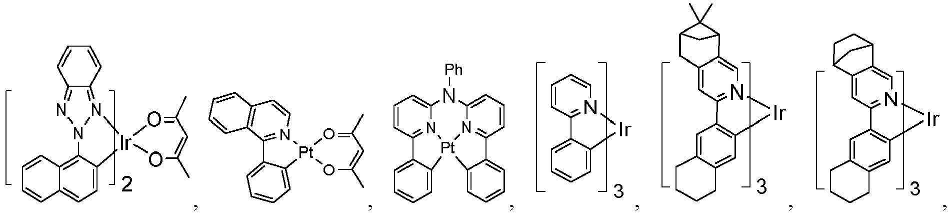

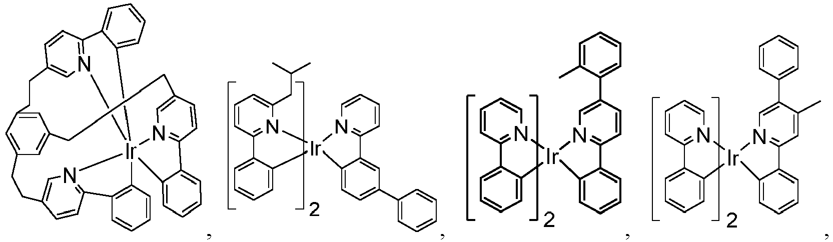

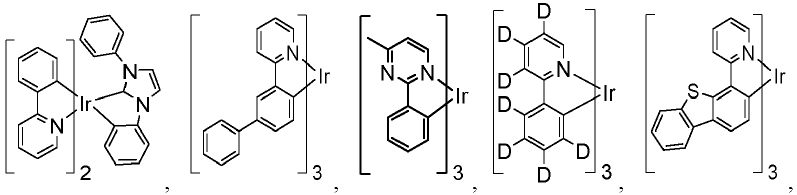

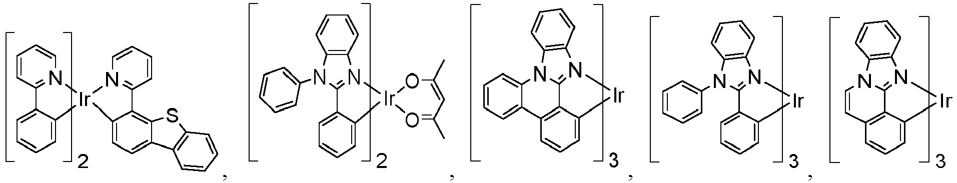

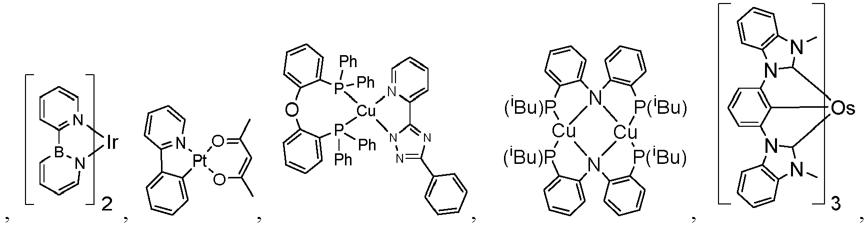

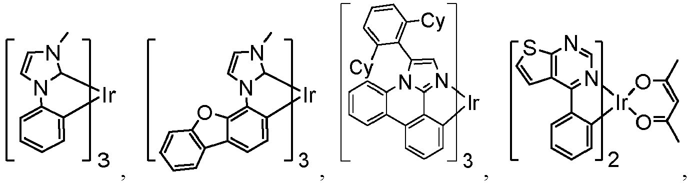

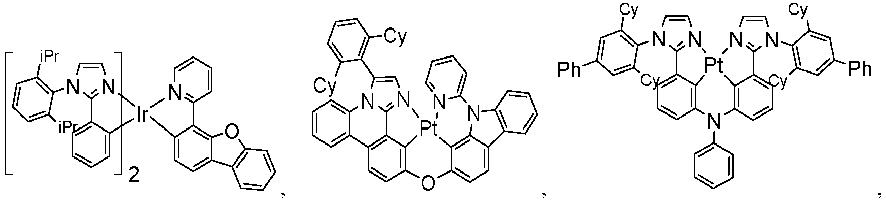

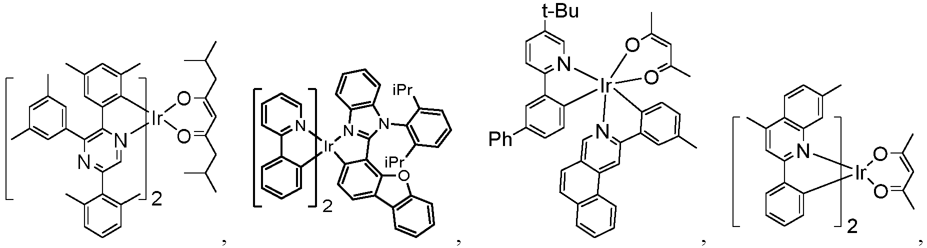

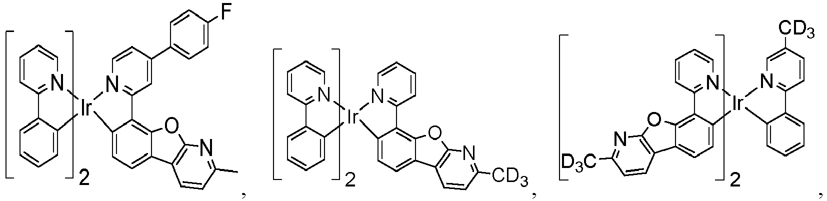

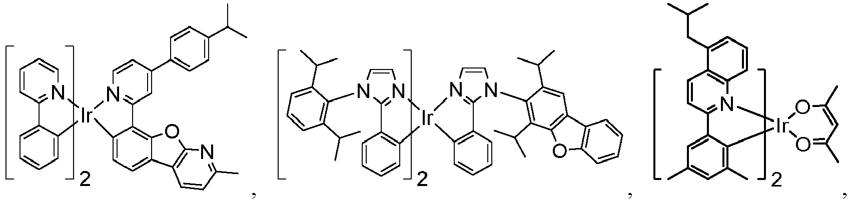

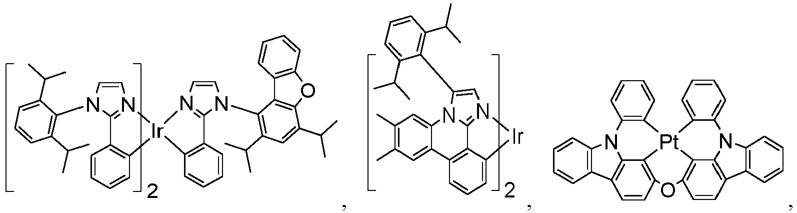

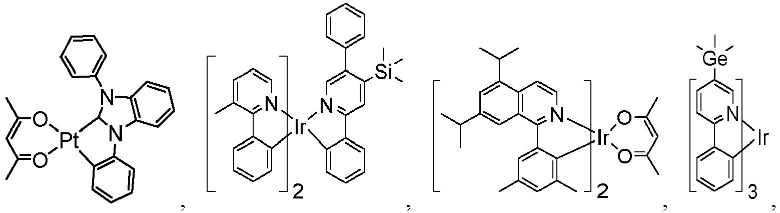

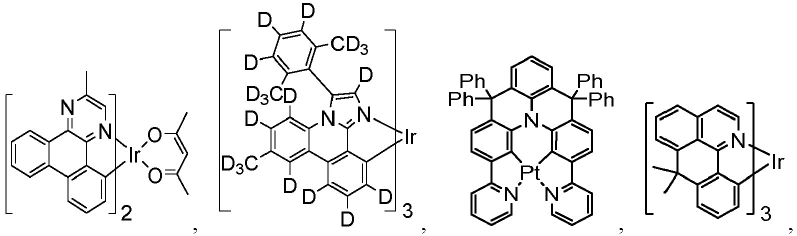

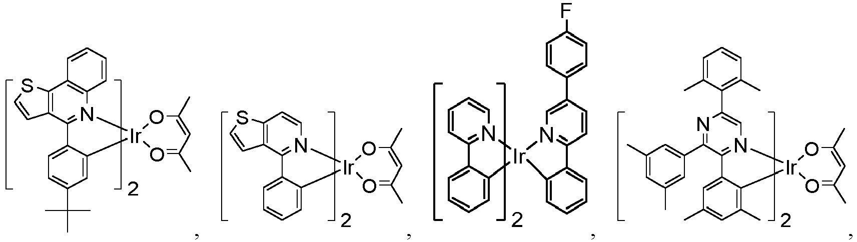

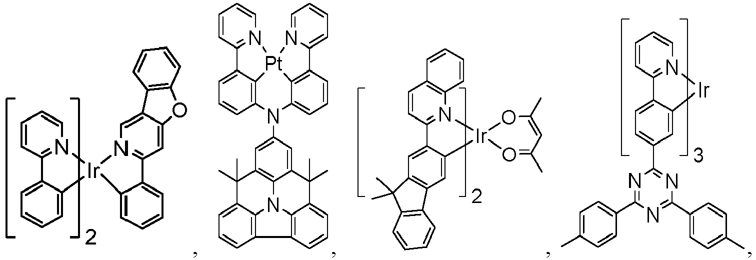

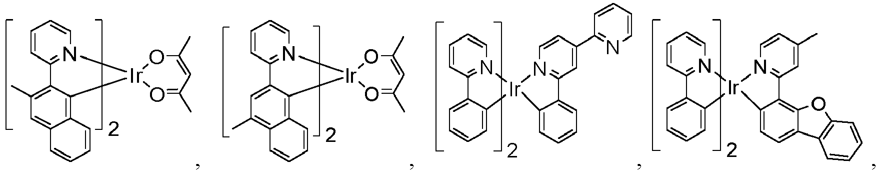

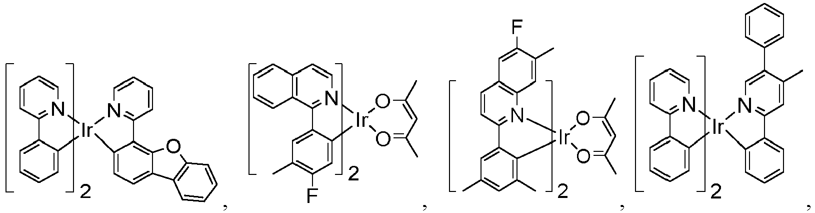

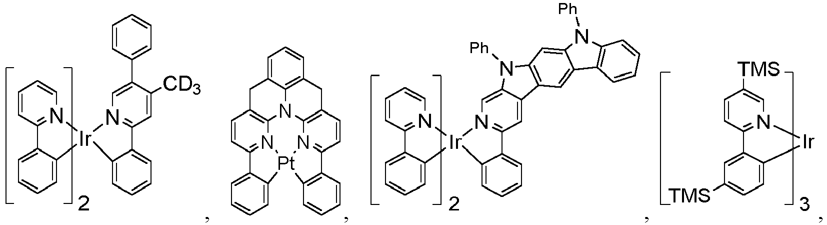

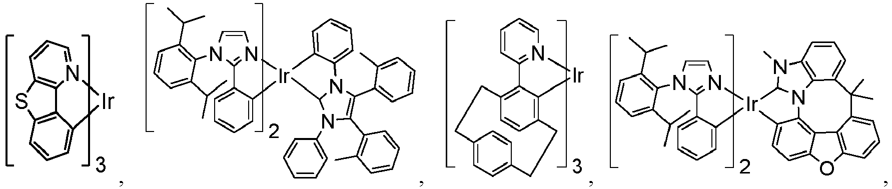

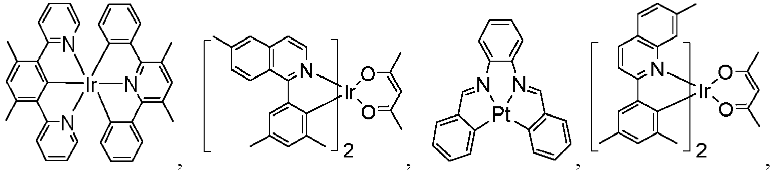

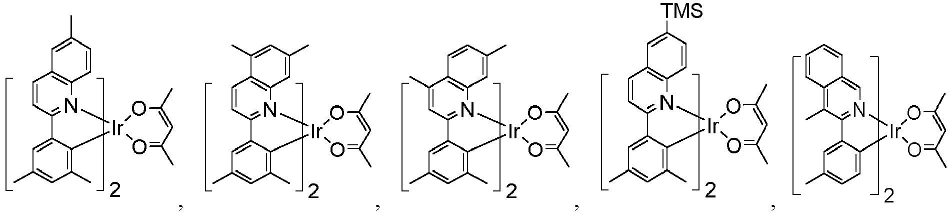

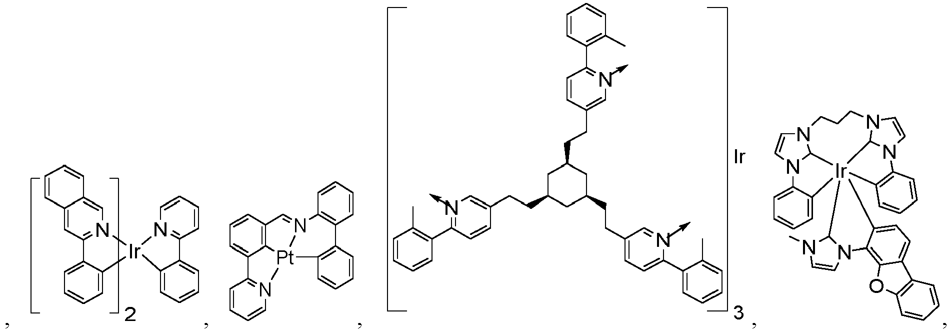

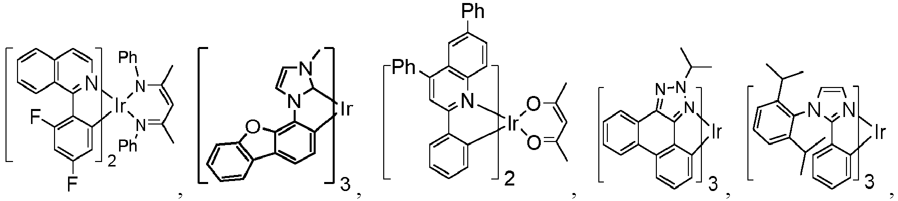

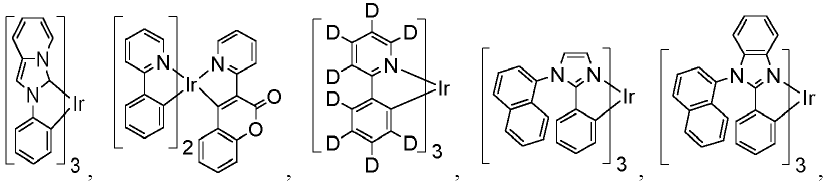

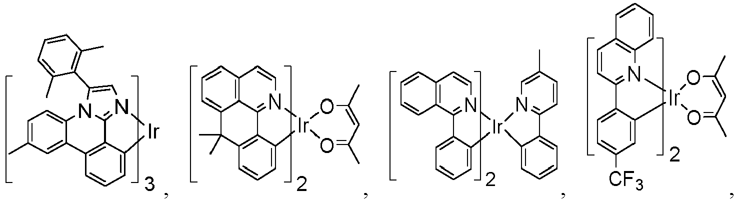

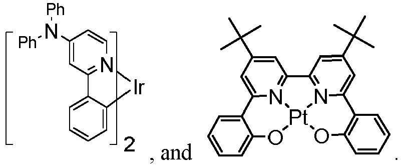

### F. HOSTs

Some examples of the organic compounds that can be used as hosts in the EML of the OLED according to the present disclosure are disclosed below.

The organic host materials can comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C=CCₙH₂ₙ₊₁, Ar₁, Ar₁-Ar₂, CₙH₂ₙ-Ar₁, or no substitution, wherein n is an integer from 1 to 10; and wherein Ar₁ and Ar₂ are independently selected from the group consisting of benzene, biphenyl, naphthalene, triphenylene, carbazole, and heteroaromatic analogs thereof.

In some embodiments, the organic host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa- 13b -boranaphtho [3,2,1 -de] anthracene).

In some embodiments, the host can be selected from the HOST Group consisting of: 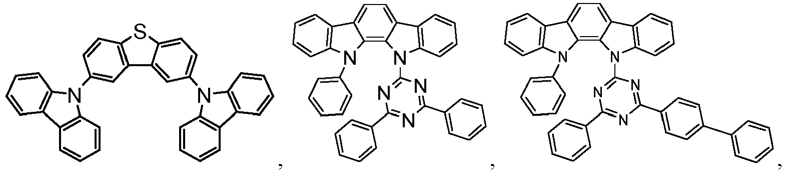 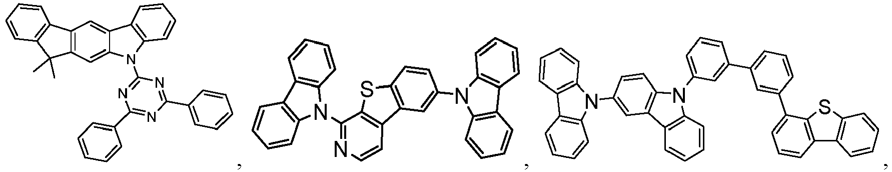 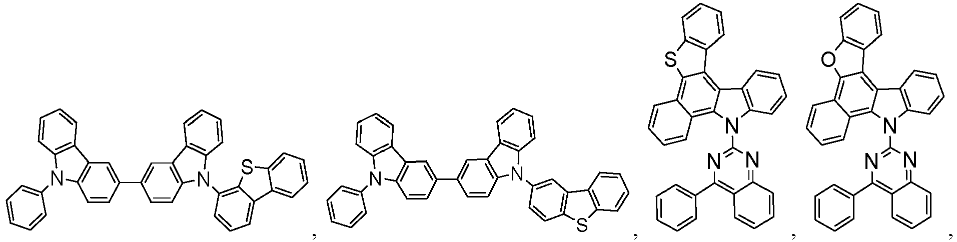 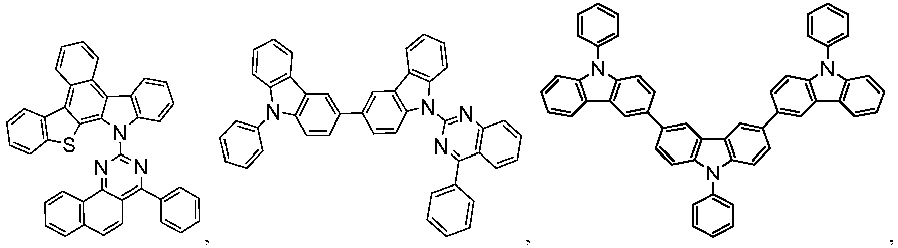 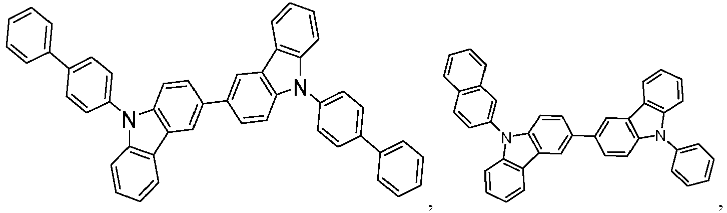 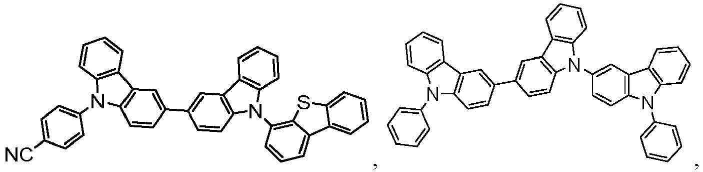 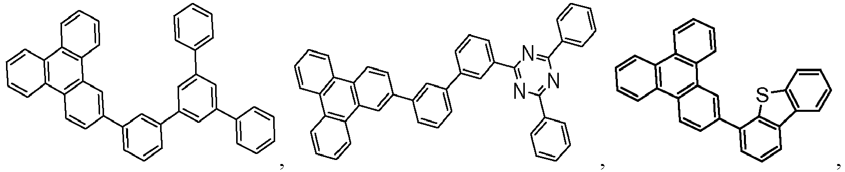 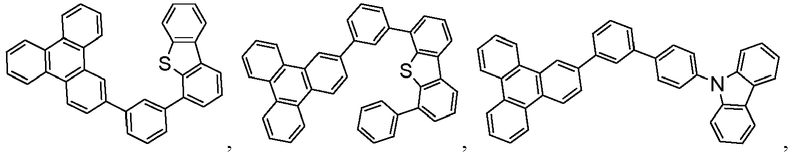 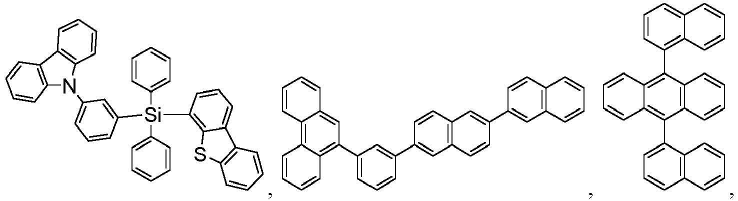 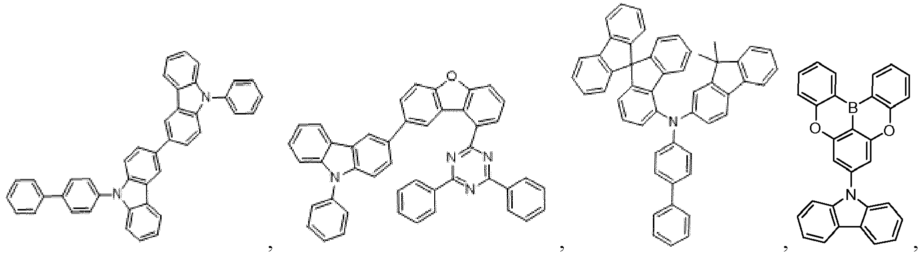 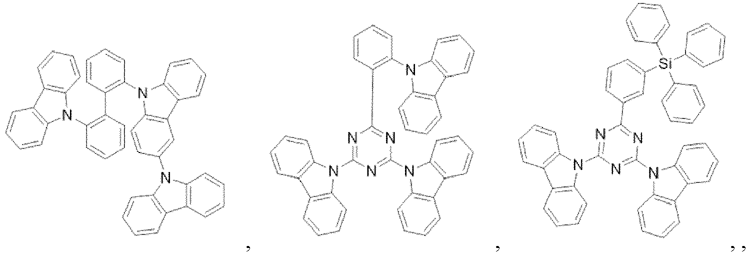 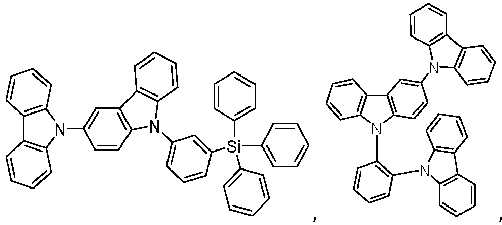 , and combinations thereof.

In some embodiments, the host comprises a metal complex.

### G. Other Hosts:

Examples of some additional class of organic compounds that can be used as hosts in the OLED of the present disclosure are presented below.

The light emitting layer of the organic EL device of the present disclosure preferably contains at least a metal complex as light emitting material, and may contain a host material using the metal complex as a host material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 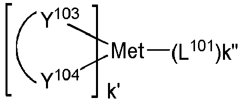 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 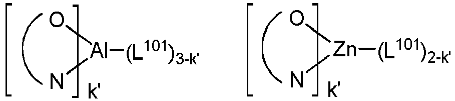 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 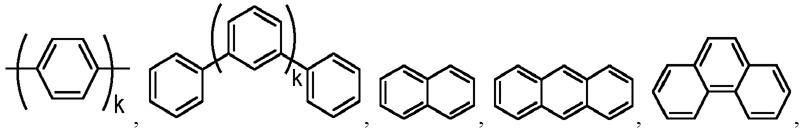 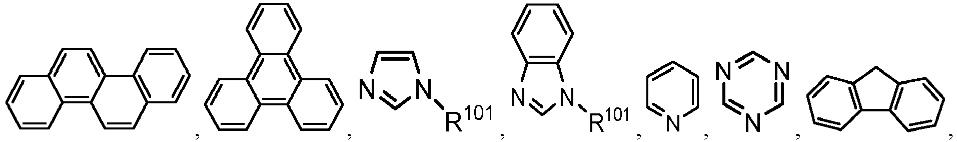 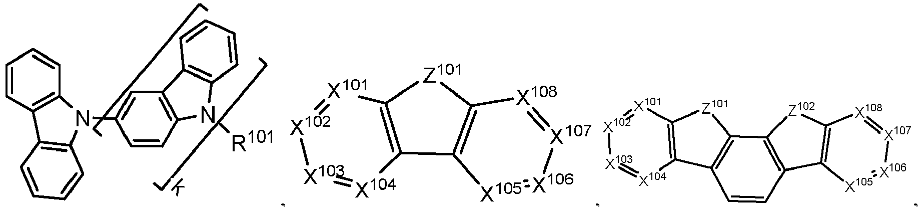 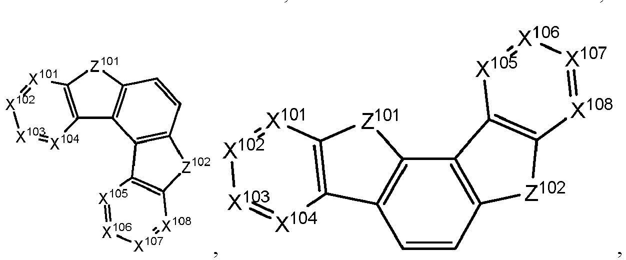 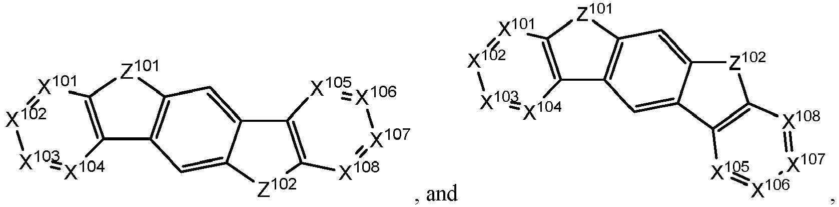 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

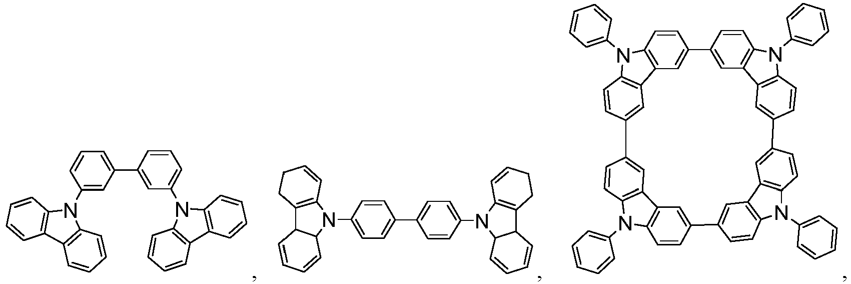

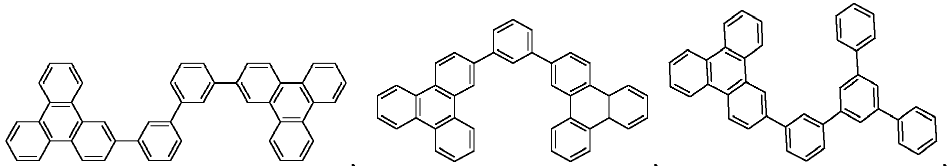

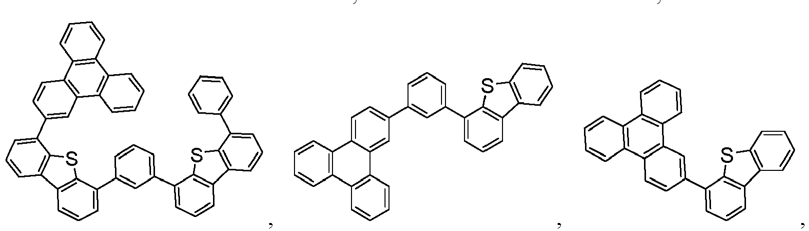

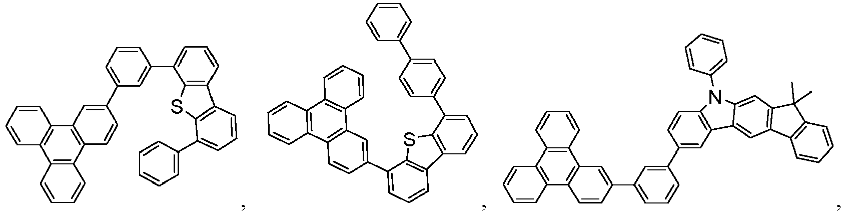

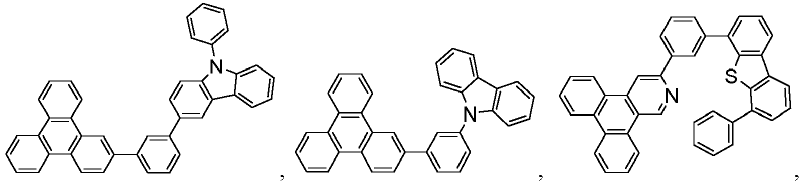

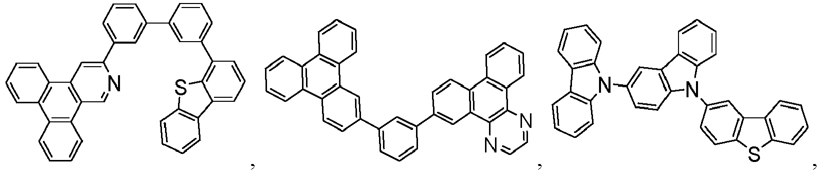

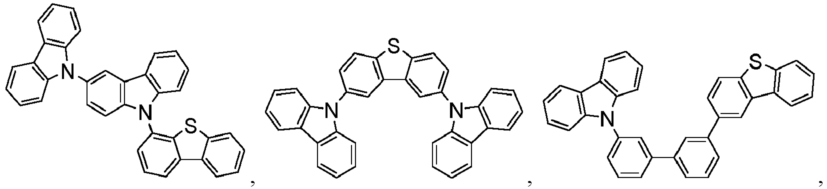

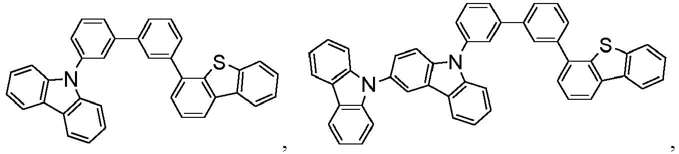

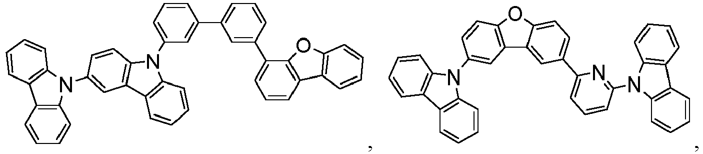

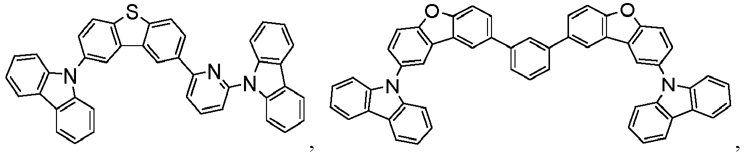

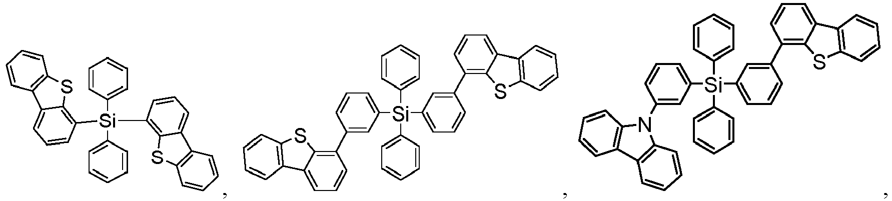

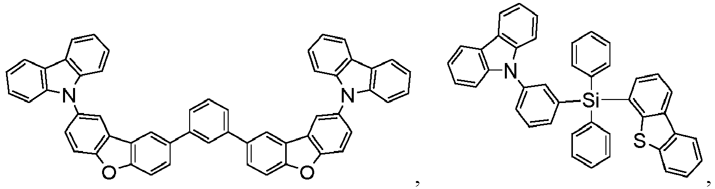

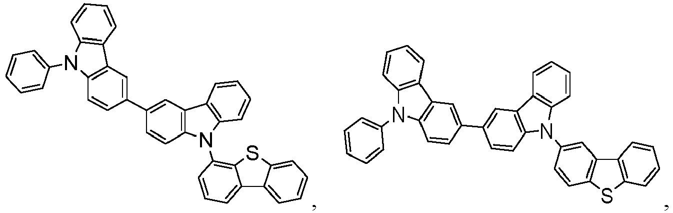

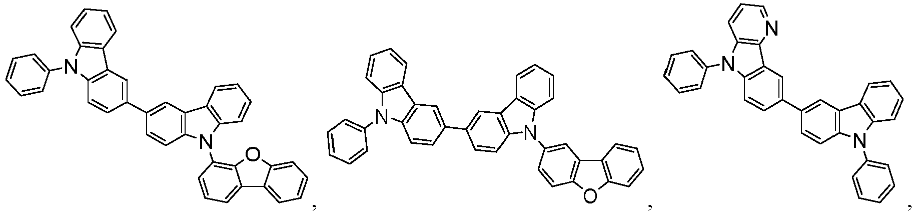

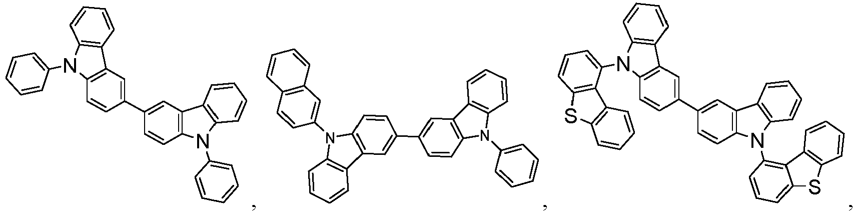

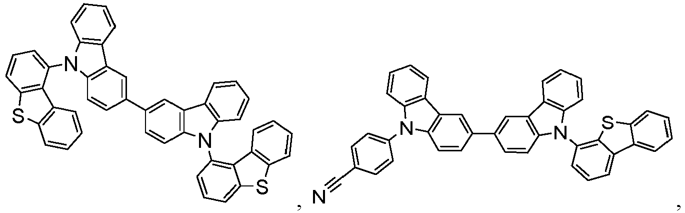

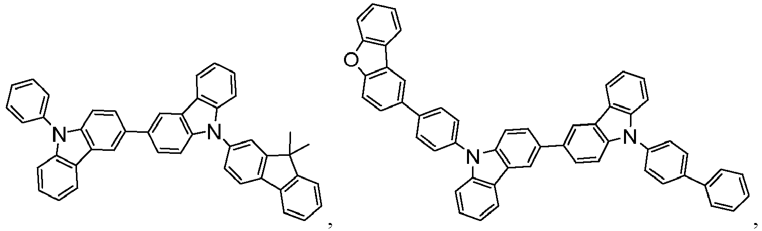

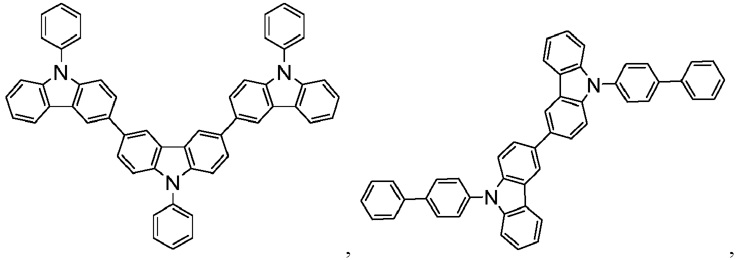

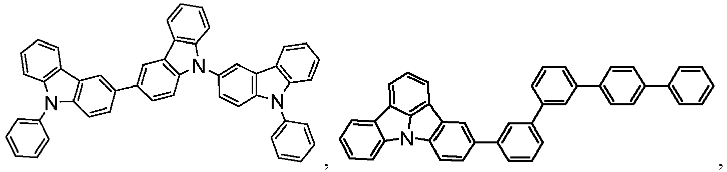

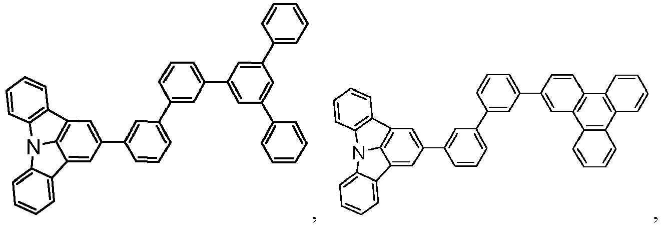

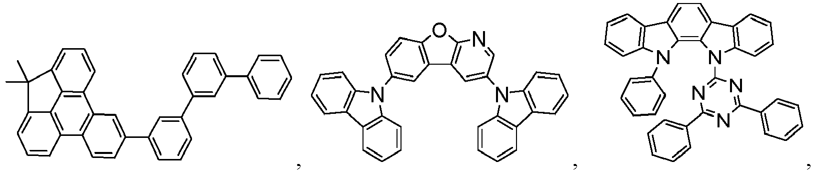

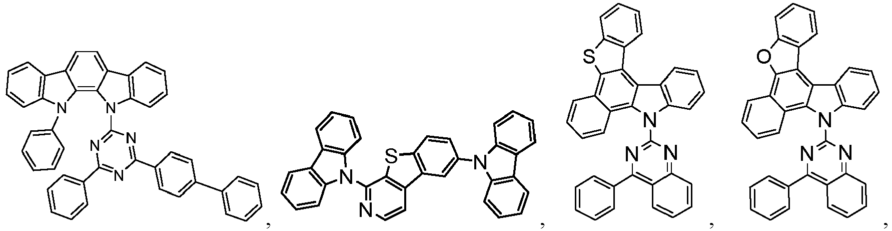

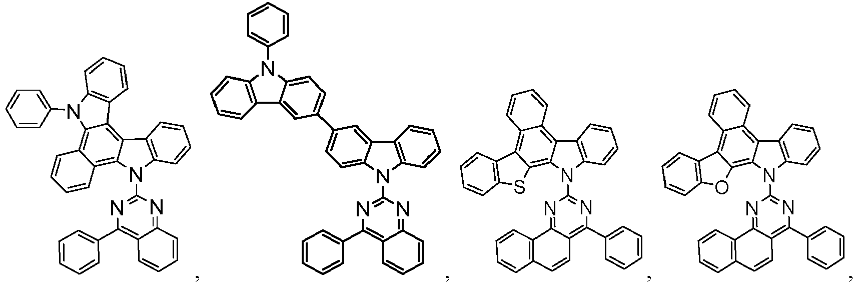

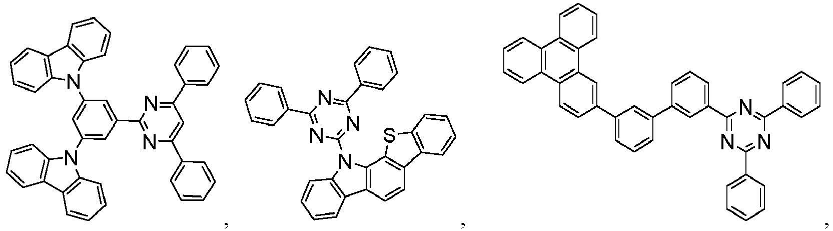

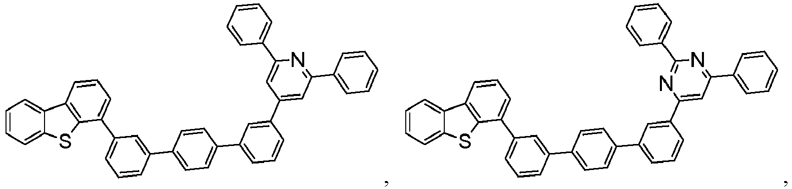

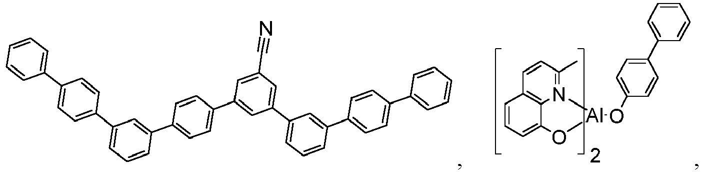

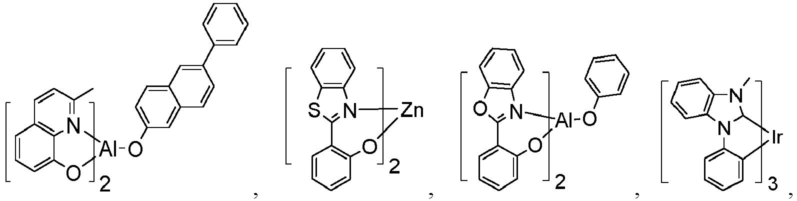

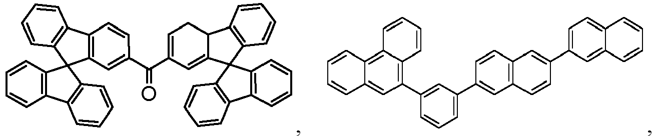

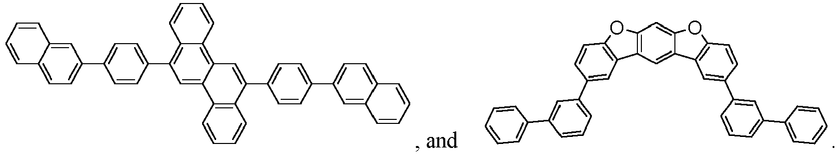

### H. HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

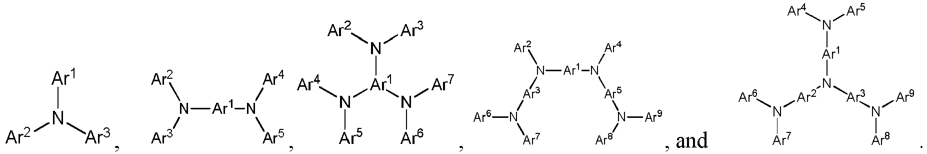

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 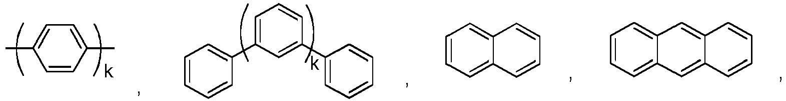 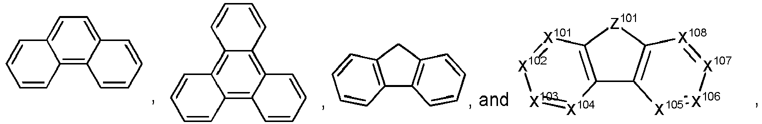 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 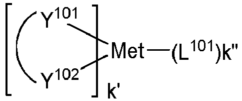 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018. 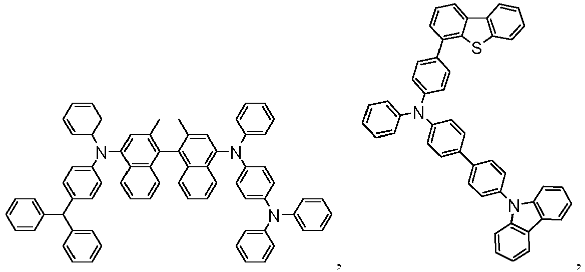 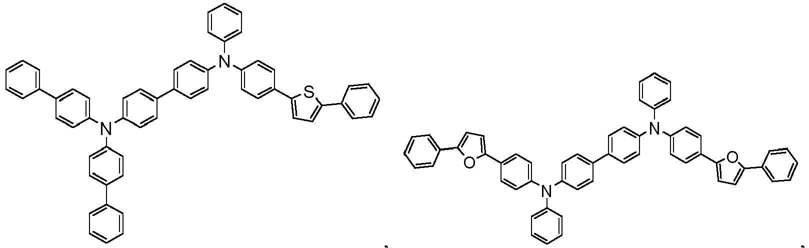 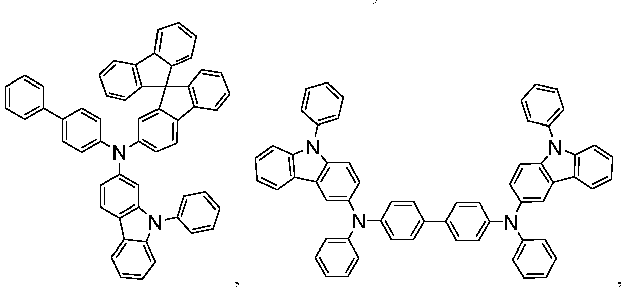 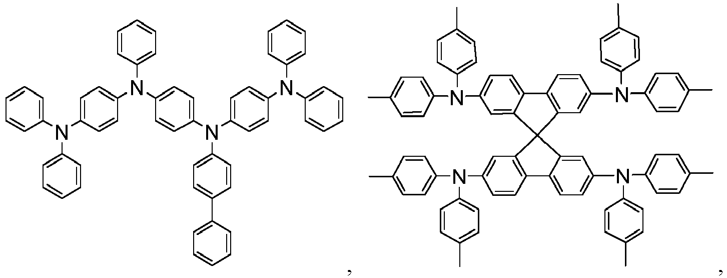 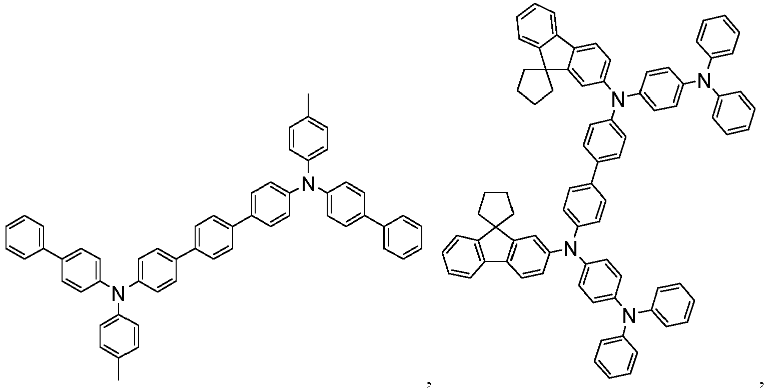 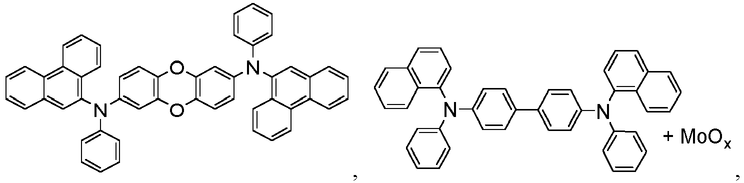 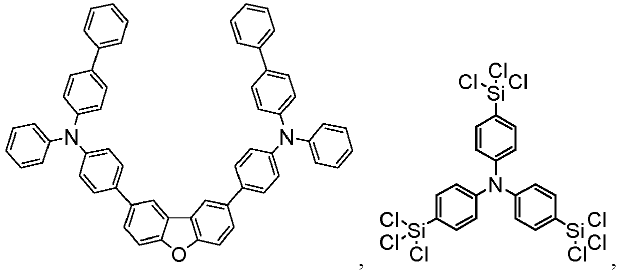 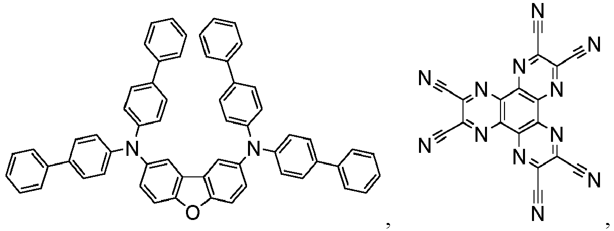 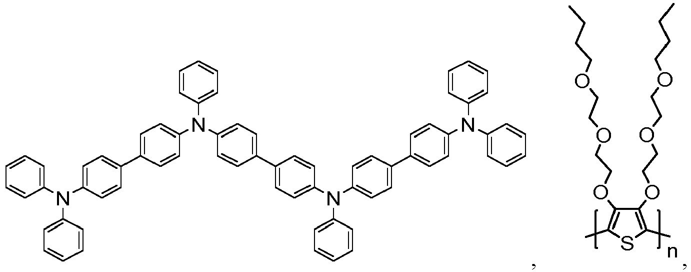 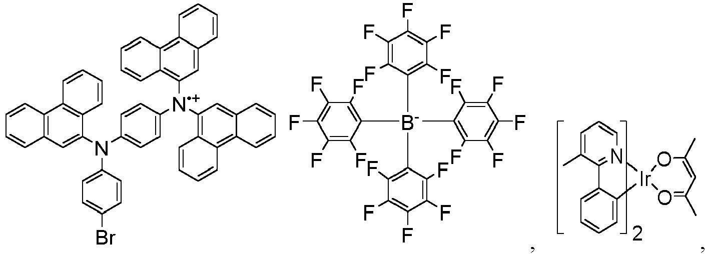 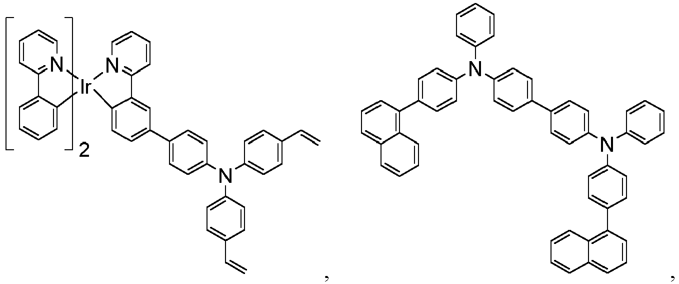 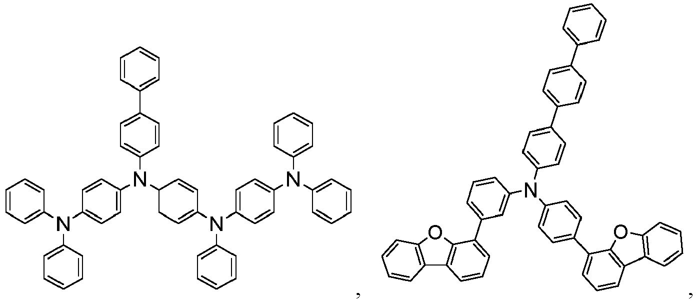 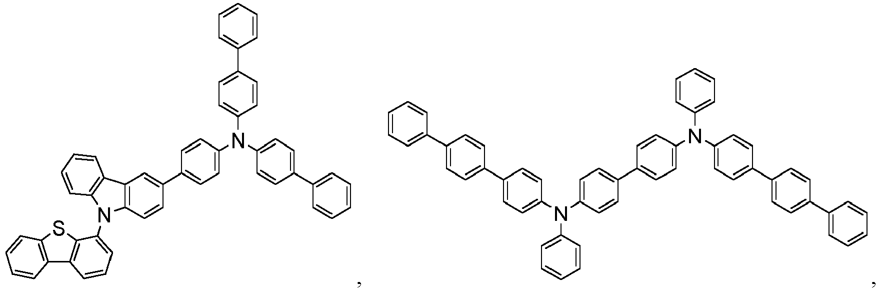 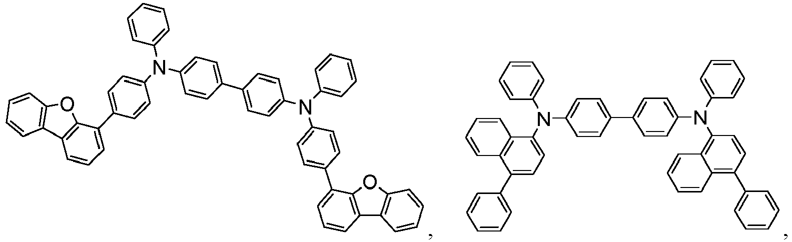 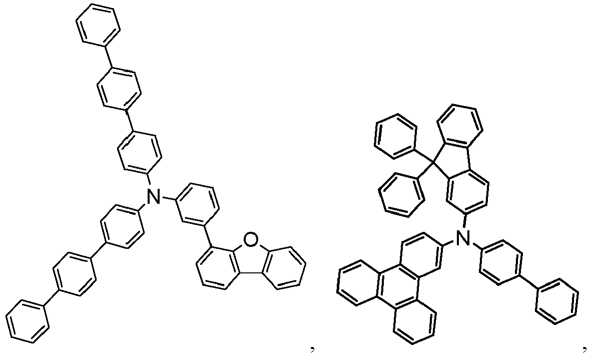 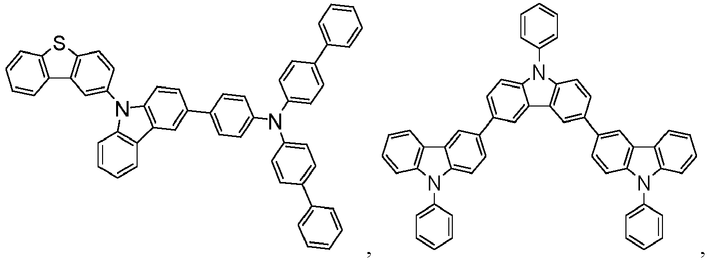 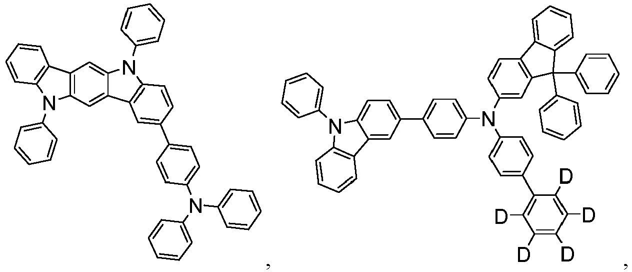 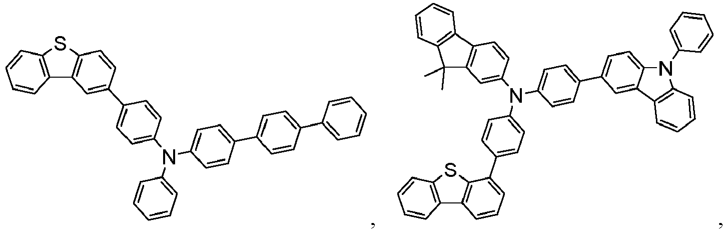 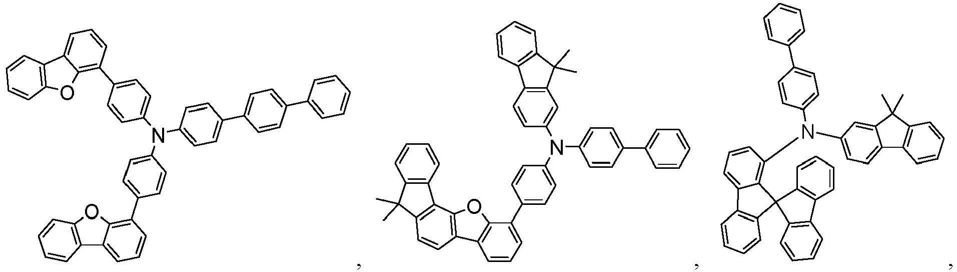 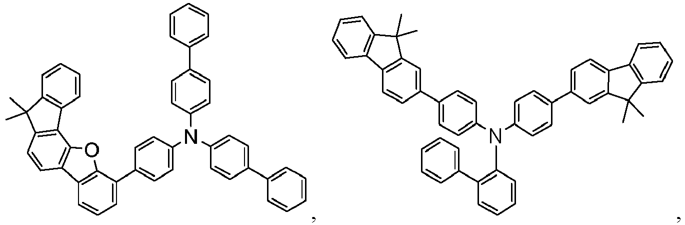 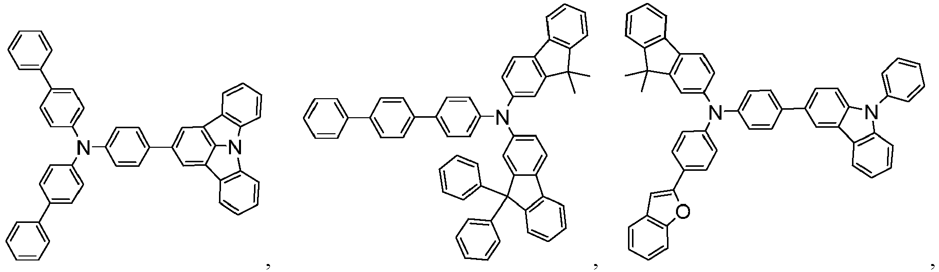 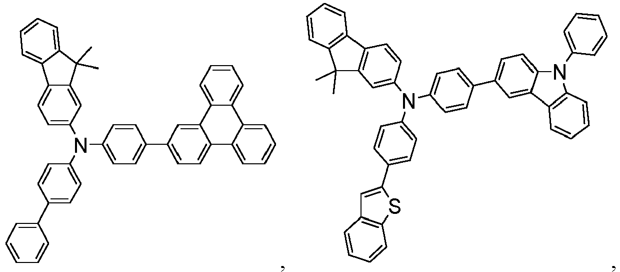 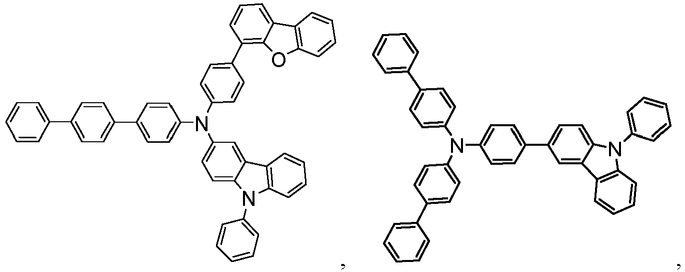 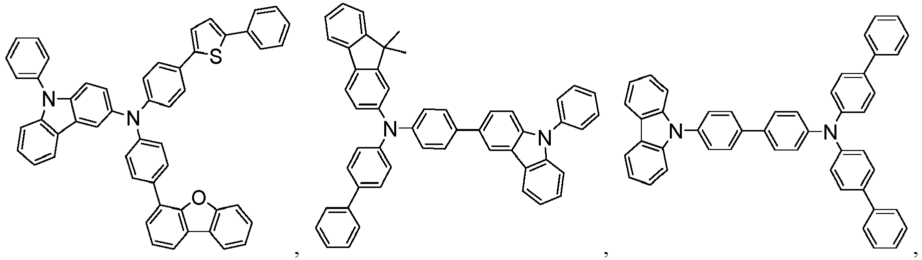 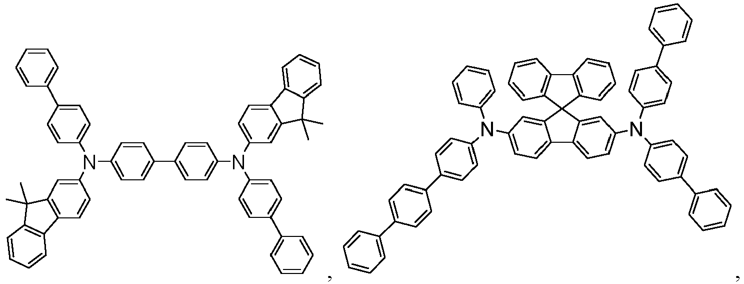 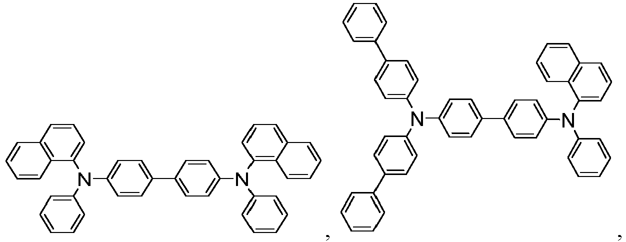 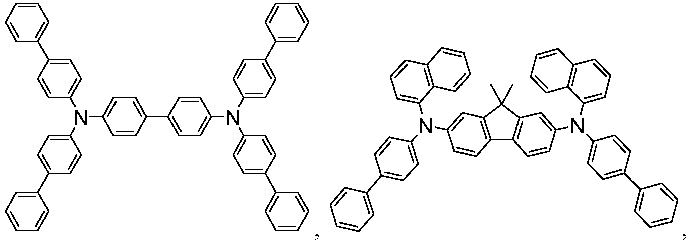 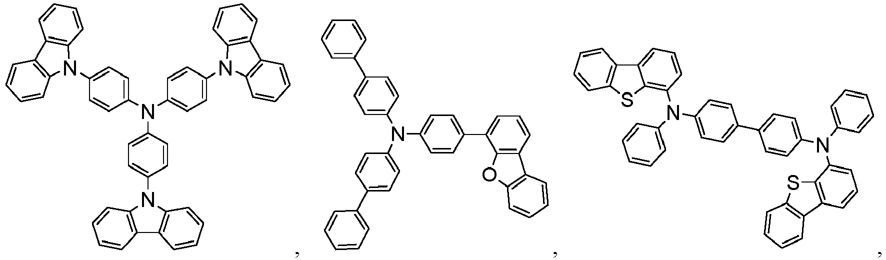 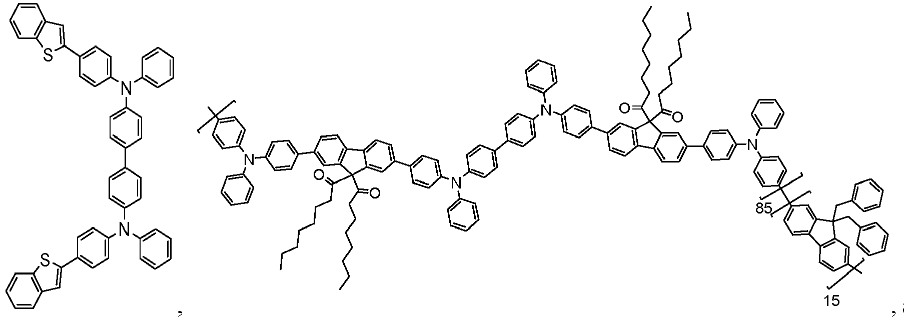 and combinations thereof.

### I. ETL

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 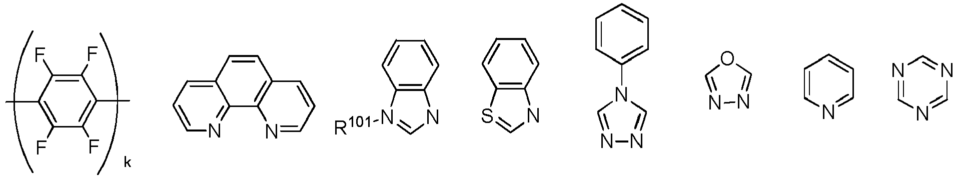 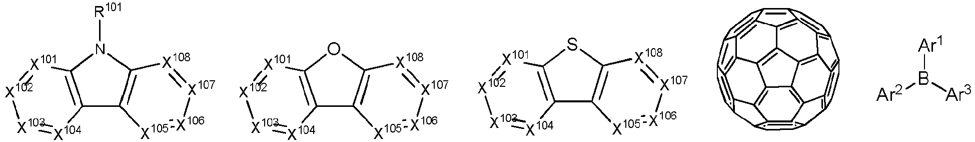 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 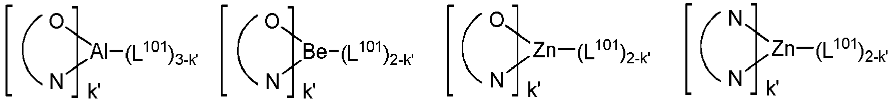 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535, 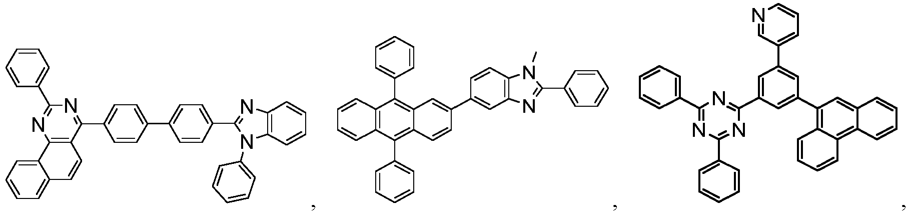 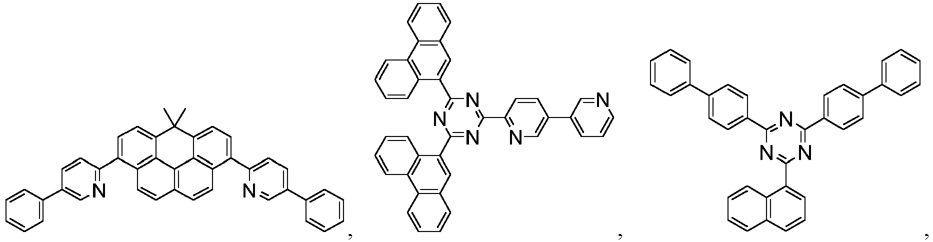 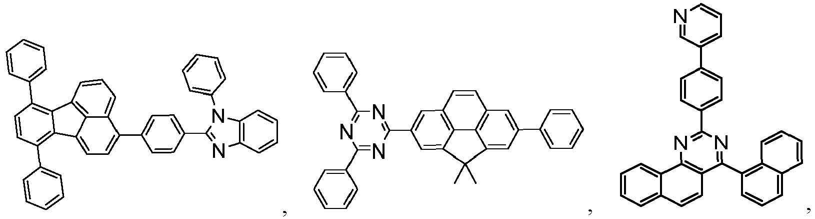 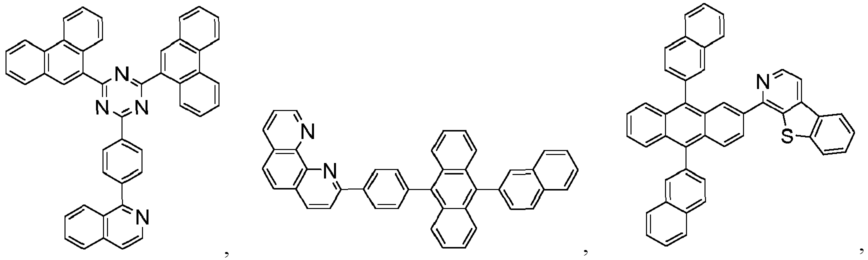 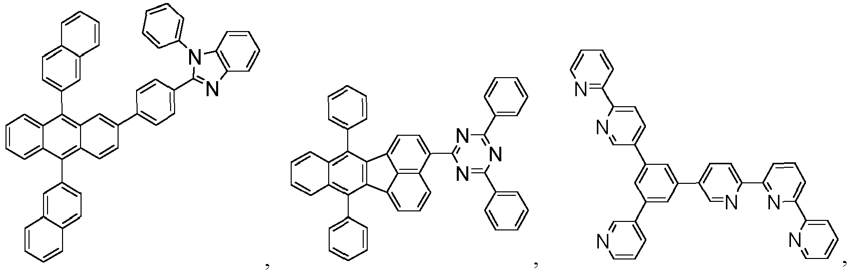 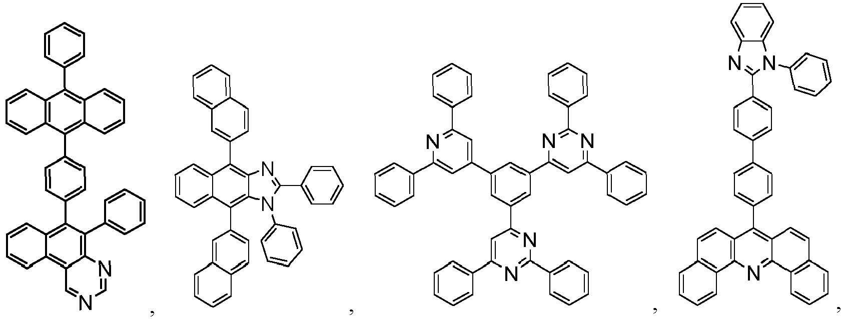 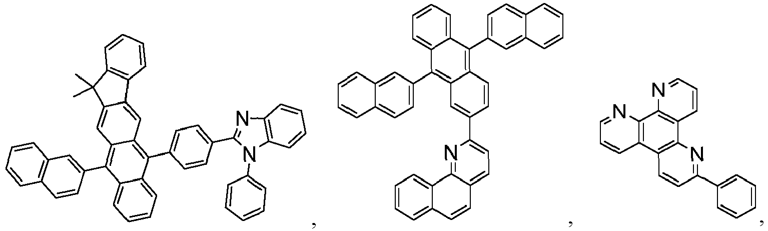 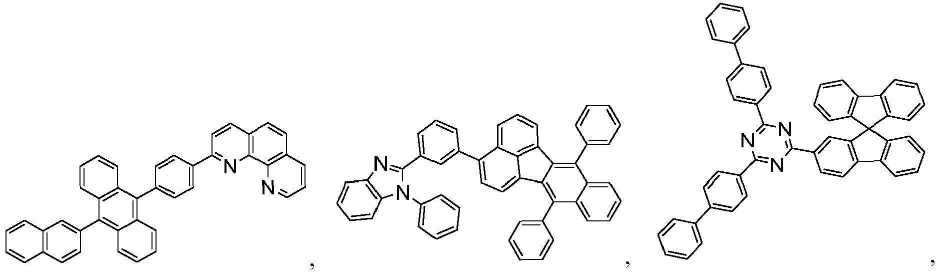 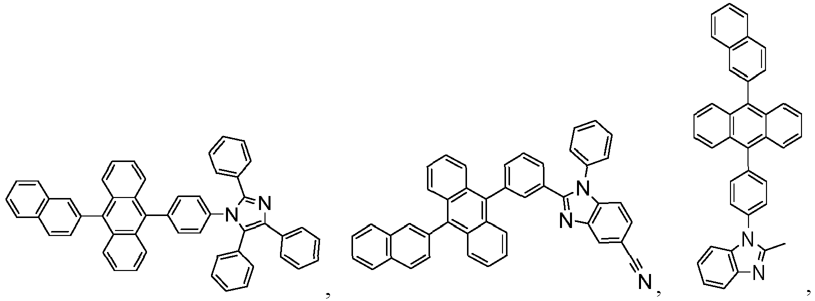 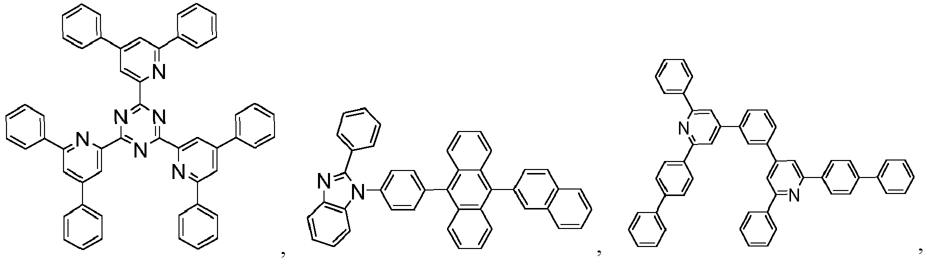 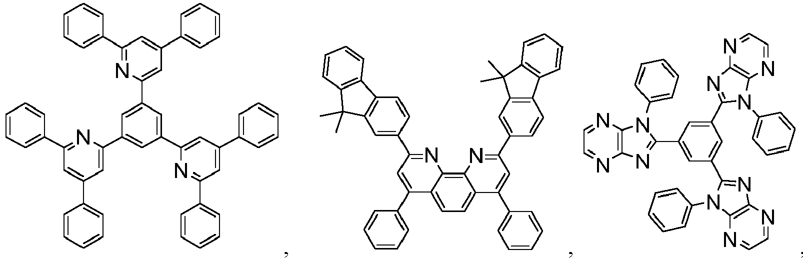 , and combinations thereof.

### J. Conductivity Dopants:

A charge transport layer or a charge injection layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

In one aspect, a compound used as a conductivity dopant contains at least one of the following groups in the molecule: 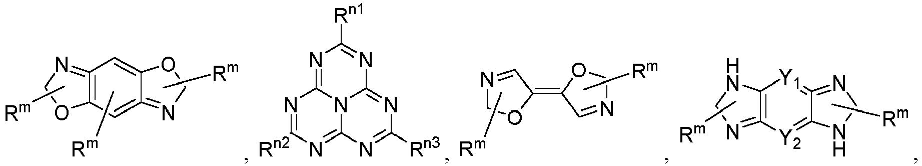 and MoO₃,
wherein each R^{m} independently represents mono substitution, up to the maximum substitutions, or no substitution;
each of R^{m}, Rⁿ¹, Rⁿ², and Rⁿ³ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof; and Y 1 and Y2 are each independently C or N. In some of the above embodiments, each of R^{m}, Rⁿ¹, Rⁿ². and Rⁿ³ may be CN, or CF³.

In some embodiments, a conductivity dopant may be one of 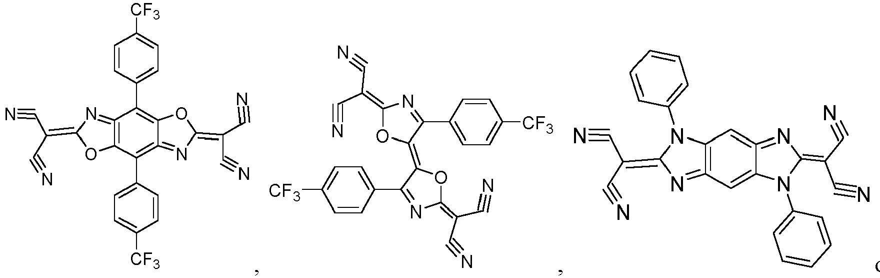 or, 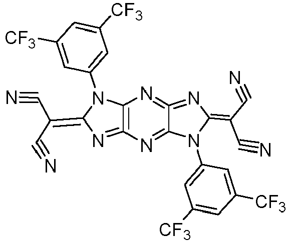 . Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

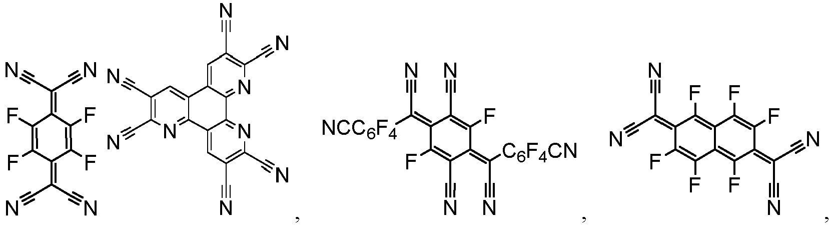

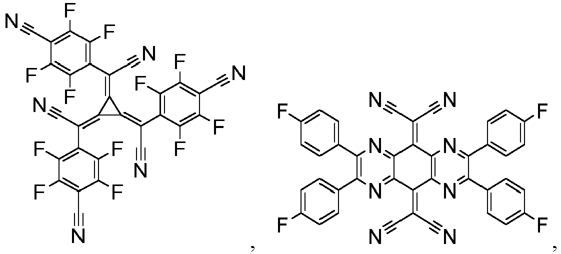

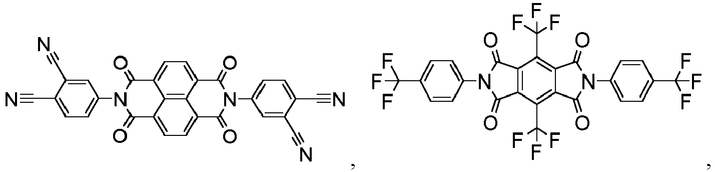

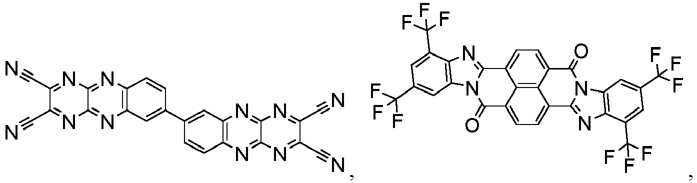

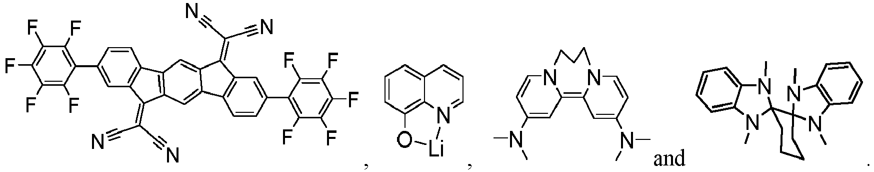

### K. Enhancement Layer

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer , and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

### L. Consumer Product

In yet another aspect, the present disclosure also provides a consumer product comprising the OLED of the present disclosure. In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated, e.g. Baldo et al., "Highly Efficient Phosphorescent Emission from Organic Electroluminescent Devices," Nature, vol. 395, 151-154, 1998; ("Baldo-1") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in U.S. Pat. No. 7,279,704 at cols. 5-6.

### M. Other Considerations

Structures and materials not specifically described may also be used, such as OLEDs comprised of polymeric materials (PLEDs) such as disclosed in U.S. Pat. No. 5,247,190 to Friend et al.. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al..

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196 organic vapor phase deposition (OVPD), such as described in U.S. Pat. No. 6,337,102 to Forrest et al. and deposition by organic vapor jet printing (OVJP, also referred to as organic vapor jet deposition (OVJD)), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In the inventive embodiments the emissive dopant in the EML produces emission via phosphorescence. In some embodiments, the emissive dopant can be a racemic mixture, or can be enriched in one enantiomer. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the OLED can include a phosphorescent sensitizer where one or multiple layers in the OLED contains an acceptor in the form of one or more fluorescent and/or delayed fluorescence emitters. The phosphorescent sensitizer must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

### N. Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

### Experimental Data

The following compounds were utilized in the OLED device examples as well as for photophysical measurements:

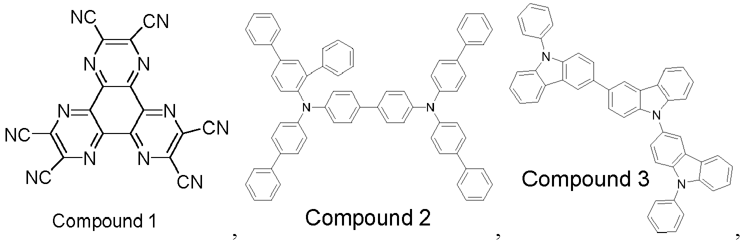

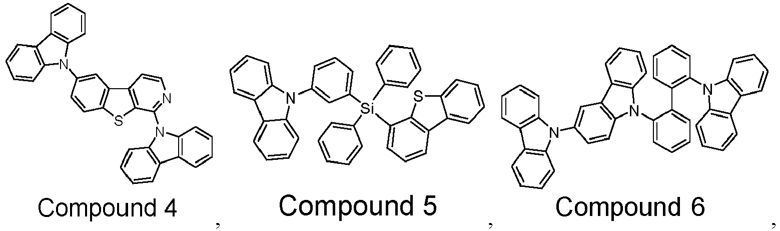

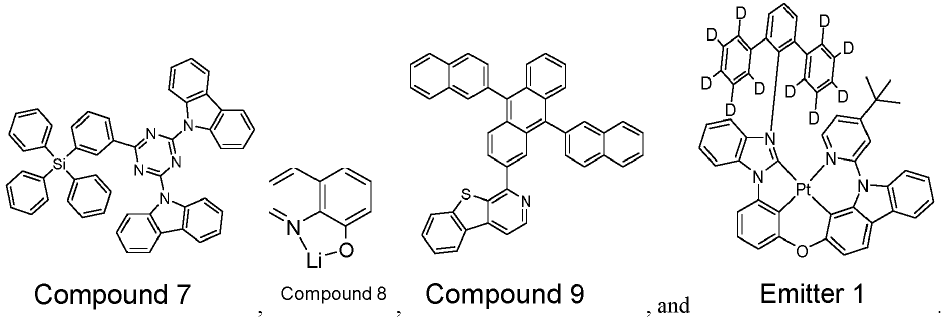

Emitter 1 is a blue phosphorescent emitter with a triplet energy T₁ greater than 2.7 eV. Thus, designing OLED device structures which maximize the efficiency is difficult due to having to achieve charge balance simultaneously with limiting triplet exciton quenching. Compounds 3, 4, 5, 6, and 7 are blocking layer materials as well as host materials for blue phosphorescent OLEDs. We demonstrate that triplet exciton quenching can be avoided by mixing electron and hole blocking layer materials with compound 5 in Table 1 which reports the normalized PLQY of Emitter 1 in various thin film compositions.

**Table 1: photoluminescent quantum yield measurements**

| **Film composition** | **PLQY (norm)** | **Increase** |
|---|---|---|
| Compound 5: Emitter 1 5% | 1.00 | -- |
| | | |
| Compound 3: Emitter 1 5% | 0.45 | -- |
| Compound 3: Compound 5 50%: Emitter 1 5% | 0.72 | 1.6 |
| | | |
| Compound 4: Emitter 1 5% | 0.66 | -- |
| Compound 4: Compound 5 50%: Emitter 1 5% | 0.82 | 1.2 |

Thin films for photoluminescent quantum yield measurements were fabricated using vacuum thermal evaporation. Films were deposited on quartz substrates. Doping percentages are in volume percent. PLQY values were measured using a Hamamatsu Quantaurus-QY Plus UV-NIR absolute PL quantum yield spectrometer with an excitation wavelength of 340nm with a continuous N₂ purge. Thin films samples are prepared on quartz and have an absorption of 25-75% of the excitation light. The N₂ purge is greater than 1 minute. It was found that by incorporating the high triplet energy compound 5 into the EBL material of Compound 3, the quenching of excitons was reduced by a factor of 1.6 times. Similarly, by incorporating compound 5 into the HBL material Compound 4, the exciton quenching of Emitter 1 was reduced by a factor of 1.2 times.

The OLED devices were constructed using m-EBLs and m-HBLs to demonstrate the advantage of multi-component EBLs and HBLs in OLED devices. The OLEDs were grown on a glass substrate precoated with an indium-tin-oxide (ITO) layer having a sheet resistance of 15-Q/sq. Prior to any organic layer deposition or coating, the substrate was degreased with solvents and then treated with an oxygen plasma for 1.5 minutes with 50W at 100 mTorr and with UV ozone for 5 minutes.

The devices in Tables 2, 3, and 4 were fabricated in high vacuum (< 10⁻⁶ Torr) by thermal evaporation. The anode electrode was 750 Å of indium tin oxide (ITO). The device examples had organic layers consisting of, sequentially, from the ITO surface, 100 Å of Compound 1 (HIL), 250 Å of Compound 2 (HTL), 50Å of m-EBL, 300 Å of either (a) Compound 5 doped with Compound 4 20% and Compound 3 10% and Emitter 1 12% or (b) Compound 6 doped with Compound 5 30% and Compound 7 26% and Emitter 1 12% (EML), 50 Å of a HBL, 300 Å of Compound 8 doped with 35% of Compound 9 (ETL), 10 Å of Compound 8 (EIL) followed by 1,000 Å of Al (Cathode). All devices were encapsulated with a glass lid sealed with an epoxy resin in a nitrogen glove box (<1ppm of H₂O and O₂,) immediately after fabrication with a moisture getter incorporated inside the package. Doping percentages are in volume percent.

For devices in Table 2, the EBLs were Compound 3 doped with 70% Compound 5 (m-EBL), only Compound 3 (single-component EBL), or only Compound 5 (single-component EBL). The EML is option (a) with Compounds 3, 4, and 5 while the single-component HBL was Compound 4. The LT is the normalized LT₉₀ at 1,000 nits which is calculated from accelerated aging at 20 mA/cm² and using an acceleration factor of 1.5. It is important to utilize a lifetime metric at a fix luminance as the increases in efficiency of the inventive devices means that device requires less current to achieve the same brightness. It was found that for these devices the two component m-EBL leads to higher EQE which may be due to reduced exciton quenching at the m-EBL/EML interface. Further, the device also has increased stability over the reference devices using either Compound 3 or Compound 5 as the single-component EBL. Importantly, we observed no increase in the operating voltage of the inventive device at 10 mA/cm² while the reference device only using Compound 5 as the single-component EBL has a significant increase in operating voltage. This indicates that the m-EBL is able to extract the best properties of hole blocking layer materials Compound 3 and Compound 5. In this example, the m-EBL is able to limit triplet quenching due to the inclusion of Compound 5 while maintaining the good hole transporting properties of Compound 3.

**Table 2: Multi-component EBL OLED device examples**

| **Device** | **EBL** | **at 10mA/cm²** | | | | | |
|---|---|---|---|---|---|---|---|
| | | **1931 CIE** | | | | | |
| | | **x** | **y** | **λ max** | **Voltage** | **EQE** | **LT90** |
| | | | | **[nm]** | **[norm]** | **[norm]** | **[norm]** |
| | Multi-component: | | | | | | |
| | Compound 3 30%: | | | | | | |
| Inventive | Compound 5 70% | 0.132 | 0.142 | 461 | 1.0 | 1.06 | 1.11 |
| Ref 1 | Compound 3 | 0.132 | 0.142 | 461 | 1.0 | 1.00 | 1.00 |
| Ref 2 | Compound 5 | 0.133 | 0.140 | 461 | 1.3 | 0.63 | 0.55 |

For devices in Table 3, the EBLs were Compound 3 doped with 50% Compound 5 (m-EBL), only Compound 3 (single-component EBL), only Compound 5 (single-component EBL), or only Compound 6 (single-component EBL). The single-component HBL was Compound 4. The EML was option (b) which is using Compounds 5, 6, and 7. The (lifetime) LT is the normalized LT₉₀ at 1,000 nits which is calculated from accelerated aging at 20 mA/cm² and using an acceleration factor of 1.5. It is important to utilize a lifetime metric at a fix luminance as the increases in efficiency of the inventive devices means that device requires less current to achieve the same brightness. Even with different materials in the EML, it was once again found that the m-EBL resulted in increased EQE and stability over the reference devices. Importantly, the multi-component EML which is composed of the Compound 3 which is not in the emissive layer along with Compound 5 out performed the EBL when it was only Compound 6 even though Compound 6 is the hole transporting host of the EML. This result is quite unexpected as one knowledgeable in the art would expect that using the hole transporting host from the EML would yield excellent performance as an EBL. Thus, we have demonstrated the power of the multi-component approach for achieving the best OLED efficiency and stability.

**Table 3: Multi-component EBL OLED device examples**

| **Device** | **EBL** | **at 10mA/cm²** | | | | | |
|---|---|---|---|---|---|---|---|
| | | **1931 CIE** | | | | | |
| | | **x** | **y** | **λ max** | **Voltage** | **EQE** | **LT90** |
| | | | | **[nm]** | **[norm]** | **[norm]** | **[norm]** |
| | Multi-component: | | | | | | |
| | Compound 3 50% : | | | | | | |
| Inventive | Compound 5 50% | 0.136 | 0.150 | 461 | 1.0 | 1.04 | 1.16 |
| Ref 1 | Compound 3 | 0.136 | 0.149 | 461 | 1.0 | 1.00 | 1.10 |
| Ref 2 | Compound 6 | 0.136 | 0.148 | 461 | 1.0 | 1.01 | 1.00 |
| Ref 3 | Compound 5 | 0.136 | 0.150 | 461 | 1.4 | 0.95 | 0.86 |

For devices in Table 4, the EBL was Compound 3. The EML is option (a) with Compounds 3, 4, and 5. The HBL was Compound 4 doped with 30% Compound 5, 80% Compound 5, 90% Compound 5, or no doping. The LT is the normalized LT₉₀ at 1,000 nits which is calculated from accelerated aging at 20 mA/cm² and using an acceleration factor of 1.5. It is important to utilize a lifetime metric at a fix luminance as the increases in efficiency of the inventive devices means that device requires less current to achieve the same brightness leading to increased stability. In the device in Table 4, we find that the multi-component HBL achieves higher EQE and greater stability compared to utilizing the electron transporting host from the EML as the HBL.

**Table 4: Multi-component HBL OLED device examples**

| **Device** | **HBL** | **at 10mA/cm²** | | | | | |
|---|---|---|---|---|---|---|---|
| | | **1931 CIE** | | | | | |
| | | **x** | **y** | **λ max** | **Voltage** | **EQE** | **LT90** |
| | | | | **[nm]** | **[norm]** | **[norm]** | **[norm]** |
| Inventive 1 | Compound 4 70% : | | | | | | |
| | Compound 5 30% | 0.132 | 0.143 | 461 | 1.0 | 1.40 | 1.62 |
| Inventive 2 | Compound 4 20% : | | | | | | |
| | Compound 5 80% | 0.132 | 0.143 | 462 | 1.0 | 1.44 | 1.76 |
| Inventive 3 | Compound 4 10% : | | | | | | |
| | Compound 5 90% | 0.132 | 0.143 | 461 | 1.1 | 1.44 | 1.64 |
| Ref 1 | Compound 4 | 0.132 | 0.145 | 462 | 1.0 | 1.00 | 1.00 |

**Table 5 summarizes the HOMO LUMO, and triplet energies of the compounds utilizes in these devices.**

| Compound | HOMO (eV) | LUMO (eV) | T₁ (eV) |
|---|---|---|---|
| 3 | -5.38 | -1.83 | 2.90 |
| 4 | -5.70 | -2.46 | 3.00 |
| 5 | -5.68 | -1.98 | 3.05 |
| 6 | -5.46 | -1.96 | 3.08 |
| 7 | < -5.8 | -2.78 | 3.02 |
| Emitter 1 | -5.35 | -2.05 | 2.77 |

The HOMO energy is estimated from the first oxidation potential derived from cyclic voltammetry. The LUMO energy is estimated from the first reduction potential derived from cyclic voltammetry. The triplet energy _{T1} of the emitter compounds is measured using the peak wavelength from the photoluminescence at 77K. Solution cyclic voltammetry and differential pulsed voltammetry were performed using a CH Instruments model 620 1B potentiostat using anhydrous dimethylformamide solvent and tetrabutylammonium hexafluorophosphate as the supporting electrolyte. Glassy carbon and platinum and silver wires were used as the working, counter and reference electrodes, respectively. Electrochemical potentials were referenced to an internal ferrocene-ferroconium redox couple (Fc+/Fc) by measuring the peak potential differences from differential pulsed voltammetry. The EHOMO = - [(Eox1 vs Fc+/Fc) + 4.8], and the ELUMO = -[(Ered1 vs Fc+/Fc) + 4.8], wherein Eox1 is the first oxidation potential and the Ered1 is the first reduction potential. Where the triplet energy, _{T1}, for blocking layer and host materials was obtained from emission onset taken at 20% of the peak height of the emission of a frozen sample in 2-MeTHF at 77 K. The spectrum was collected on a Horiba Fluorolog-3 spectrofluorometer.

## Claims

1. An organic light emitting device (OLED, 100) comprising a light emitting stack that comprises:
a first electrode (115);
a second electrode (160); and
a first layer (120, 125, 130, 140, 145, 150) and an emissive layer (EML, 135) disposed between the first electrode (115) and the second electrode (160), the EML comprising three host materials and a first emissive material dopant that is a phosphorescent emitter; **characterised in that** the first layer is a multi-component electron blocking layer (m-EBL, 130) comprising at least two components or a multi-component hole blocking layer (m-HBL, 140) comprising at least two components,
wherein when the first layer is an m-EBL, the first layer is adjacent to the EML and the OLED further comprises a hole transporting layer (HTL, 125) and a hole injection layer (HIL, 120) disposed between the first layer and one of the two electrodes that is an anode or a charge generation layer;
wherein when the first layer is an m-HBL, the first layer is adjacent to the EML and the OLED further comprises an electron transporting layer (ETL, 145) and an electron injection layer (EIL, 150) disposed between the first layer and one of the two electrodes that is a cathode or a charge generation layer.

2. The OLED of claim 1, wherein a minimum number of components in the EML is selected from the group consisting of 4, 5, 6, 7, and 8.

3. The OLED of claim 1, wherein the OLED further comprises a second layer; wherein the second layer is configured to be one of the layers from the following Functional Layer Group: a multi-component hole injecting layer (m-HIL), a multi-component hole transporting layer (m-HTL), a multi-component electron blocking layer (m-EBL), a multi-component hole blocking layer (m-HBL), a multi-component electron transporting layer (m-ETL), and a multi-component electron injecting layer (m-EIL);and is a different type of layer from the first layer;
wherein the m-EBL and m-HBL each comprises at least two components, and the m-HIL, m-HTL, m-EIL, and m-ETL each comprises at least three components;
wherein when the second layer is an m-EBL, the second layer is adjacent to the EML and the OLED further comprises a HTL and a HIL disposed between the second layer and one of the two electrodes that is an anode or a charge generation layer;
wherein when the second layer is an m-HBL, the second layer is adjacent to the EML and the OLED further comprises an ETL and an EIL disposed between the second layer and one of the two electrodes that is a cathode or a charge generation layer.

4. The OLED of claim 1, wherein each component in a layer in direct contact with the EML has a higher T₁ energy than any component in the EML by at least 0.1 eV; and/or wherein first layer is an m-EBL or an m-HBL and each component in the first layer has a HOMO energy within 0.4 eV of each other, and/or a LUMO energy within 0.4 eV of each other.

5. The OLED of claim 1, wherein the EML comprises an emitter, a hole transporting host, and an electron transporting host; or wherein the EML comprises an emitter, a hole transporting host, and an electron transporting host, and a wide-band gap host.

6. The OLED of claim 1, wherein the EML comprises an acceptor which also functions as an emitter, a sensitizer, or a host; and/or the EML comprises an acceptor, a sensitizer, a hole transporting host, and an electron transporting host.

7. The OLED of claim 1, wherein two of the components of the EML other than the emitter form an exciplex; and/or wherein the m-EBL and m-HBL each comprises at least one hole transporting material, and at least one electron transporting material.

8. The OLED of claim 1, wherein the first layer is an m-EBL comprising at least two electron blocking materials; or
the first layer is an m-HBL comprising at least two hole blocking materials.

9. The OLED of claim 1, wherein the EML comprises an organometallic complex that contains one of the following metals: Ag, Au, Cu, Ir, Rh, Os, Pt, Pd, or Al.

10. The OLED of claim 9, the organometallic complex is a phosphorescent emitter or a blue phosphorescent emitter.

11. The OLED of claim 1, wherein at least one of the materials in the EML, m-EBL, and m-HBL collectively can contain at least one of the following moieties or fused analogues of these moieties:

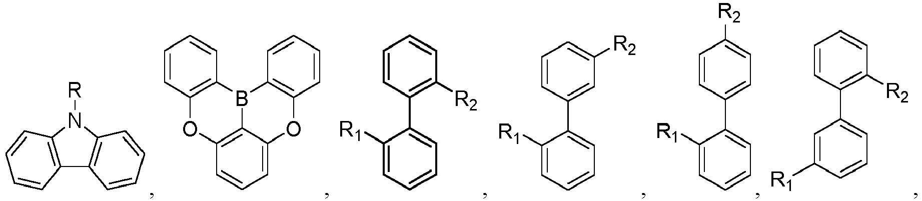

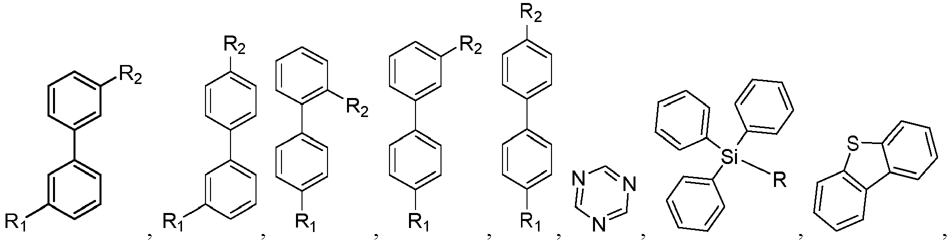

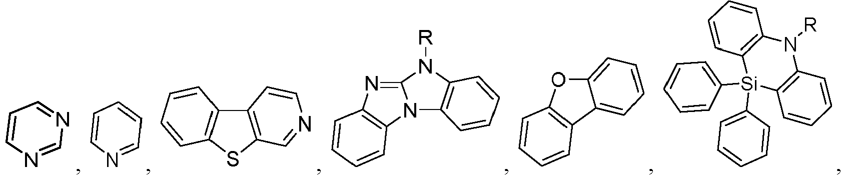

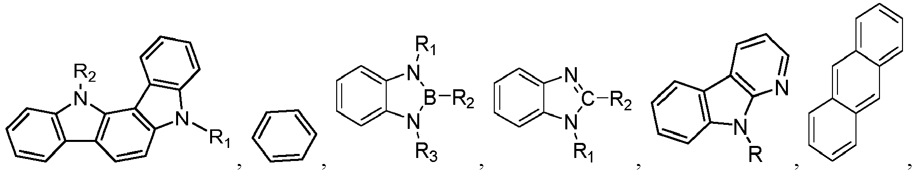

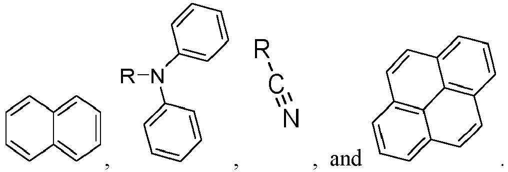

12. The OLED of claim 10, wherein the phosphorescent emitter is selected from the group consisting of: 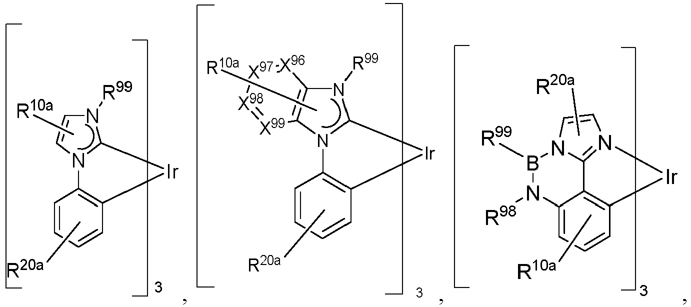 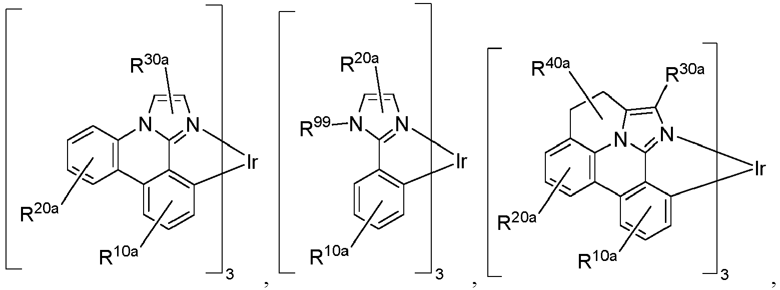 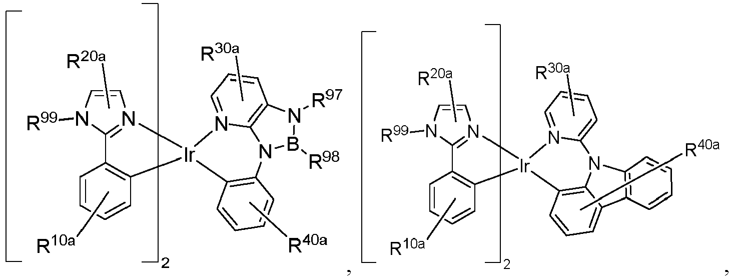 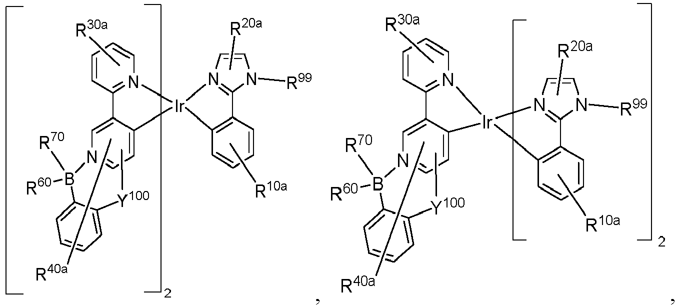 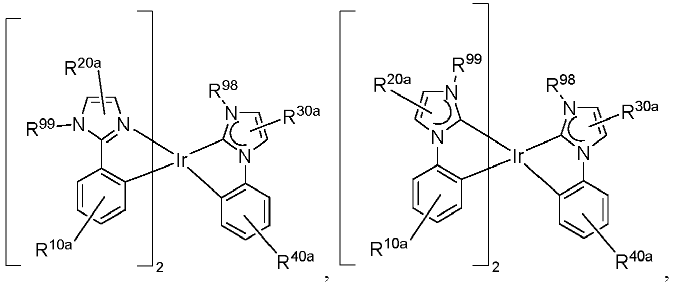 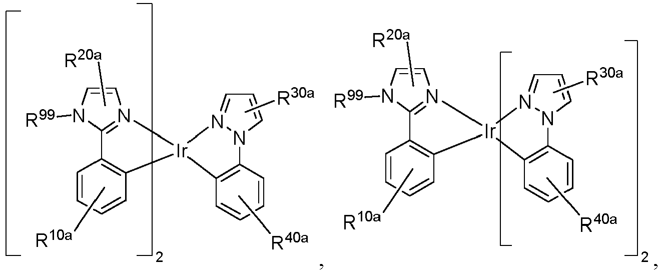 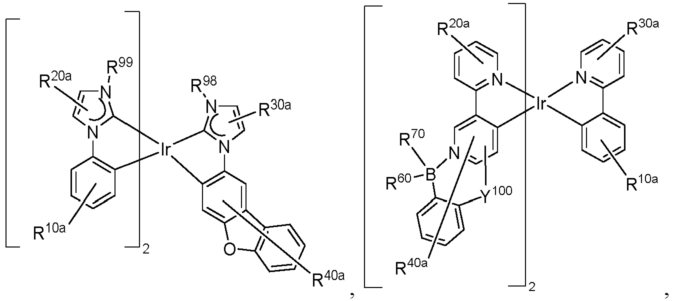 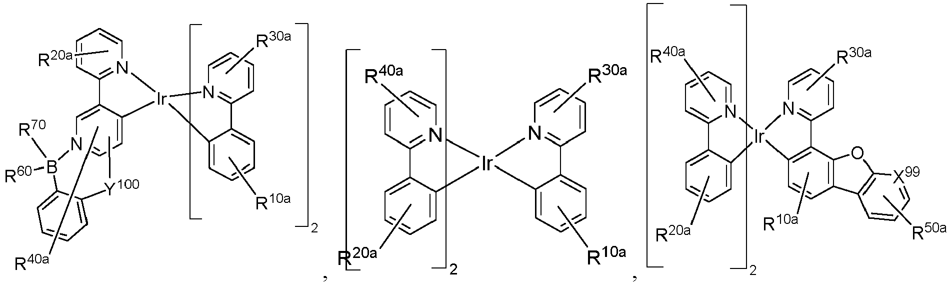 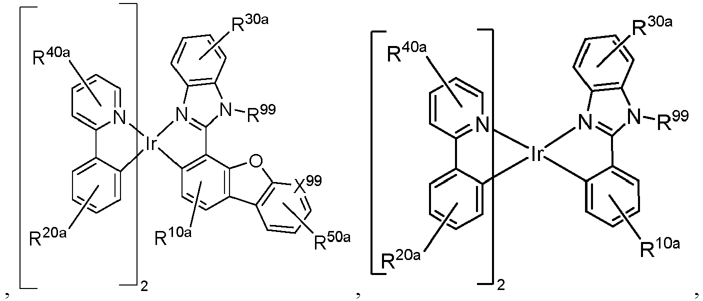 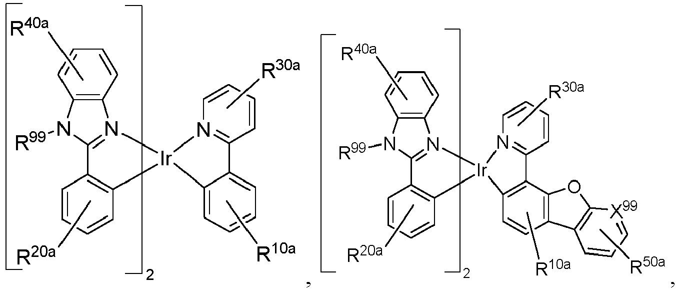 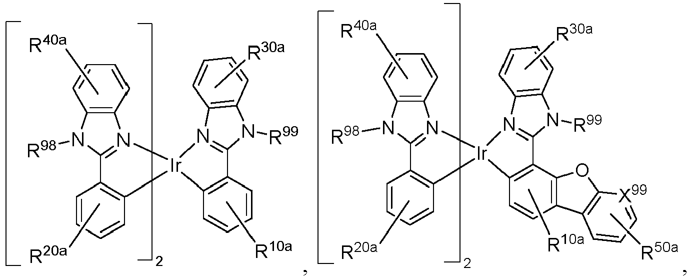 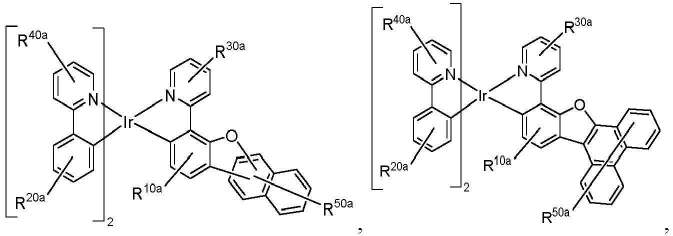 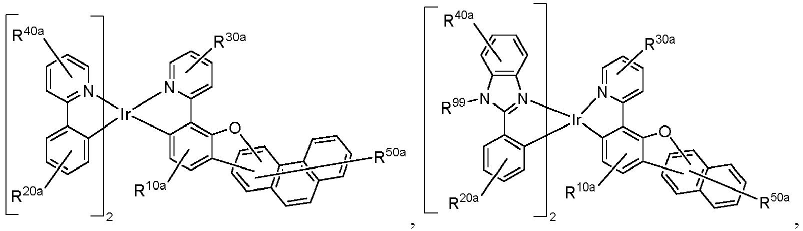 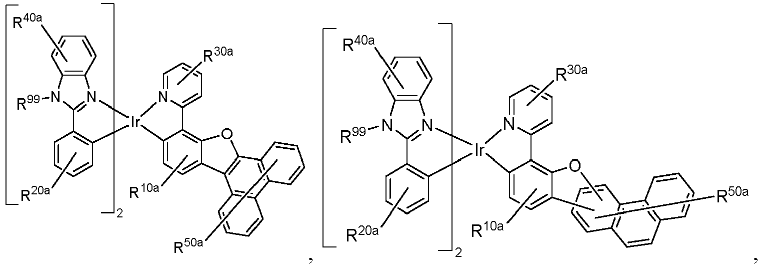 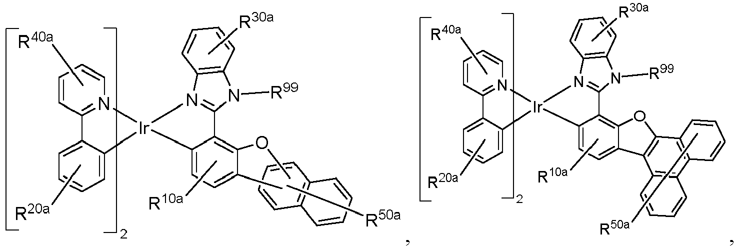 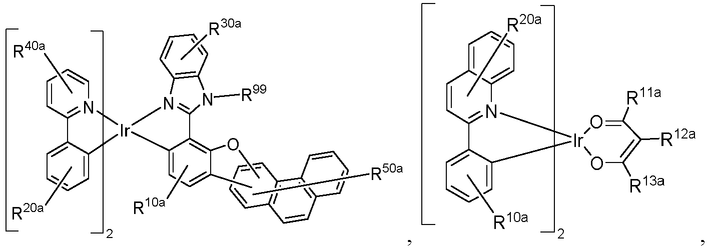 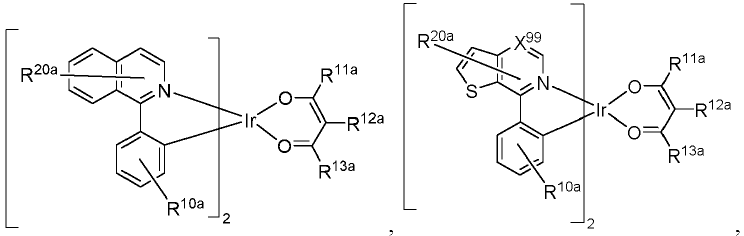 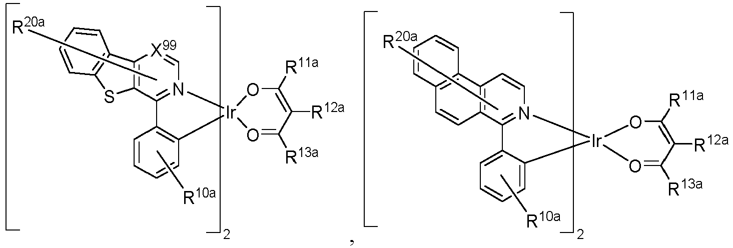 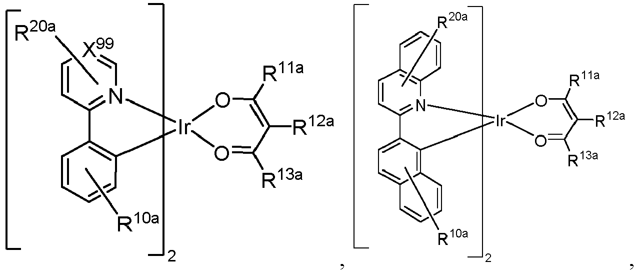 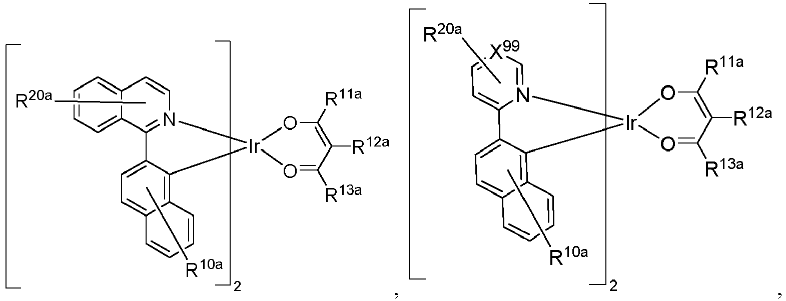 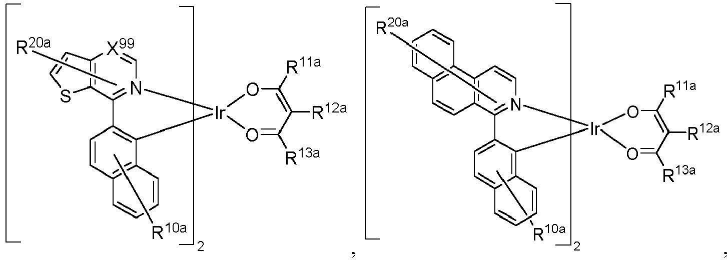 and 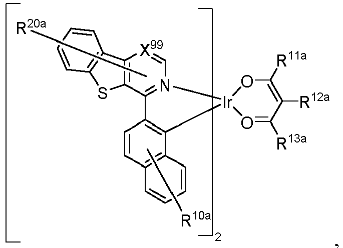 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof; and
two adjacent R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ are optionally joined or fused to form a ring.

13. The OLED of claim 10, wherein the phosphorescent emitter is selected from the group consisting of: 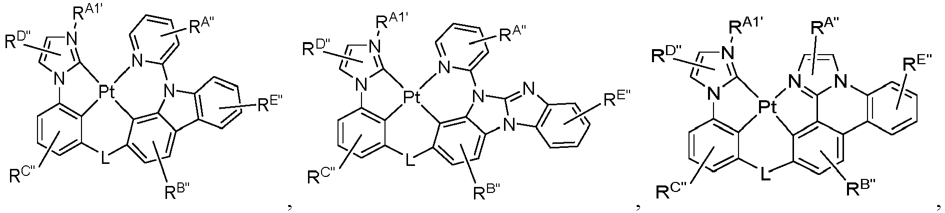 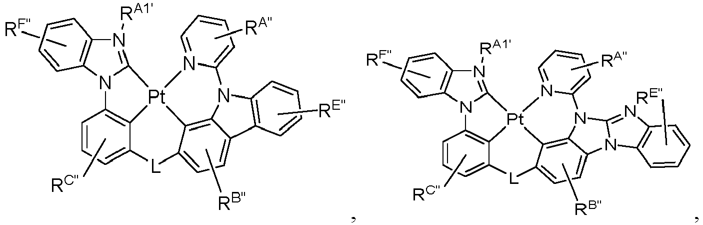 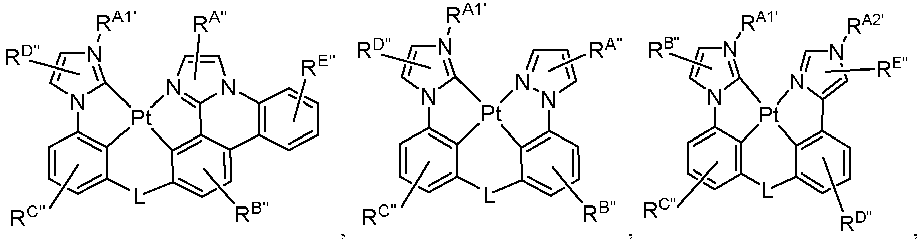 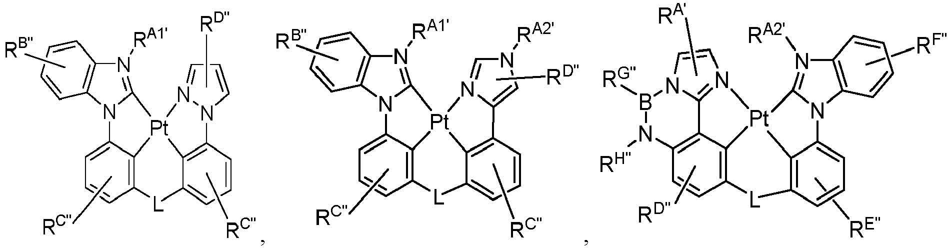 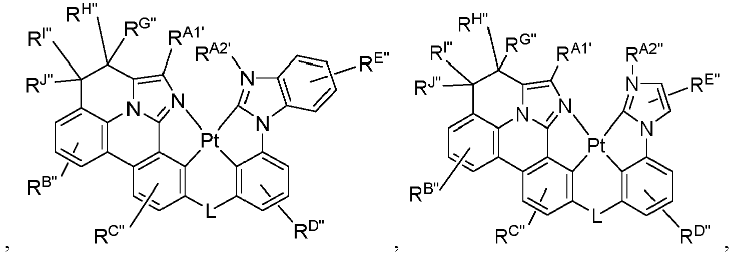 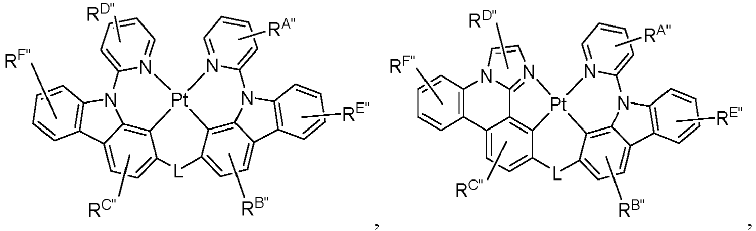 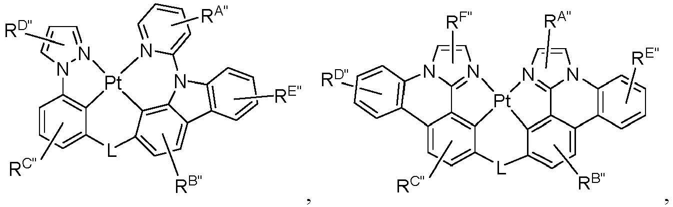 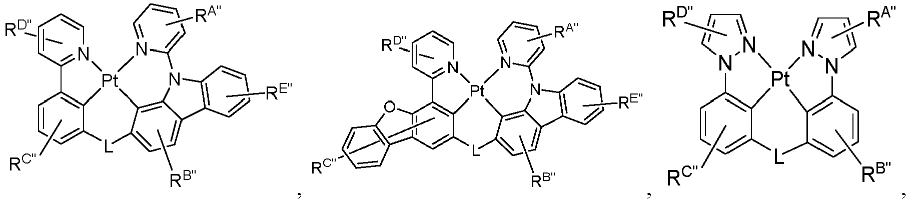 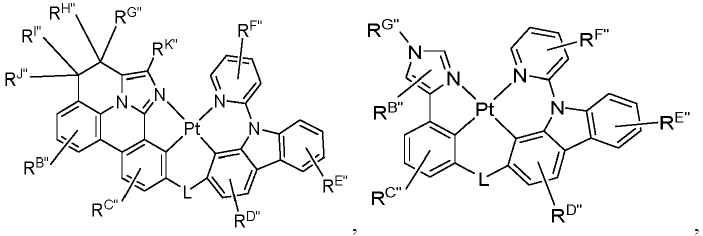 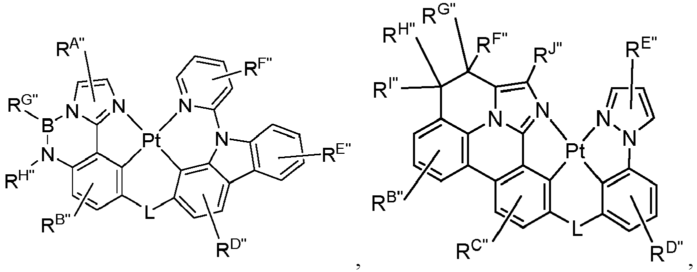 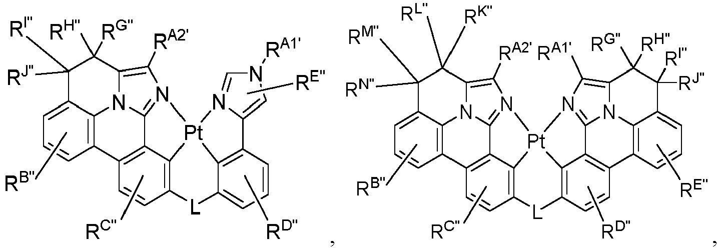 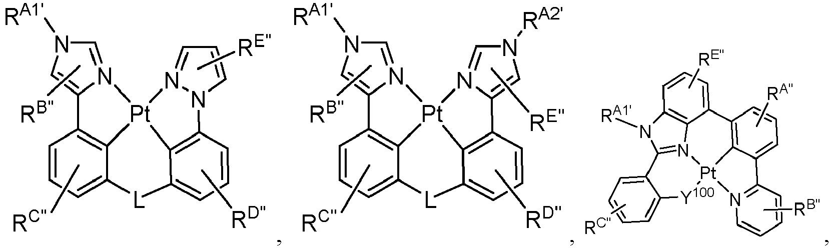 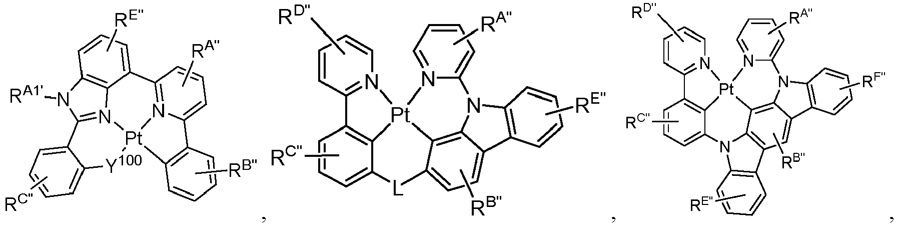 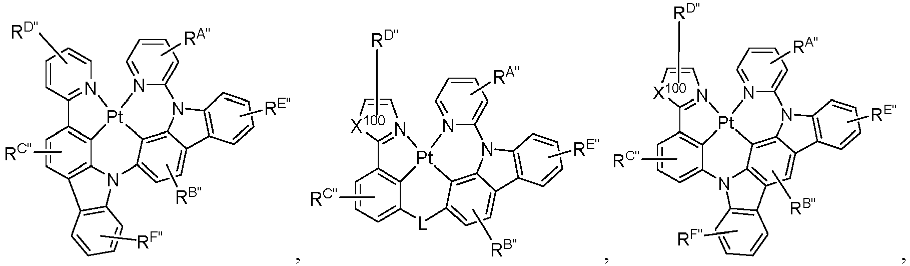 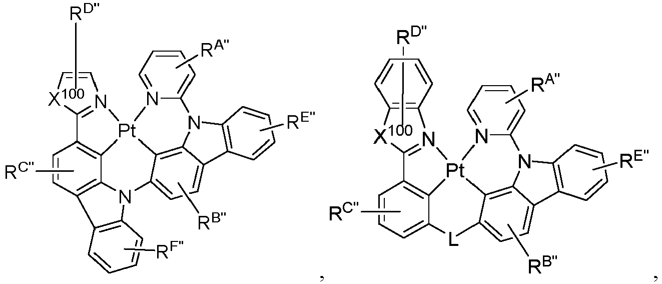 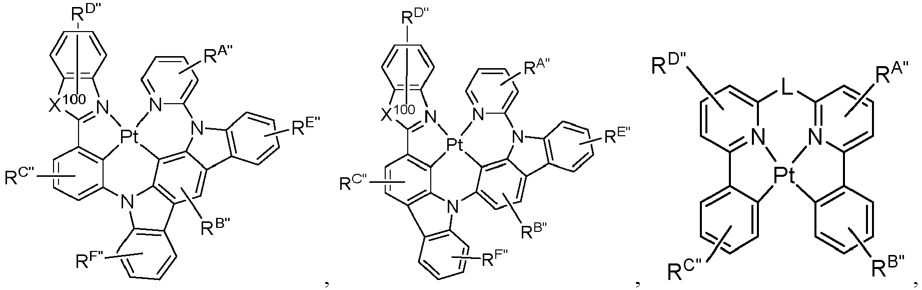 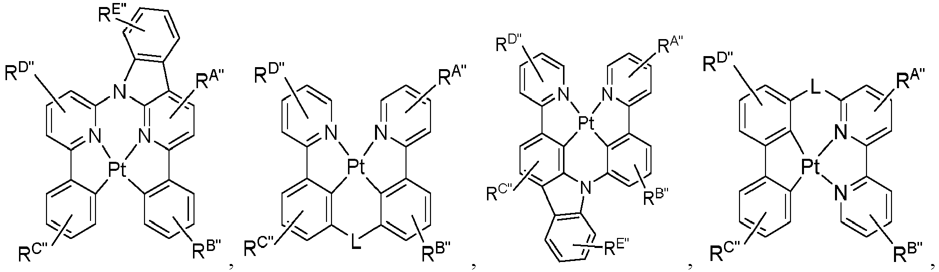 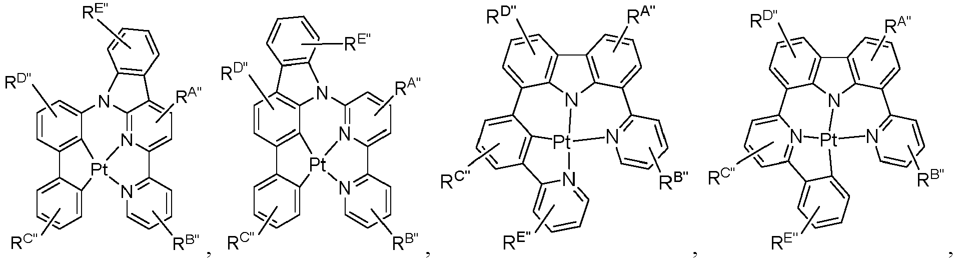 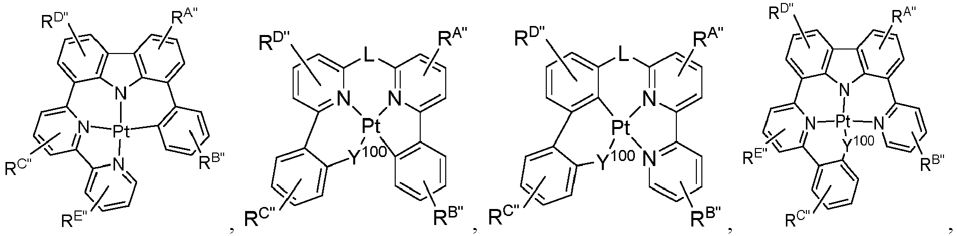 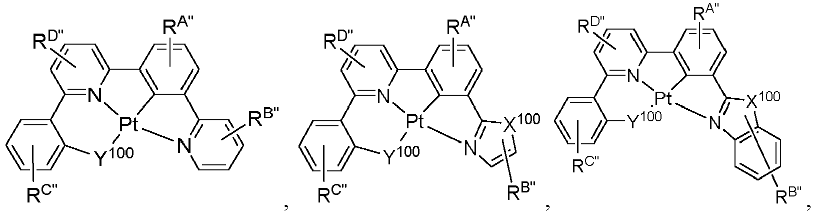 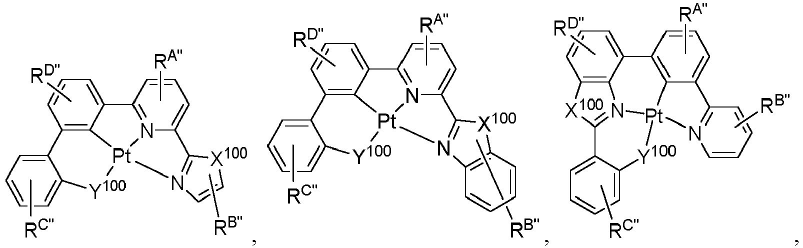 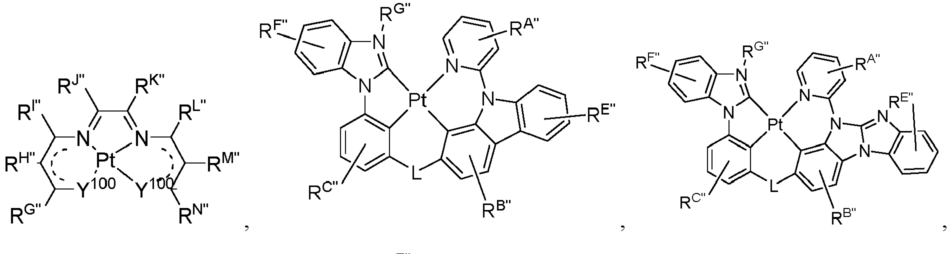 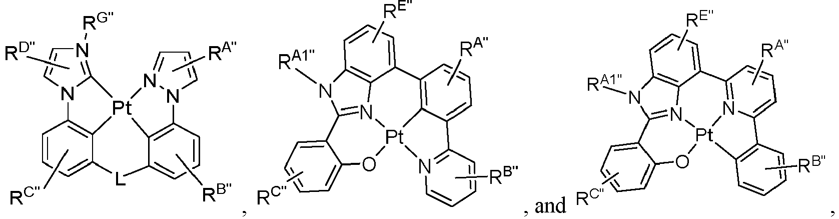 wherein:
each Y¹⁰⁰ is independently selected from the group consisting of a NR", O, S, and Se;
L is independently selected from the group consisting of a direct bond, BR", BR"R"', NR", PR", O, S, Se, C=O, C=S, C=Se, C=NR", C=CR"R"', S=O, SO₂, CR", CR"R"', SiR"R"', GeR"R"', alkyl, cycloalkyl, aryl, heteroaryl, and combinations thereof;
X¹⁰⁰ for each occurrence is selected from the group consisting of O, S, Se, NR", and CR"R‴;
each R^{A"}, R^{B"}, R^{C"}, R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof; and
two adjacent R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} may be optionally joined to form a ring.

14. The OLED of claim 10, wherein the phosphorescent emitter is selected from the group consisting of the following blue phosphorescent emitter materials: 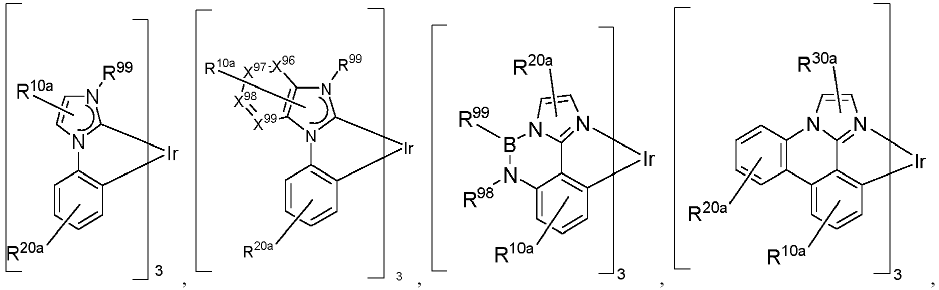 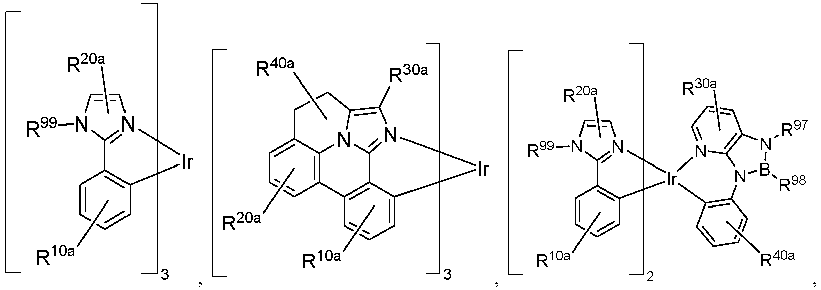 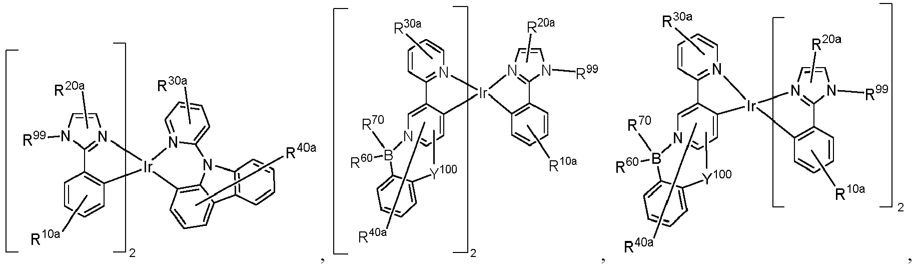 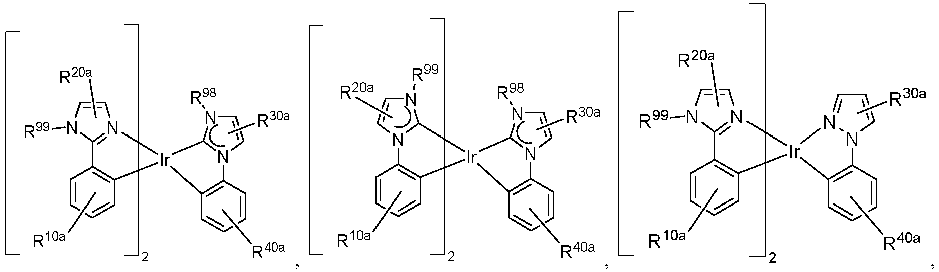 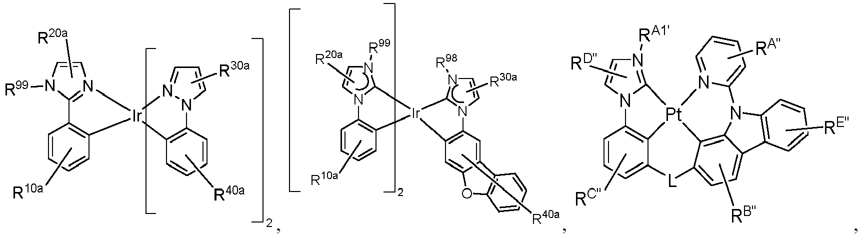 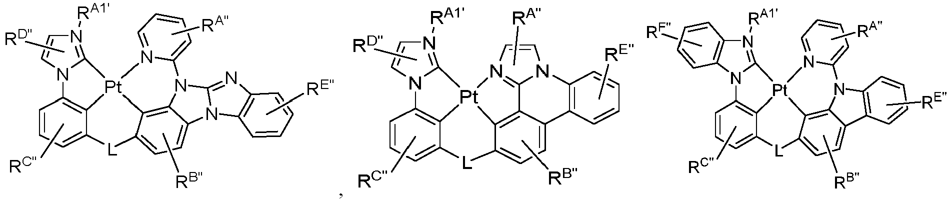 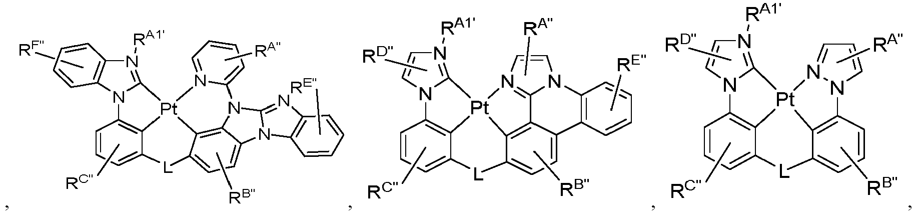 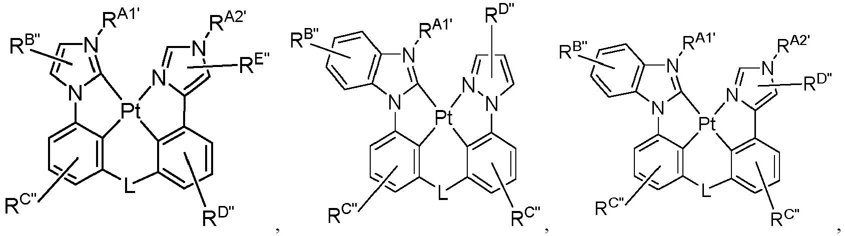 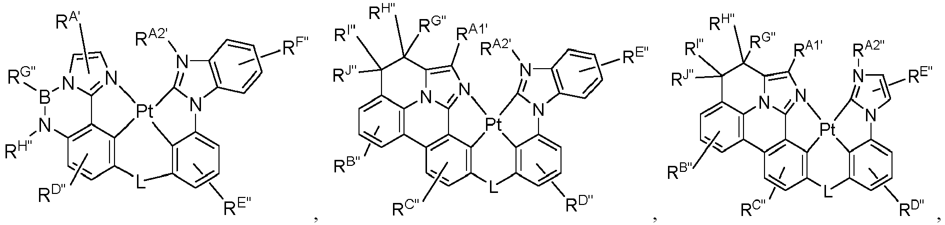 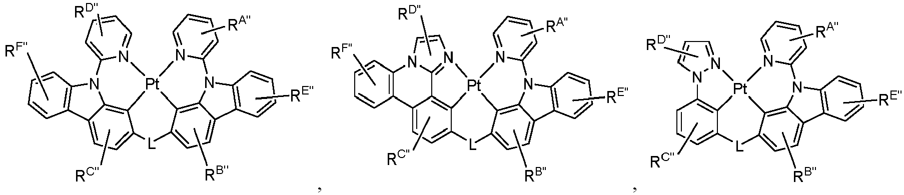 , and

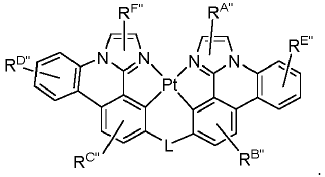

15. A consumer product comprising an OLED according to claim 1, wherein the consumer product is one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

## Patentansprüche

1. Organische lichtemittierende Vorrichtung (OLED, 100) umfassend einen lichtemittierenden Stapel, der umfasst:
eine erste Elektrode (115);
eine zweite Elektrode (160); und
eine erste Schicht (120, 125, 130, 140, 145, 150) und eine emittierende Schicht (EML, 135), die zwischen der ersten Elektrode (115) und der zweiten Elektrode (160) angeordnet sind, wobei die EML drei Hostmaterialien und einen ersten Dotierstoff aus emittierendem Material umfasst, der ein phosphoreszierender Emitter ist;
**dadurch gekennzeichnet, dass** die erste Schicht eine Mehrkomponenten-Elektronensperrschicht (m-EBL, 130) ist, die mindestens zwei Komponenten umfasst, oder eine Mehrkomponenten-Lochsperrschicht (m-HBL, 140), die mindestens zwei Komponenten umfasst,
wobei, wenn die erste Schicht eine m-EBL ist, die erste Schicht an die EML angrenzt und die OLED ferner eine Lochtransportschicht (HTL, 125) und eine Lochinjektionsschicht (HIL, 120) umfasst, die zwischen der ersten Schicht und einer der beiden Elektroden angeordnet sind, die eine Anode oder eine Ladungserzeugungsschicht ist;
wobei, wenn die erste Schicht eine m-HBL ist, die erste Schicht an die EML angrenzt und die OLED weiterhin eine Elektronentransportschicht (ETL, 145) und eine Elektroneninjektionsschicht (EIL, 150) umfasst, die zwischen der ersten Schicht und einer der beiden Elektroden, die eine Kathode oder eine Ladungserzeugungsschicht ist, angeordnet sind.

2. OLED nach Anspruch 1, wobei eine Mindestanzahl von Komponenten in der EML ausgewählt ist aus der Gruppe bestehend aus 4, 5, 6, 7 und 8.

3. OLED nach Anspruch 1, wobei die OLED ferner eine zweite Schicht umfasst; wobei die zweite Schicht so konfiguriert ist, dass sie eine der Schichten aus der folgenden Funktionsschichtgruppe ist: eine Mehrkomponenten-Lochinjektionsschicht (m-HIL), eine Mehrkomponenten-Lochtransportschicht (m-HTL), eine Mehrkomponenten-Elektronensperrschicht (m-EBL), eine Mehrkomponenten-Lochsperrschicht (m-HBL), eine Mehrkomponenten-Elektronentransportschicht (m-ETL) und eine Mehrkomponenten-Elektroneninjektionsschicht (m-EIL);und eine andere Art von Schicht als die erste Schicht ist;
wobei die m-EBL und die m-HBL jeweils mindestens zwei Komponenten umfassen, und die m-HIL, die m-HTL, die m-EIL und die m-ETL jeweils mindestens drei Komponenten umfassen;
wobei, wenn die zweite Schicht eine m-EBL ist, die zweite Schicht an die EML angrenzt und die OLED ferner eine HTL und eine HIL umfasst, die zwischen der zweiten Schicht und einer der beiden Elektroden angeordnet sind, die eine Anode oder eine Ladungserzeugungsschicht ist;
wobei, wenn die zweite Schicht eine m-HBL ist, die zweite Schicht an die EML angrenzt und die OLED ferner eine ETL und eine EIL umfasst, die zwischen der zweiten Schicht und einer der beiden Elektroden, die eine Kathode oder eine Ladungserzeugungsschicht ist, angeordnet sind.

4. OLED nach Anspruch 1, wobei jede Komponente in einer Schicht, die in direktem Kontakt mit dem EML steht, eine um mindestens 0,1 eV höhere T₁-Energie aufweist als irgendeine Komponente in der EML; und/oder wobei die erste Schicht eine m-EBL oder eine m-HBL ist und jede Komponente in der ersten Schicht eine HOMO-Energie innerhalb von 0,4 eV voneinander und/oder eine LUMO-Energie innerhalb von 0,4 eV voneinander aufweist.

5. OLED nach Anspruch 1, wobei die EML einen Emitter, einen Loch transportierenden Host und einen Elektronen transportierenden Host umfasst; oder wobei die EML einen Emitter, einen Loch transportierenden Host und einen Elektronen transportierenden Host sowie einen Host mit breiter Bandlücke umfasst.

6. OLED nach Anspruch 1, wobei die EML einen Akzeptor umfasst, der auch als Emitter, Sensibilisator oder Host fungiert, und/oder die EML einen Akzeptor, einen Sensibilisator, einen Loch transportierenden Host und einen Elektronen transportierenden Host umfasst.

7. OLED nach Anspruch 1, wobei zwei der Komponenten der EML mit Ausnahme des Emitters einen Exziplex bilden; und/oder wobei die m-EBL und die m-HBL jeweils mindestens ein Loch transportierendes Material und mindestens ein Elektronen transportierendes Material umfassen.

8. OLED nach Anspruch 1, wobei die erste Schicht eine m-EBL ist, die mindestens zwei elektronenblockierende Materialien umfasst, oder
die erste Schicht eine m-HBL ist, die mindestens zwei lochblockierende Materialien umfasst.

9. OLED nach Anspruch 1, wobei die EML einen metallorganischen Komplex umfasst, der eines der folgenden Metalle enthält: Ag, Au, Cu, Ir, Rh, Os, Pt, Pd, oder Al.

10. OLED nach Anspruch 9, wobei der metallorganische Komplex ein phosphoreszierender Emitter oder ein blau phosphoreszierender Emitter ist.

11. OLED nach Anspruch 1, wobei mindestens eines der Materialien in der EML, der m-EBL und der m-HBL zusammen mindestens eine der folgenden Gruppen oder fusionierte Analoga dieser Gruppen enthalten kann:

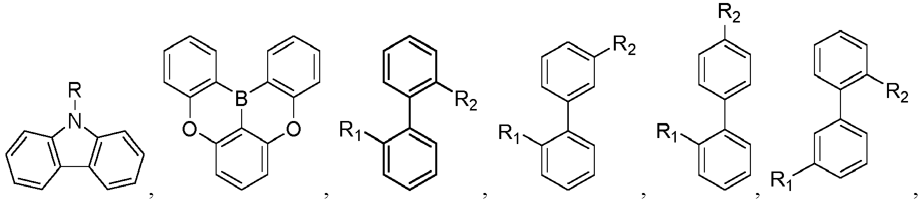

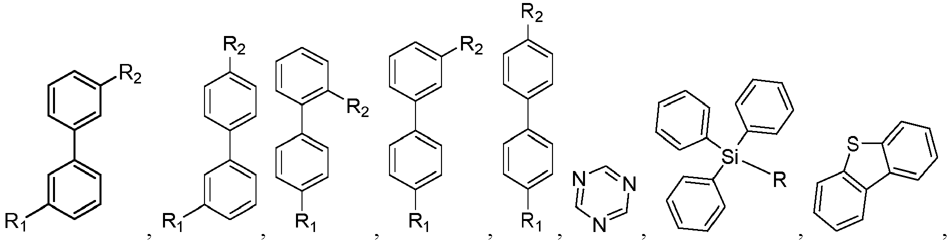

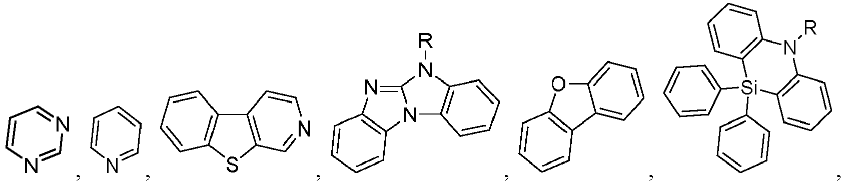

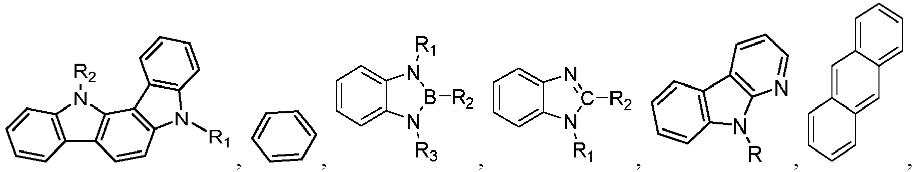

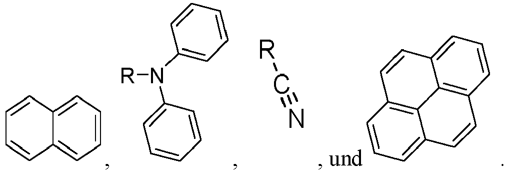

12. OLED nach Anspruch 10, wobei der phosphoreszierende Emitter ausgewählt ist aus der Gruppe bestehend aus: 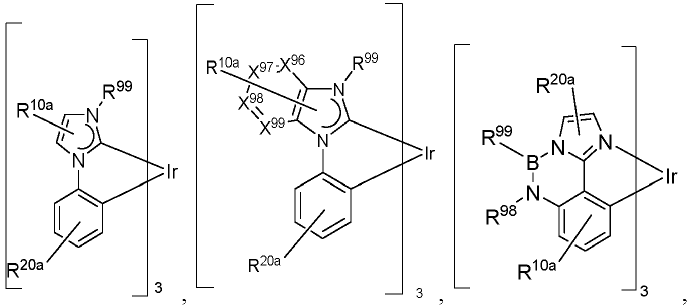 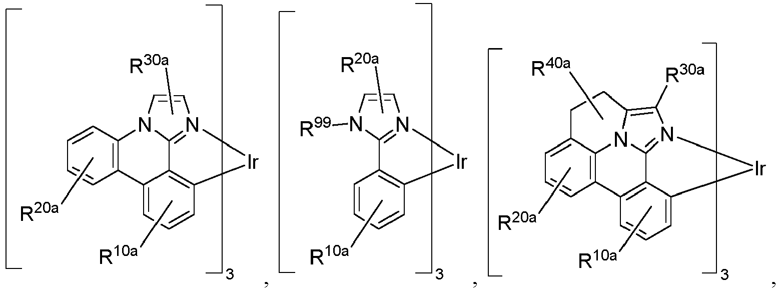 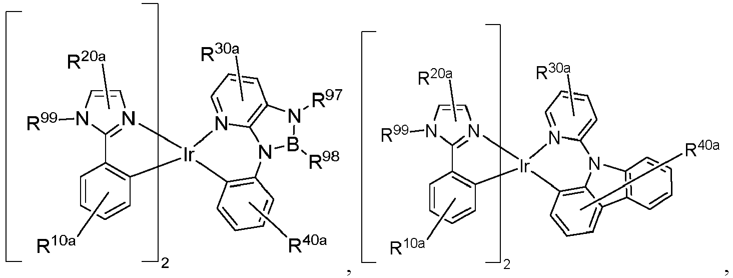 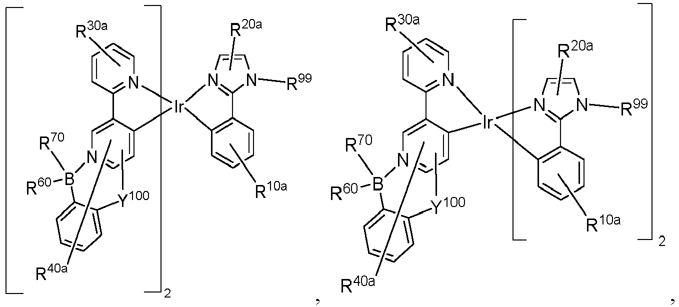 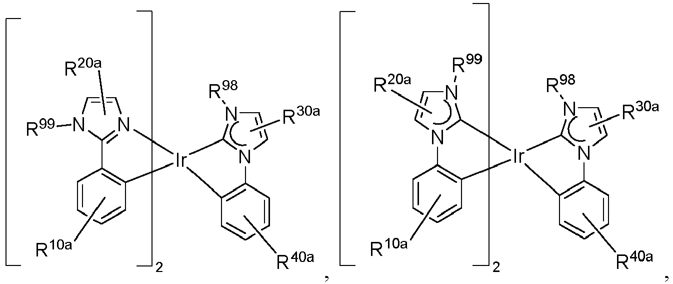 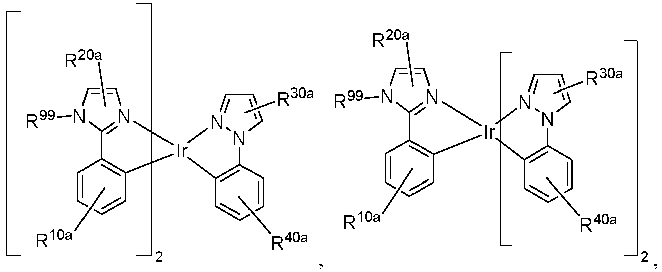 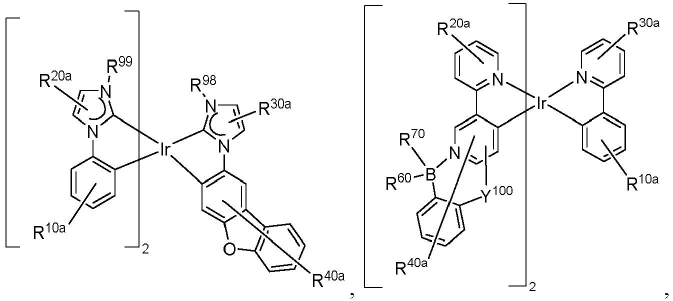 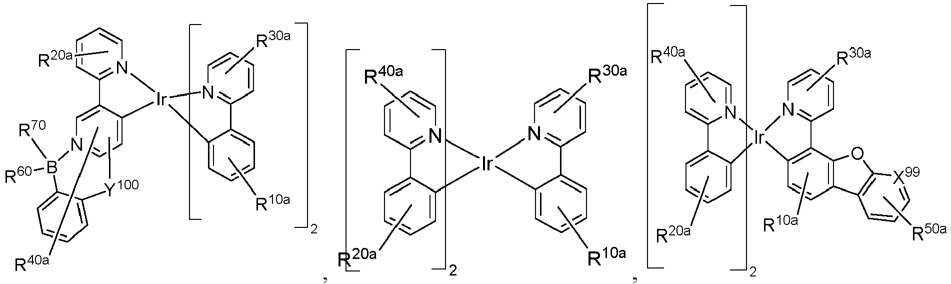 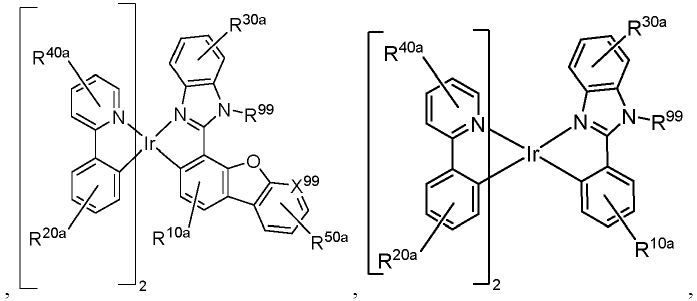 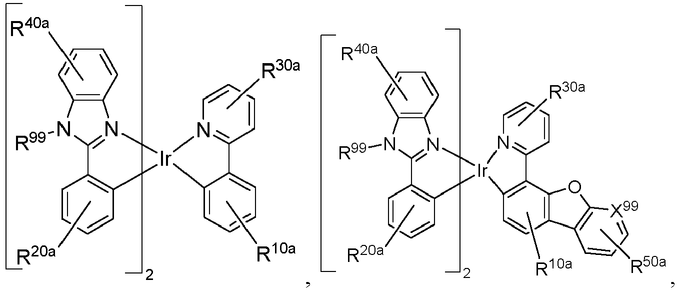 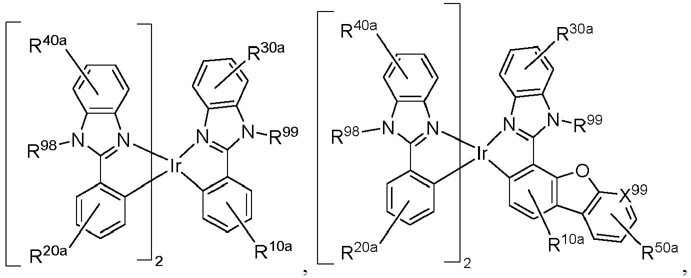 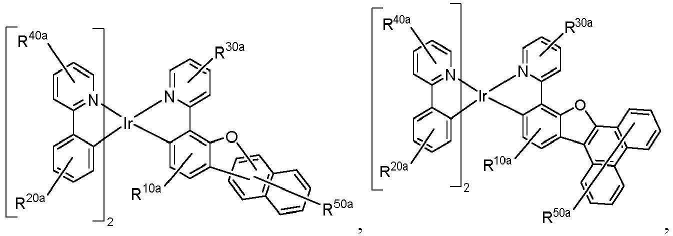 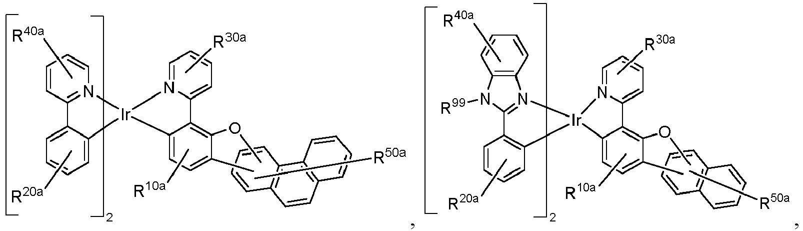 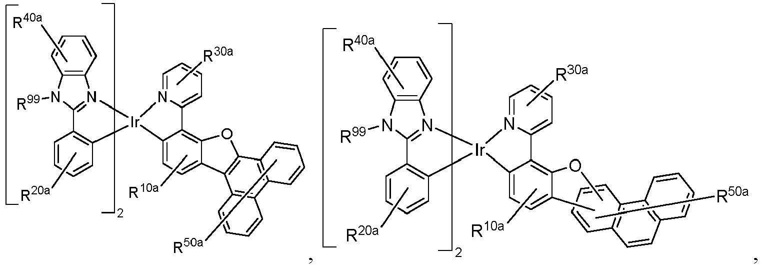 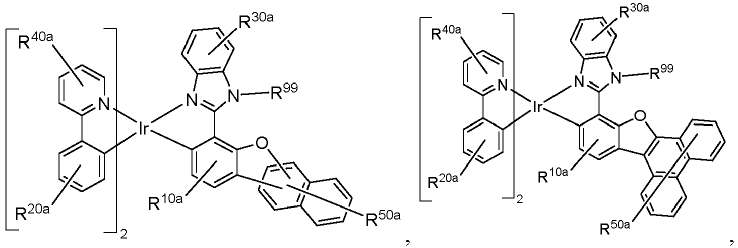 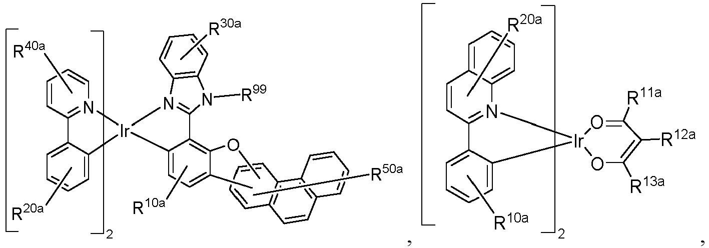 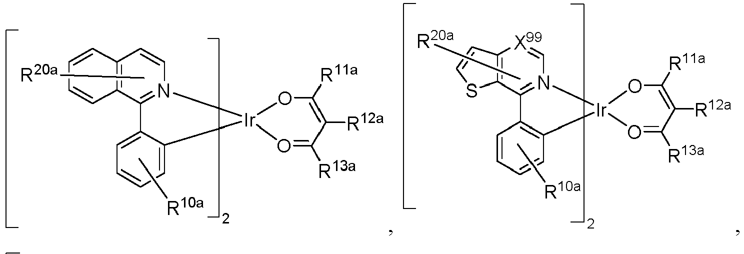 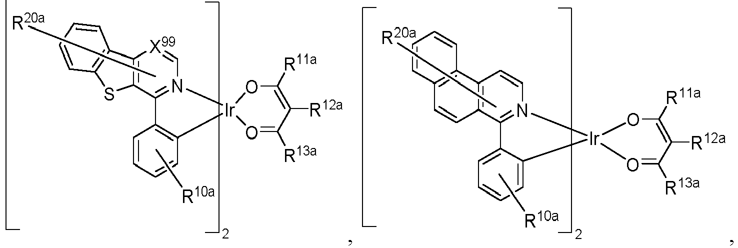 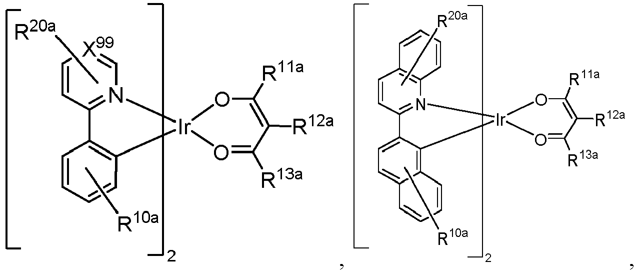 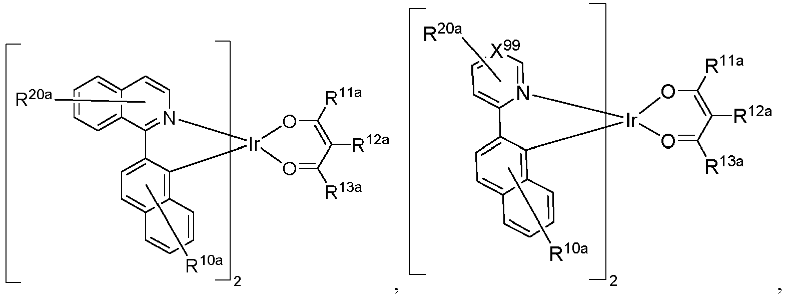 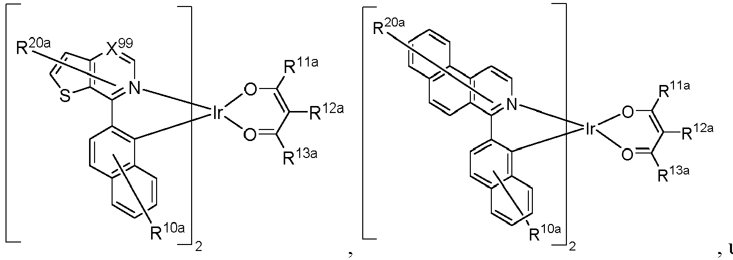 und 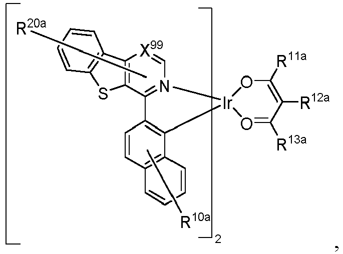 wobei
jedes von X⁹⁶ bis X⁹⁹ unabhängig voneinander C oder N ist;
jedes Y¹⁰⁰ unabhängig ausgewählt ist aus der Gruppe bestehend aus NR", O, S und Se;
jedes R^{10a}, R^{20a}, R^{30a}, R^{40a} und R^{50a} unabhängig eine Monosubstitution, bis zu den maximalen Substitutionen oder keine Substitution darstellt;
jedes von R, R', R", R^{10a}, R^{11a}, R^{12a}, R^{13a}, R^{20a}, R^{30a}, R^{40a}, R^{30a}, R⁶⁰, R⁷⁰, R⁹⁷, R⁹⁸ und R⁹⁹ unabhängig ein Wasserstoff oder ein Substituent ist, ausgewählt aus der Gruppe, bestehend aus Deuterium, Halogenid, Alkyl, Cycloalkyl, Heteroalkyl, Arylalkyl, Alkoxy, Aryloxy, Amino, Silyl, Germyl, Boryl, Selenyl, Alkenyl, Cycloalkenyl, Heteroalkenyl, Alkynyl, Aryl, Heteroaryl, Acyl, Carbonyl, Carbonsäure, Ester, Nitril, Isonitril, Sulfanyl, Sulfinyl, Sulfonyl, Phosphino und Kombinationen davon; und
zwei benachbarte R^{10a}, R^{11a}, R^{12a}, R^{13a}, R^{20a}, R^{30a}, R^{40a}, R^{30a}, R⁶⁰, R⁷⁰, R⁹⁷, R⁹⁸ und R⁹⁹ gegebenenfalls verbunden oder verschmolzen sind, um einen Ring zu bilden.

13. OLED nach Anspruch 10, wobei der phosphoreszierende Emitter ausgewählt ist aus der Gruppe bestehend aus: 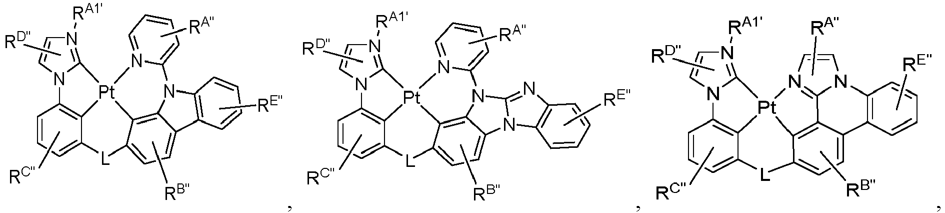 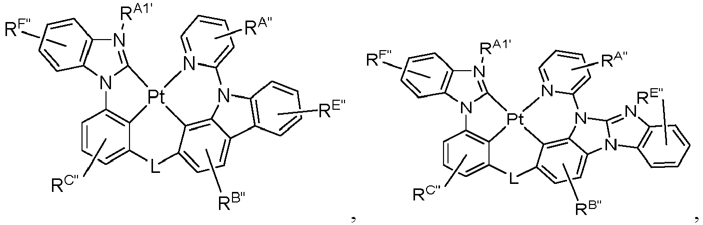 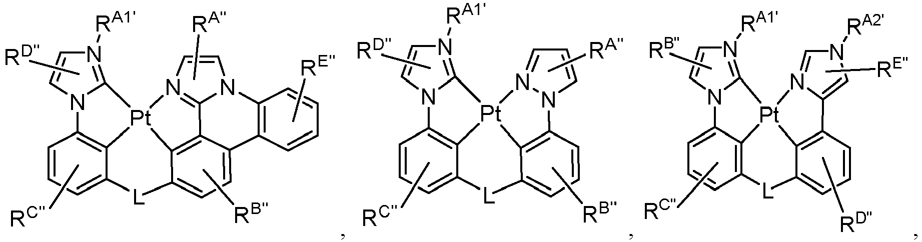 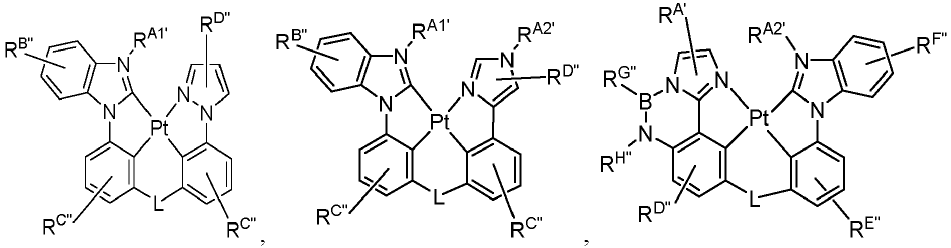 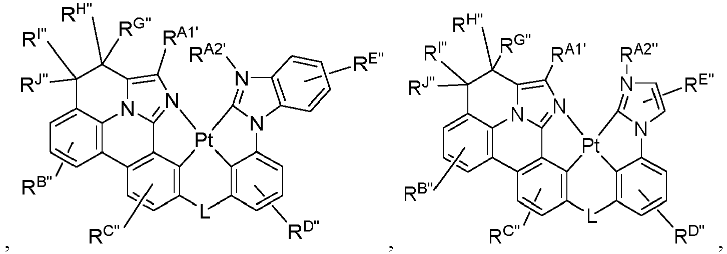 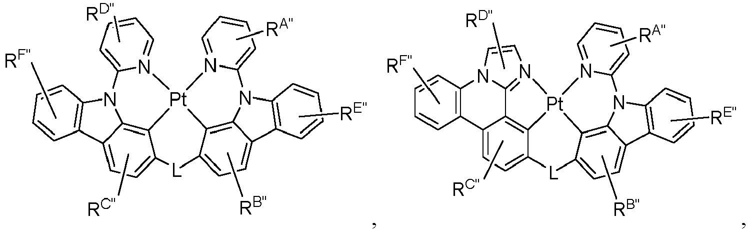 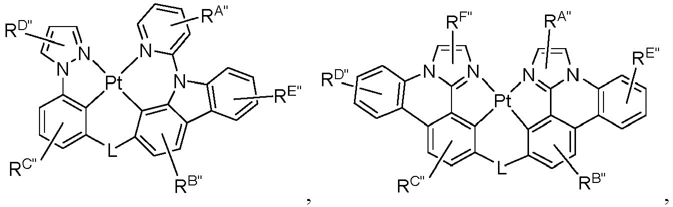 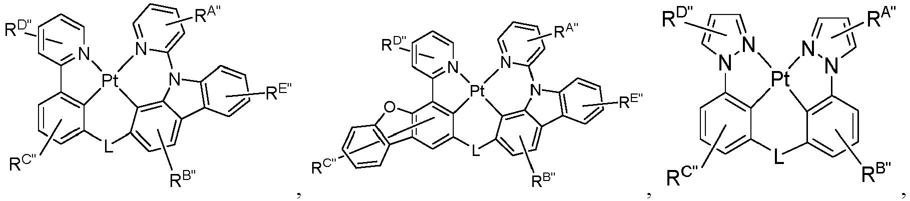 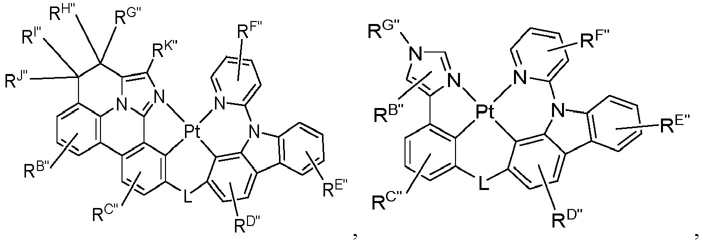 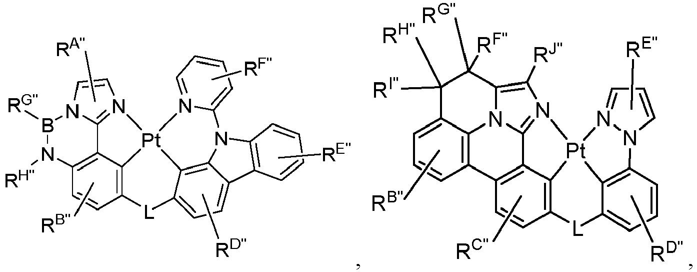 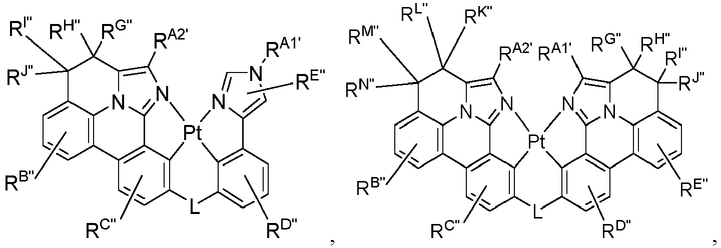 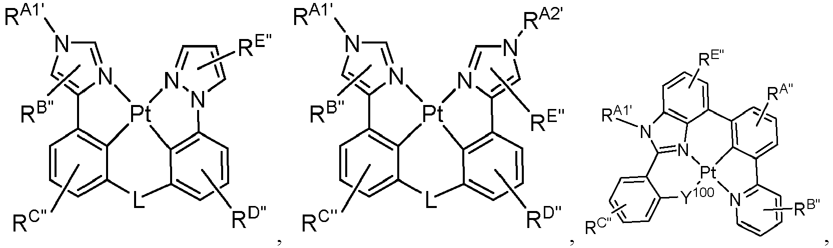 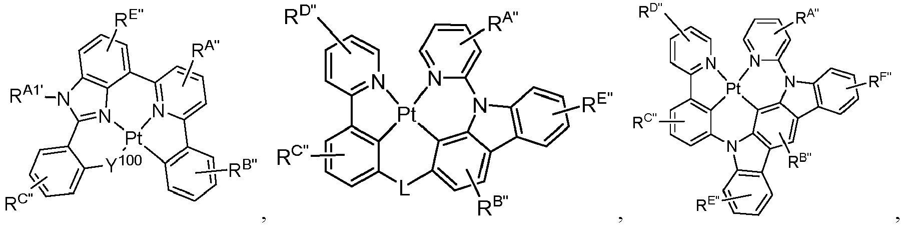 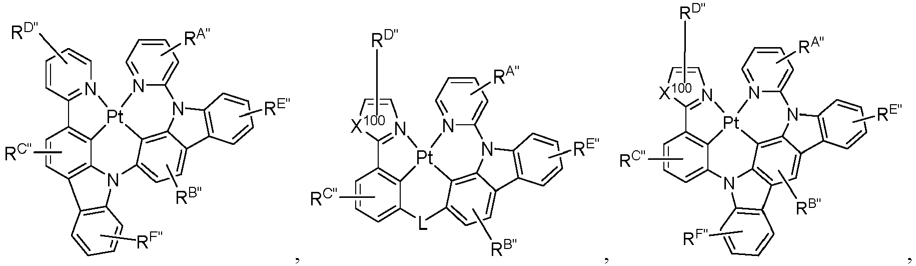 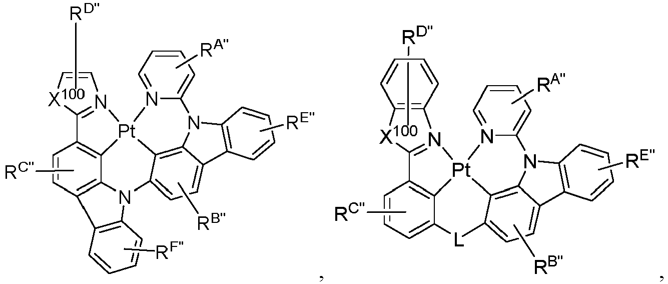 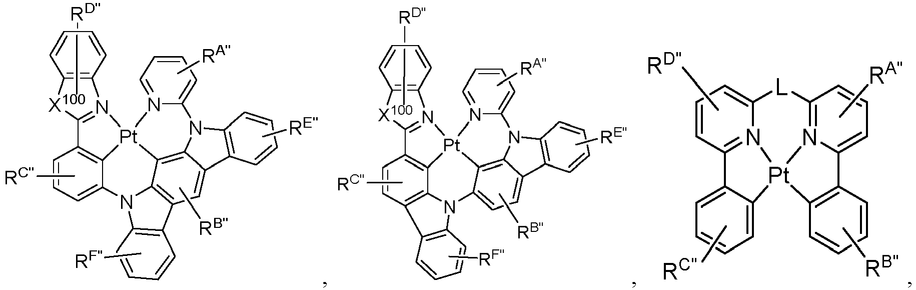 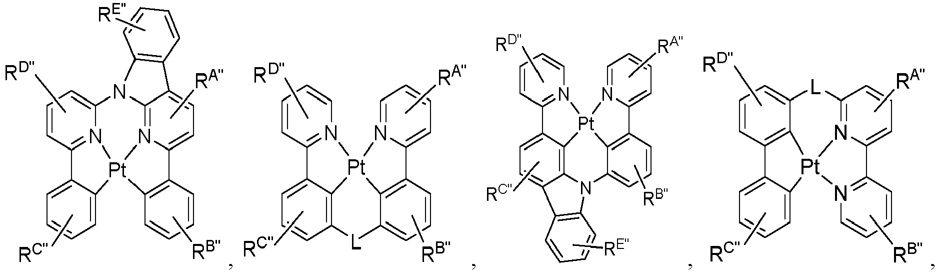 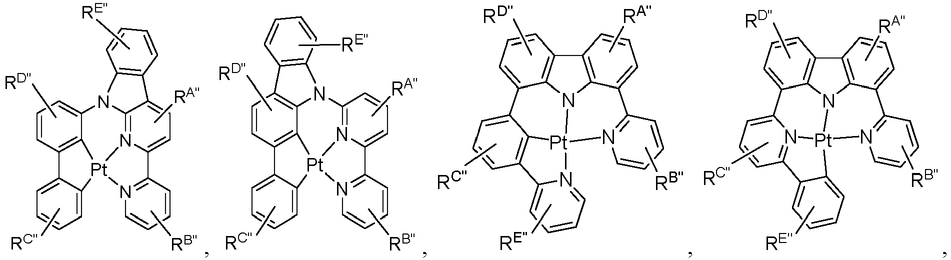 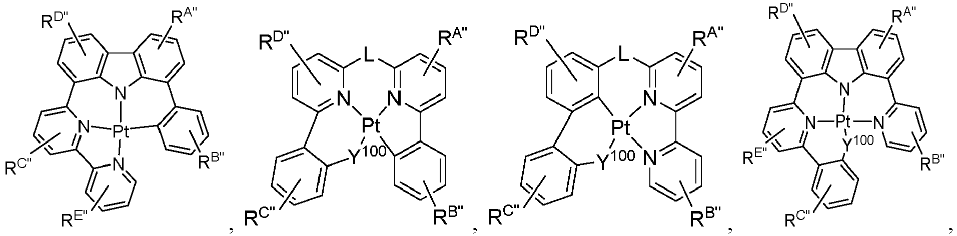 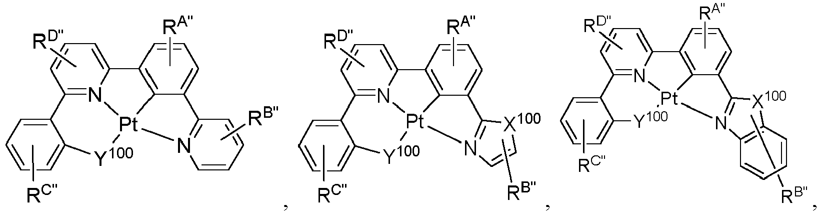 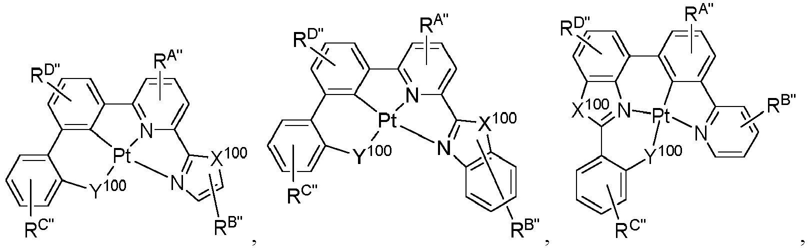 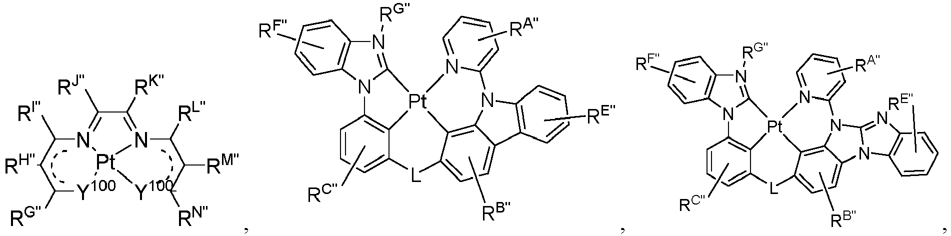 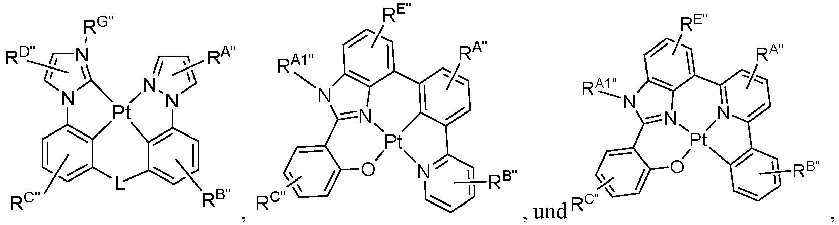 wobei:
jedes Y¹⁰⁰ unabhängig ausgewählt ist aus der Gruppe bestehend aus NR", O, S und Se;
L unabhängig ausgewählt ist aus der Gruppe bestehend aus einer direkten Bindung, BR", BR"R‴, NR", PR", O, S, Se, C=O, C=S, C=Se, C=NR", C=CR"R‴, S=O, SO₂, CR", CR"R‴, SiR"R‴, GeR"R‴, Alkyl, Cycloalkyl, Aryl, Heteroaryl und Kombinationen davon;
X¹⁰⁰ bei jedem Auftreten ausgewählt ist aus der Gruppe bestehend aus O, S, Se, NR" und CR"R‴,
jedes R^{A"}, R^{B"}, R^{C"}, R^{D"}, R^{E"} und R^{F"} unabhängig voneinander eine Monosubstitution, eine Substitution bis zum Maximum oder keine Substitution darstellt;
jedes von R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, und R^{N"} unabhängig ein Wasserstoffatom oder ein Substituent ist, der ausgewählt ist aus der Gruppe bestehend aus Deuterium, Halogenid, Alkyl, Cycloalkyl, Heteroalkyl, Arylalkyl, Alkoxy, Aryloxy, Amino, Silyl, Germyl, Boryl, Selenyl, Alkenyl, Cycloalkenyl, Heteroalkenyl, Alkynyl, Aryl, Heteroaryl, Acyl, Carbonyl, Carbonsäure, Ester, Nitril, Isonitril, Sulfanyl, Sulfinyl, Sulfonyl, Phosphino, Kombinationen davon; und
zwei benachbarte R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"} und R^{N"} können gegebenenfalls miteinander verbunden sein, um einen Ring zu bilden.

14. OLED nach Anspruch 10, wobei der phosphoreszierende Emitter aus der Gruppe ausgewählt ist, die aus den folgenden blau phosphoreszierenden Emittermaterialien besteht:

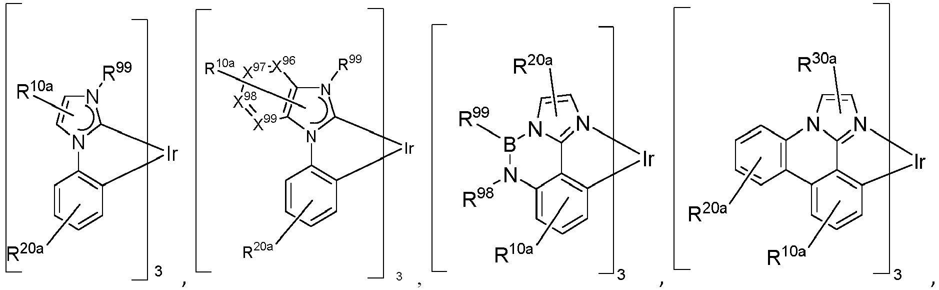

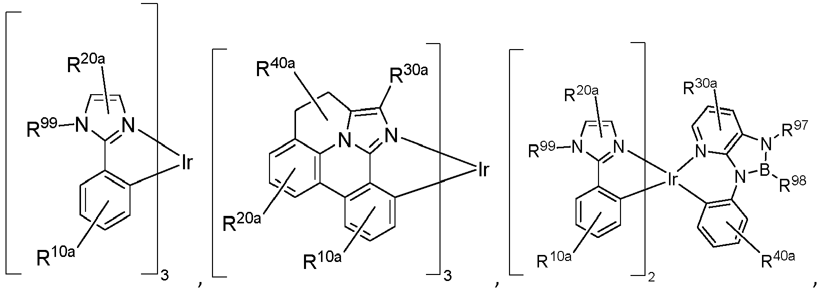

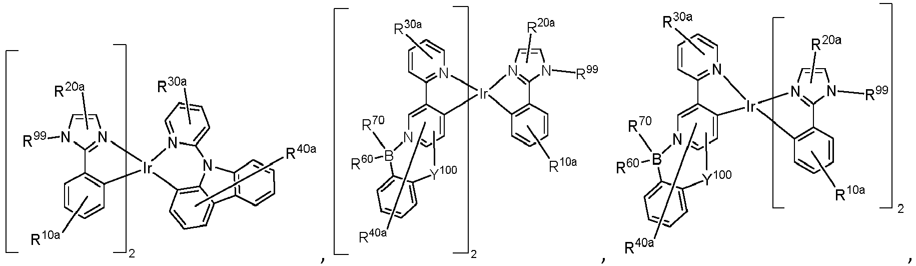

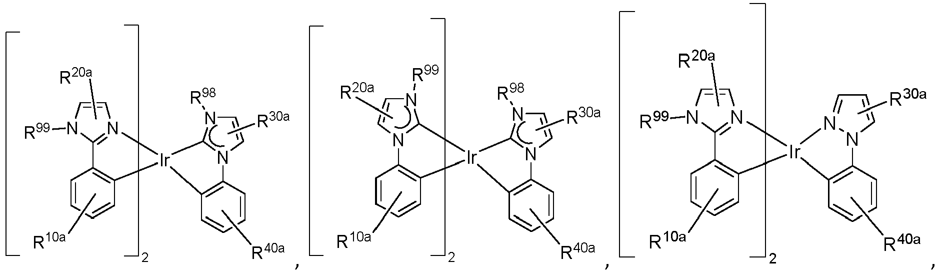

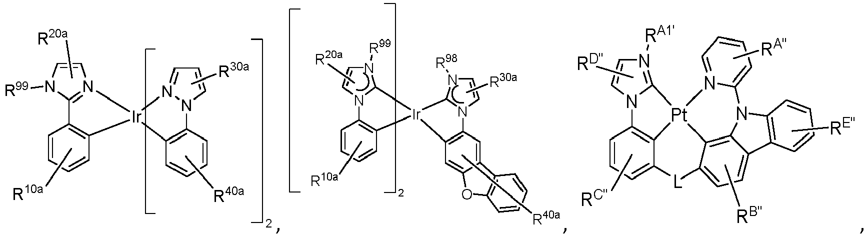

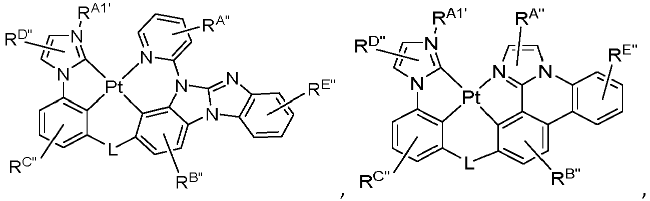

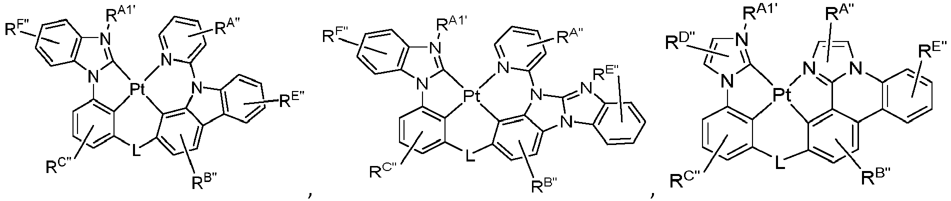

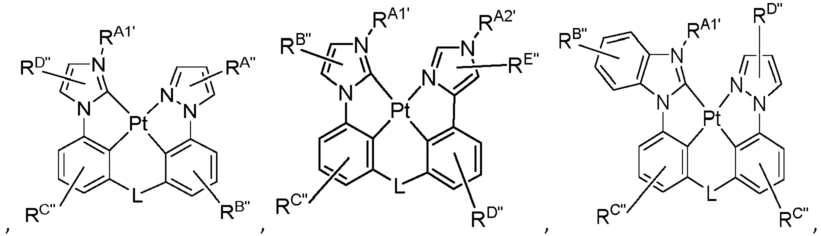

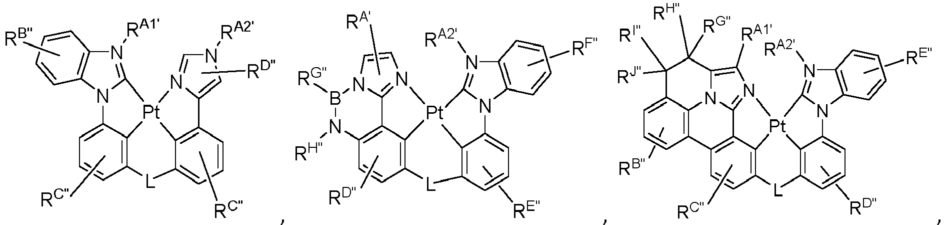

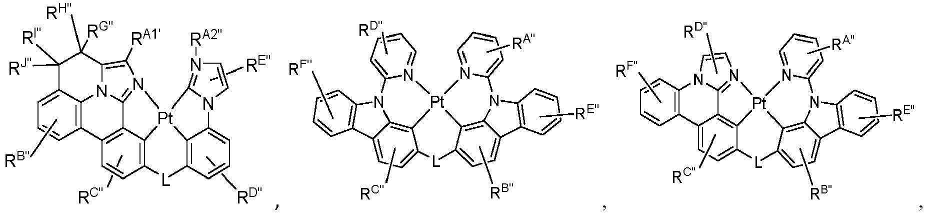

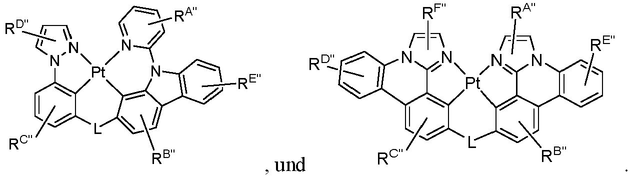

15. Verbraucherprodukt, das eine OLED nach Anspruch 1 umfasst, wobei das Verbraucherprodukt eines der folgenden ist: ein Flachbildschirm, ein Computermonitor, ein medizinischer Monitor, ein Fernseher, eine Werbetafel, eine Leuchte für die Innen- oder Außenbeleuchtung und/oder Signalisierung, ein Heads-up-Display, ein vollständig oder teilweise transparentes Display, ein flexibles Display, ein Laserdrucker, ein Telefon, ein Mobiltelefon, ein Tablet, ein Phablet, ein persönlicher digitaler Assistent (PDA), ein tragbares Gerät, ein Laptop, eine Digitalkamera, ein Camcorder, ein Sucher, ein Mikrodisplay mit einer Diagonale von weniger als 2 Zoll, ein 3D-Display, ein Virtual-Reality- oder Augmented-Reality-Display, ein Fahrzeug, eine Videowand mit mehreren zusammengeschalteten Displays, ein Theater- oder Stadionbildschirm, ein Lichttherapiegerät und ein Schild.

## Revendications

1. Diode électroluminescente organique (OLED, 100) comportant un empilement électroluminescent qui comporte :
une première électrode (115),
une seconde électrode (160), et
une première couche (120, 125, 130, 140, 145, 150) et une couche d'émission (EML, 135) disposée entre la première électrode (115) et la seconde électrode (160), l'EML comportant trois matériaux hôtes et un premier dopant de matériau d'émission qui est un émetteur phosphorescent ; **caractérisée en ce que** la première couche est une couche de blocage d'électrons à plusieurs composants (m-EBL, 130) comportant au moins deux composants ou une couche de blocage de trous à plusieurs composants (m-HBL, 140) comportant au moins deux composants,
dans laquelle lorsque la première couche est une m-EBL, la première couche est adjacente à l'EML et l'OLED comporte en outre une couche de transport de trous (HTL, 125) et une couche d'injection de trous (HIL, 120) disposées entre la première couche et l'une des deux électrodes qui est une anode ou une couche de génération de charges,
dans laquelle lorsque la première couche est une m-HBL, la première couche est adjacente à l'EML et l'OLED comporte en outre une couche de transport d'électrons (ETL, 145) et une couche d'injection d'électrons (EIL, 150) disposées entre la première couche et l'une des deux électrodes qui est une cathode ou une couche de génération de charges.

2. OLED selon la revendication 1, dans laquelle un nombre minimal de composants dans l'EML est choisi parmi le groupe constitué de 4, 5, 6, 7 et 8.

3. OLED selon la revendication 1, dans laquelle l'OLED comporte en outre une seconde couche, dans laquelle la seconde couche est configurée pour être l'une des couches parmi le groupe de couches fonctionnelles suivant : une couche d'injection de trous à composants multiples (m-HIL), une couche de transport de trous à composants multiples (m-HTL), une couche de blocage d'électrons à composants multiples (m-EBL), une couche de blocage de trous à composants multiples (m-HBL), une couche de transport d'électrons à composants multiples (m-ETL) et une couche d'injection d'électrons à composants multiplies (m-EIL), et est un type de couche différent de la première couche,
dans laquelle les m-EBL et m-HBL comportent chacune au moins deux composants, et les m-HIL, m-HTL, m-EIL et m-ETL comportent chacune au moins trois composants,
dans laquelle lorsque la seconde couche est une m-EBL, la seconde couche est adjacente à l'EML et l'OLED comporte en outre une HTL et une HIL disposées entre la seconde couche et l'une des deux électrodes qui est une anode ou une couche de génération de charges,
dans laquelle lorsque la seconde couche est une m-HBL, la seconde couche est adjacente à l'EML et l'OLED comporte en outre une ETL et une EIL disposées entre la seconde couche et l'une des deux électrodes qui est une cathode ou une couche de génération de charges.

4. OLED selon la revendication 1, dans laquelle chaque composant dans une couche en contact direct avec l'EML a une énergie T₁ supérieure d'au moins 0,1 eV à tout composant dans l'EML ; et/ou dans laquelle la première couche est une m-EBL ou une m-HBL et chaque composant dans la première couche a une énergie HOMO dans les limites de 0,4 eV de chaque autre composant et/ou une énergie LUMO dans les limites de 0,4 eV de chaque autre composant.

5. OLED selon la revendication 1, dans laquelle l'EML comporte un émetteur, un hôte de transport de trous et un hôte de transport d'électrons ; ou dans laquelle l'EML comporte un émetteur, un hôte de transport de trous et un hôte de transport d'électrons et un hôte à large écart de bande.

6. OLED selon la revendication 1, dans laquelle l'EML comporte un accepteur qui fonctionne également comme un émetteur, un sensibilisateur ou un hôte, et/ou l'EML comporte un accepteur, un sensibilisateur, un hôte de transport de trous et un hôte de transport d'électrons.

7. OLED selon la revendication 1, dans laquelle deux des composants de l'EML autres que l'émetteur forment un exciplexe, et/ou dans laquelle les m-EBL et m-HBL comportent chacune au moins un matériau de transport de trous et au moins un matériau de transport d'électrons.

8. OLED selon la revendication 1, dans laquelle la première couche est une m-EBL comportant au moins deux matériaux de blocage d'électrons, ou
la première couche est une m-HBL comportant au moins deux matériaux de blocage de trous.

9. OLED selon la revendication 1, dans laquelle l'EML comporte un complexe organométallique qui contient l'un des métaux suivants : Ag, Au, Cu, Ir, Rh, Os, Pt, Pd ou Al.

10. OLED selon la revendication 9, dans laquelle le complexe organométallique est un émetteur phosphorescent ou un émetteur phosphorescent bleu.

11. OLED selon la revendication 1, dans laquelle au moins un des matériaux dans les EML, m-EBL et m-HBL peut collectivement contenir au moins l'un des groupements suivants ou des analogues fusionnés de ces groupements : 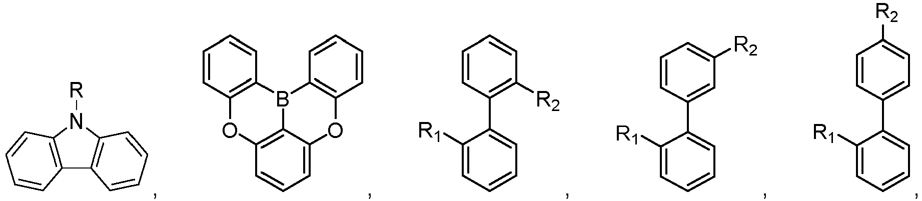 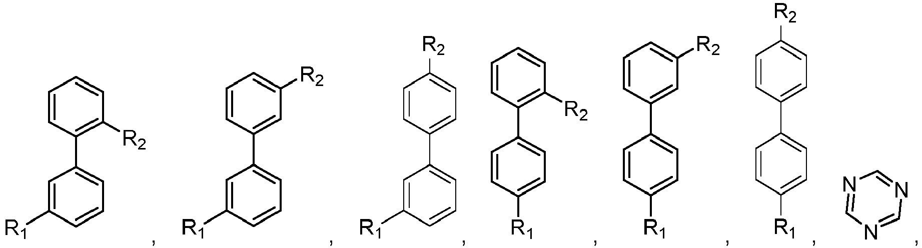 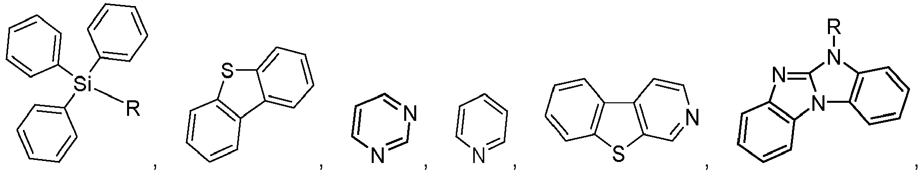 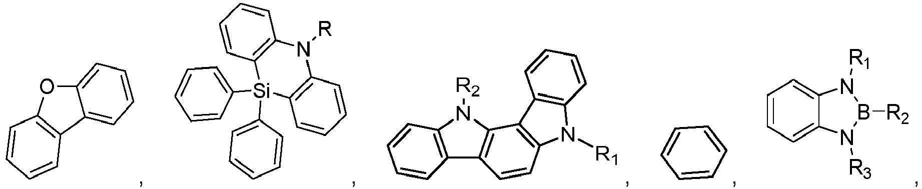 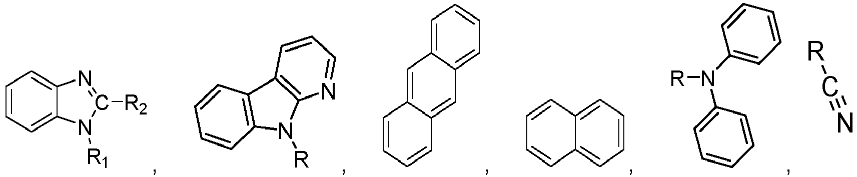 et

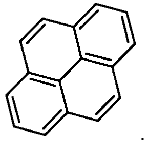

12. OLED selon la revendication 10, dans laquelle l'émetteur phosphorescent est choisi parmi le groupe constitué de : 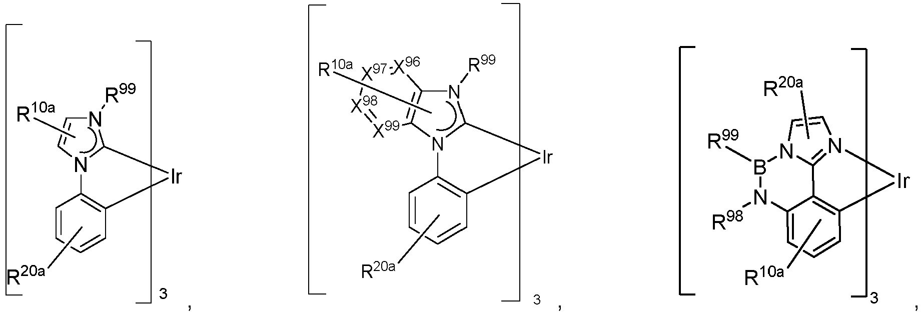 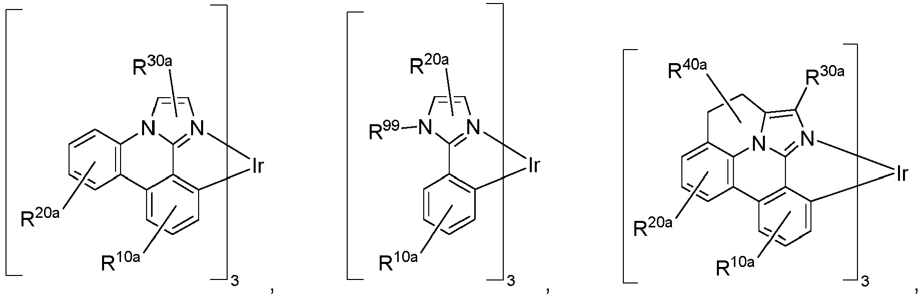 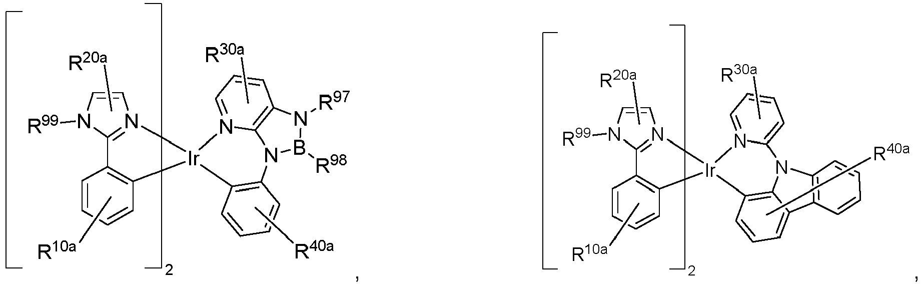 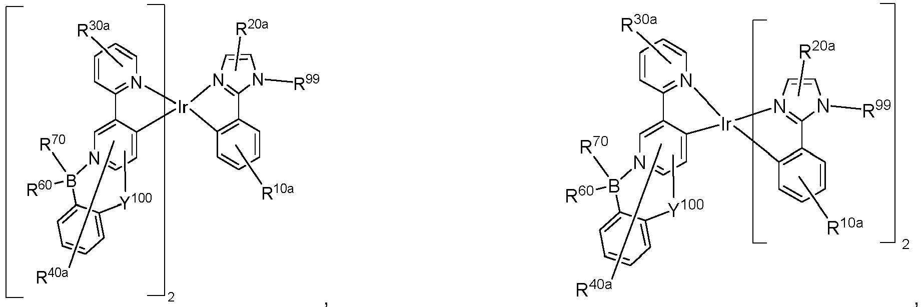 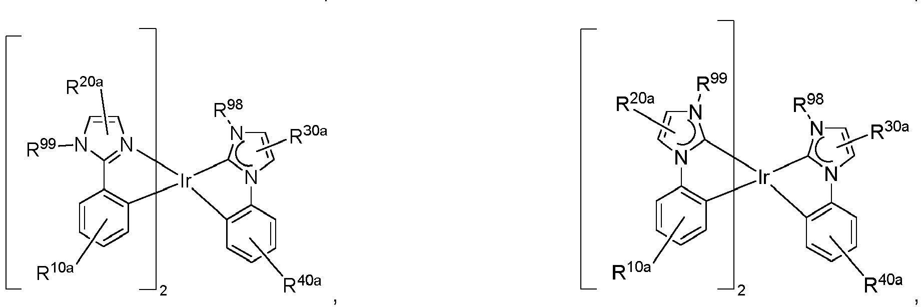 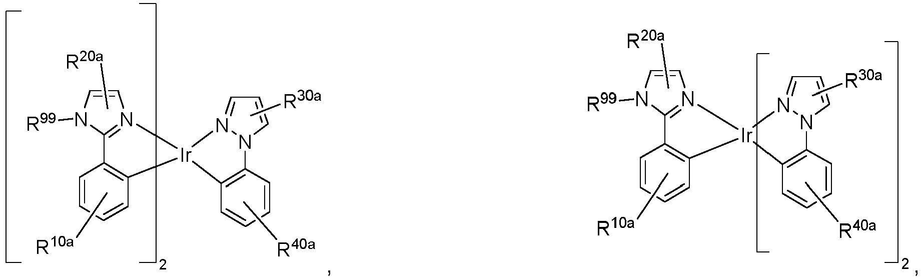 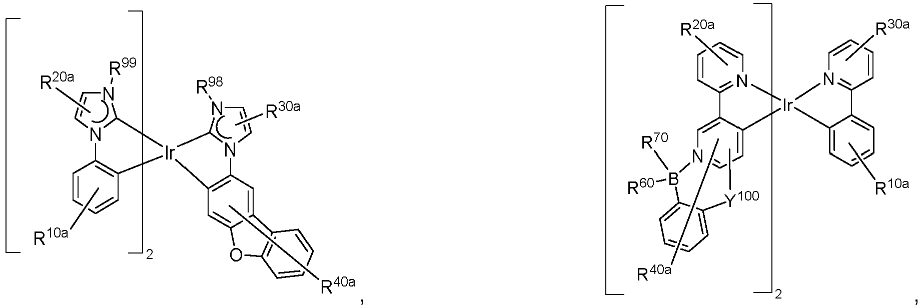 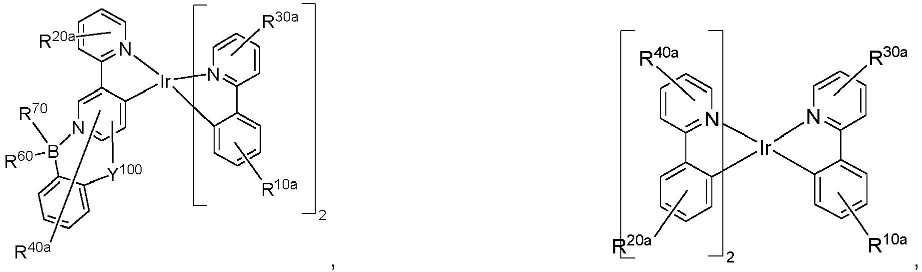 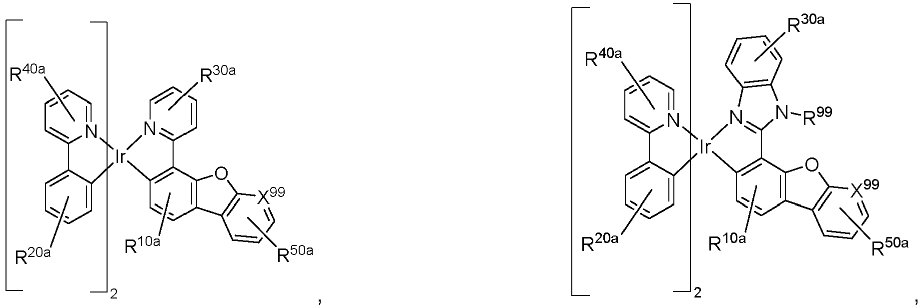 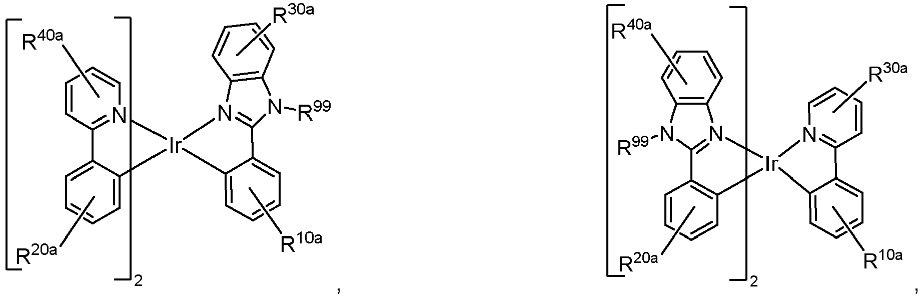 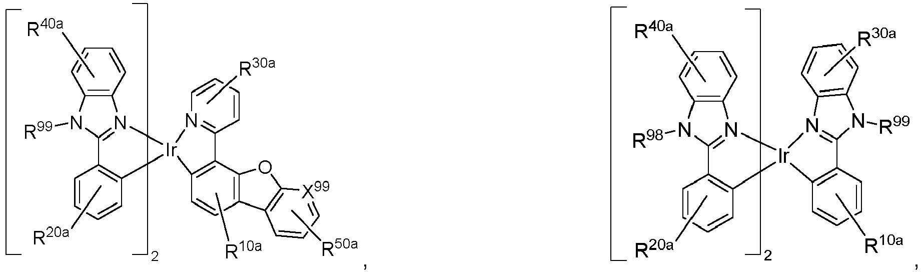 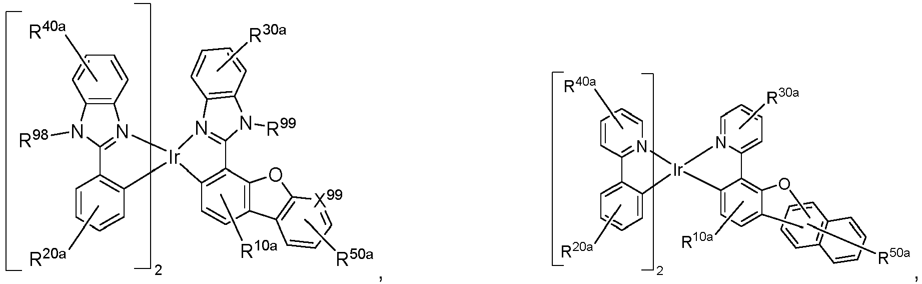 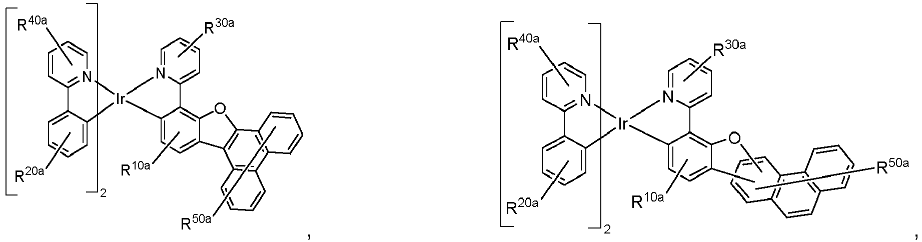 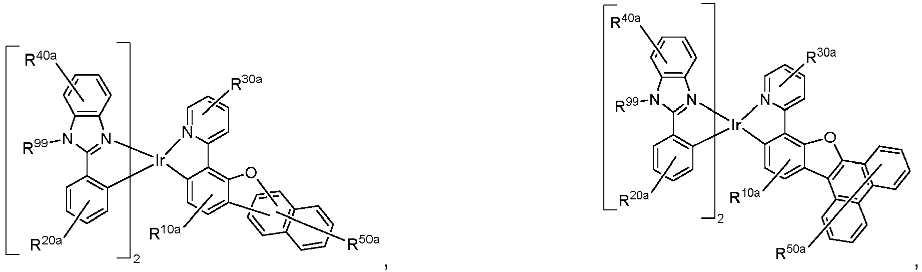 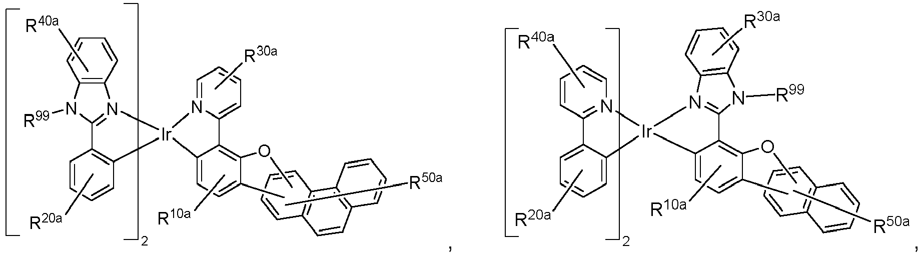 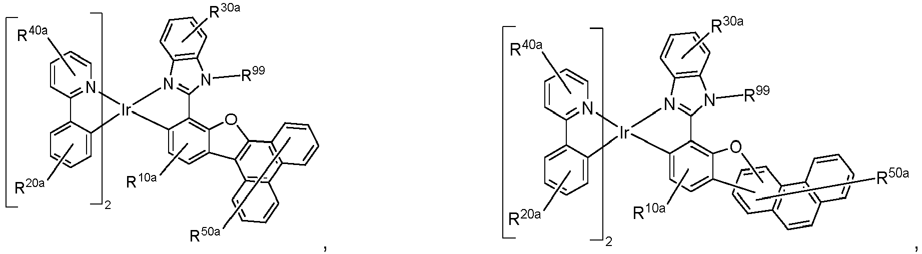 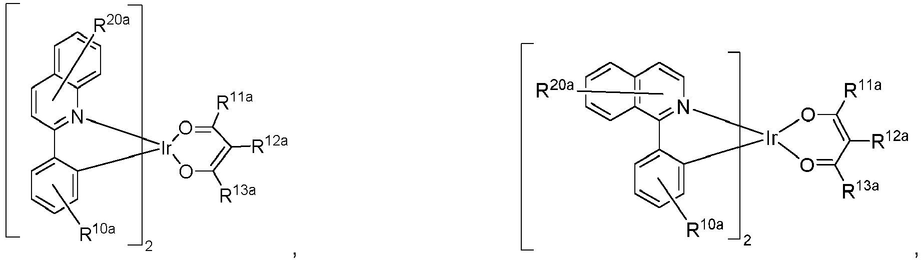 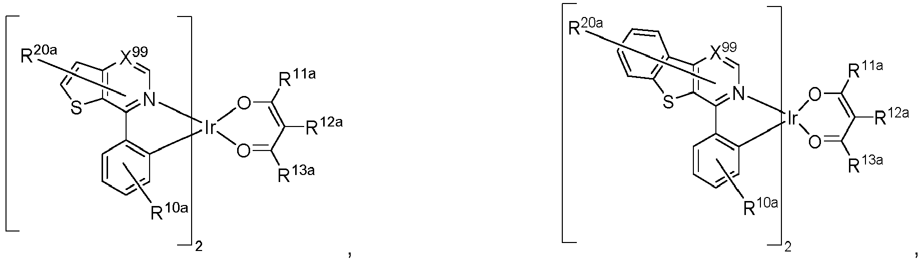 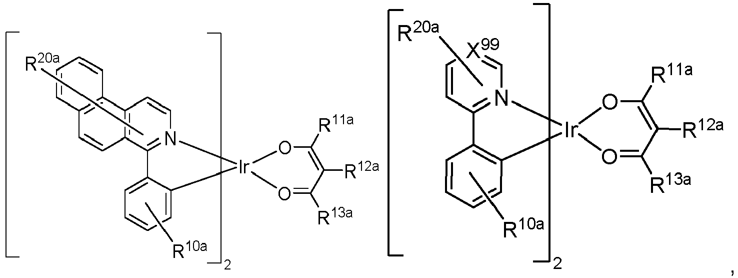 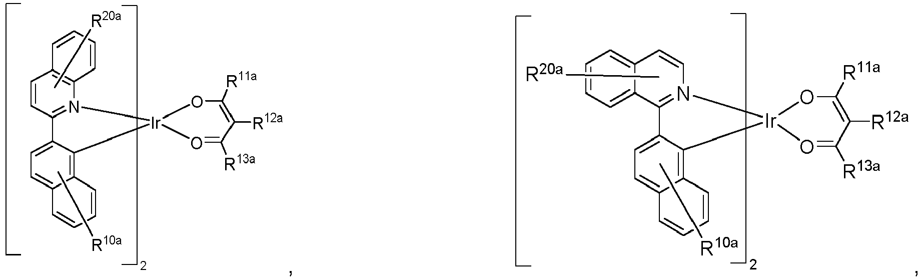 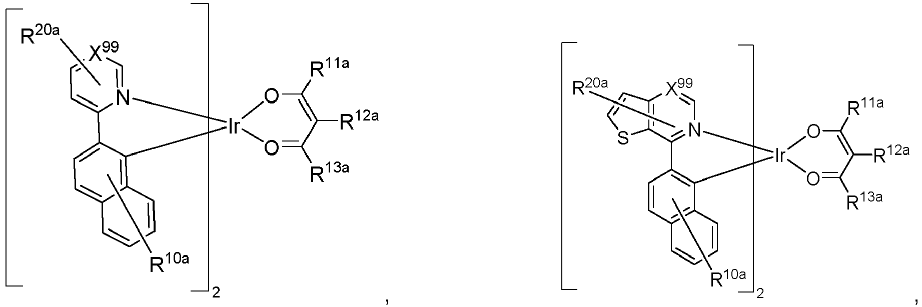 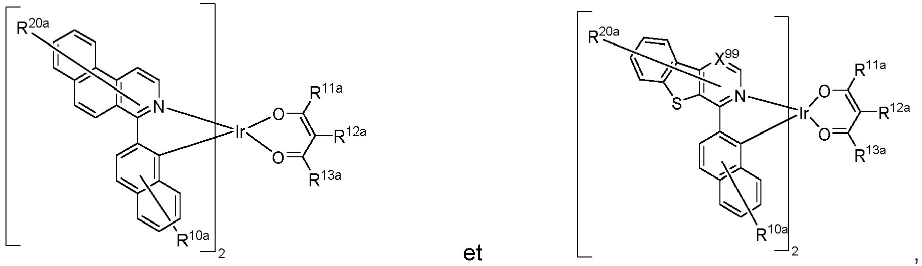 dans laquelle
X⁹⁶ à X⁹⁹ sont chacun, indépendamment les uns des autres, C ou N,
les Y¹⁰⁰ sont chacun choisis indépendamment les uns des autres parmi le groupe constitué d'un NR", O, S et Se,
R^{10a}, R^{20a}, R^{30a}, R^{40a} et R^{50a} représentent chacun, indépendamment les uns des autres, une mono-substitution, jusqu'au nombre maximal de substitutions ou aucune substitution,
R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸ et R⁹⁹ sont chacun, indépendamment les uns des autres, un hydrogène ou un substituant choisi parmi le groupe constitué du deutérium, d'un halogénure, d'un alkyle, d'un cycloalkyle, d'un hétéroalkyle, d'un arylalkyle, d'un alcoxy, d'un aryloxy, d'un amino, d'un silyle, d'un germyle, d'un boryle, d'un sélényle, d'un alcényle, d'un cycloalcényle, d'un hétéroalcényle, d'un alcynyle, d'un aryle, d'un hétéroaryle, d'un acyle, d'un carbonyle, d'un acide carboxylique, d'un ester, d'un nitrile, d'un isonitrile, d'un sulfanyle, d'un sulfinyle, d'un sulfonyle, d'un phosphino et de combinaisons de ceux-ci, et
deux éléments adjacents parmi R^{10a}, R^{11a}, R^{12a}, R^{13a}, R^{20a}, R^{30a}, R^{40a}, R^{50a}, R⁶⁰, R⁷⁰, R⁹⁷, R⁹⁸ et R⁹⁹ sont facultativement réunis ou fusionnés pour former un cycle.

13. OLED selon la revendication 10, dans laquelle l'émetteur phosphorescent est choisi parmi le groupe constitué de : 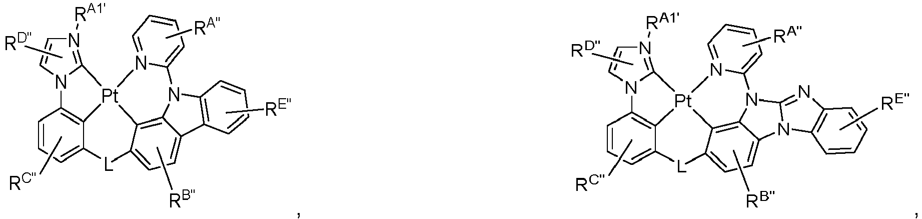 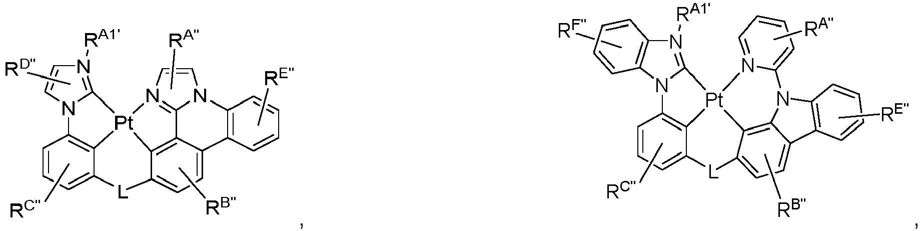 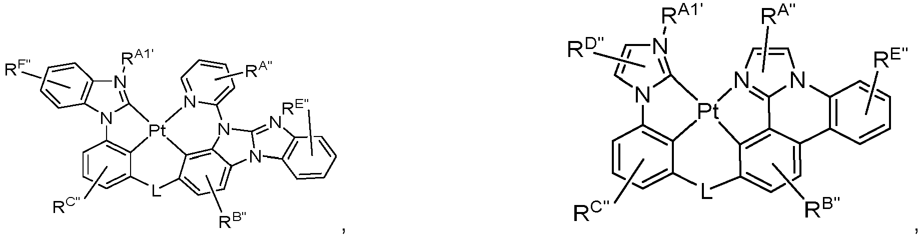 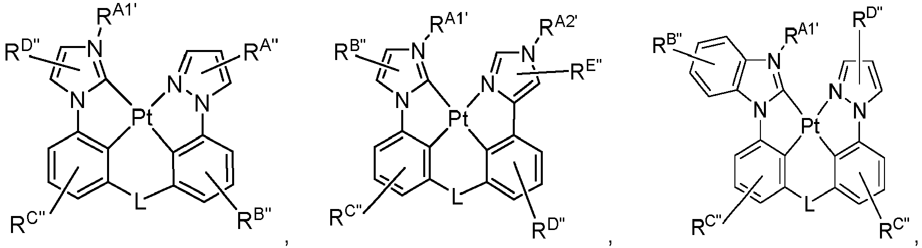 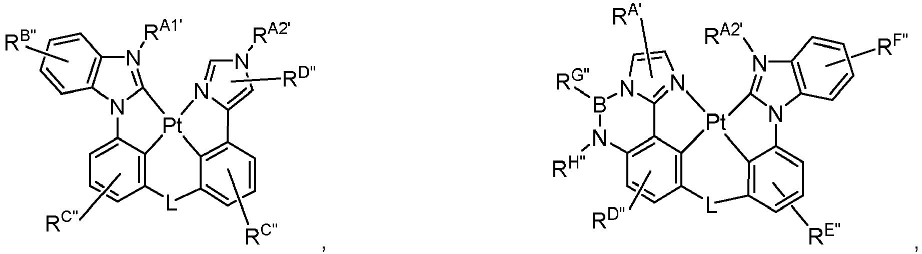 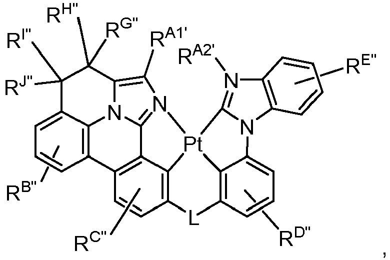 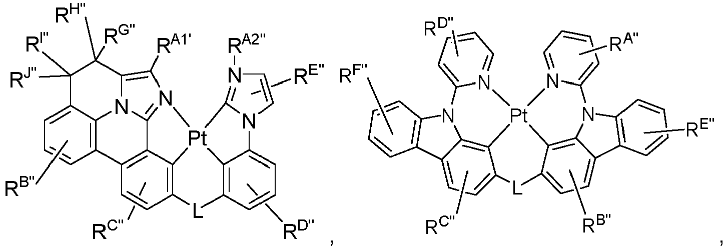 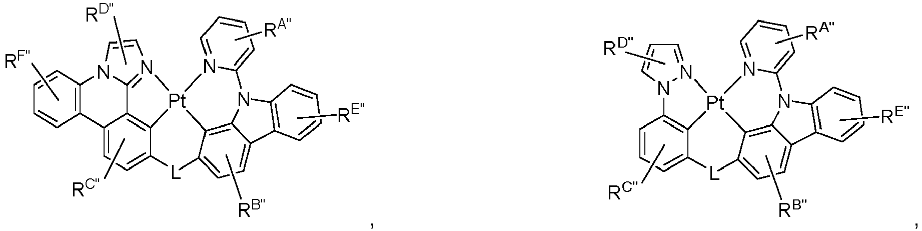 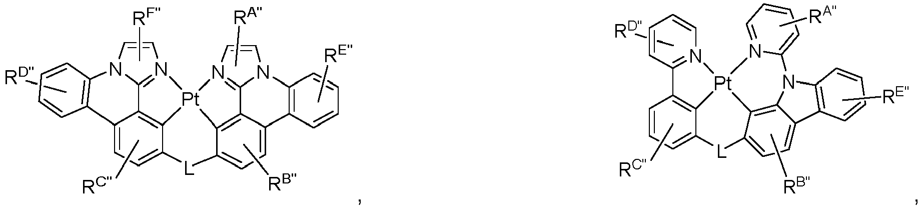 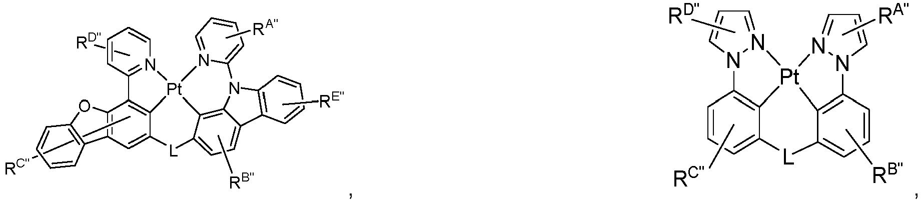 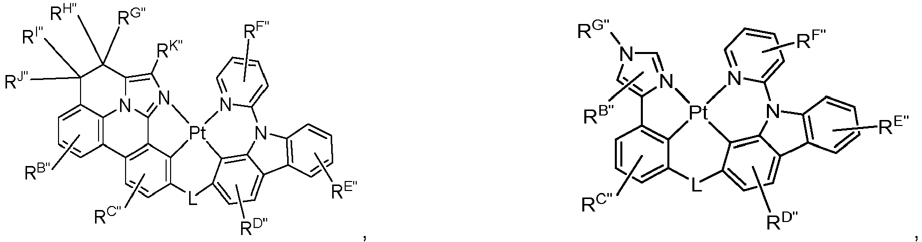 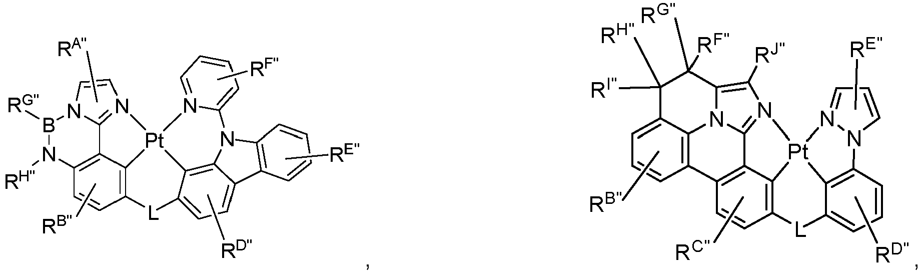 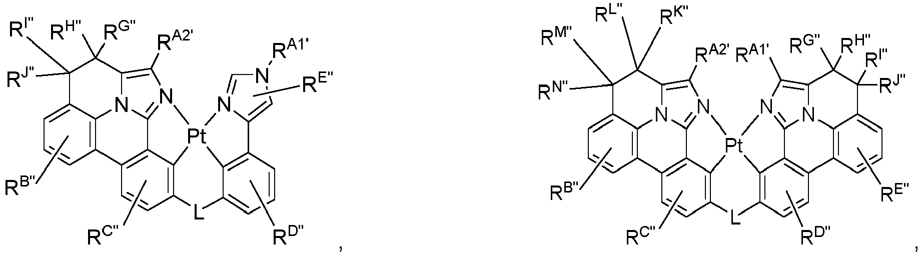 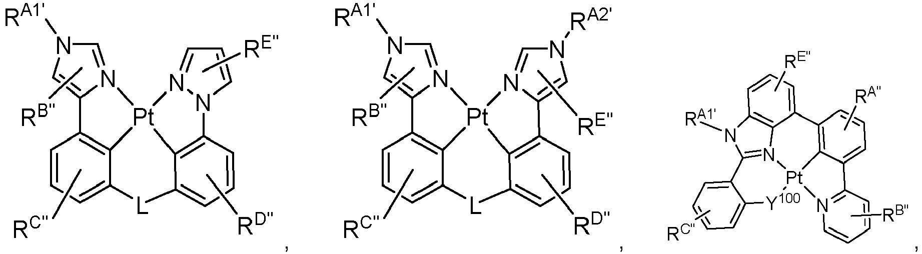 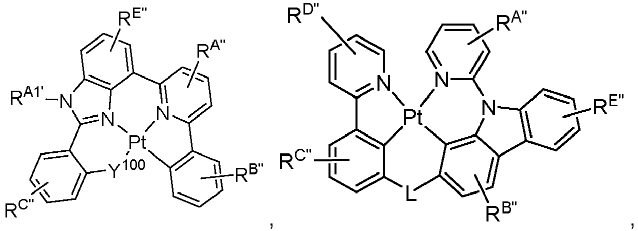 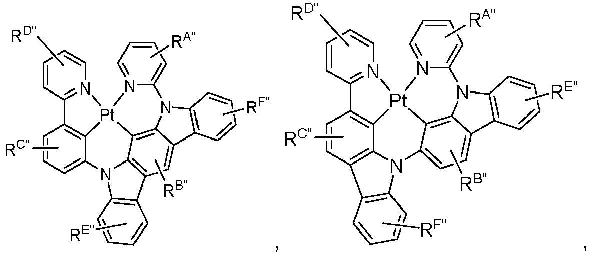 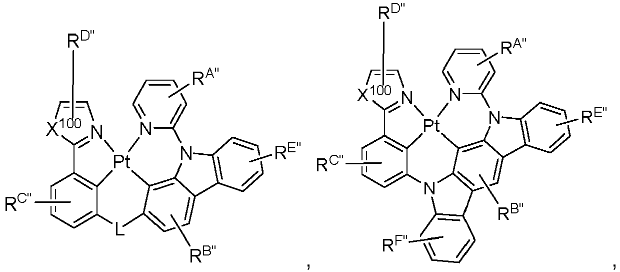 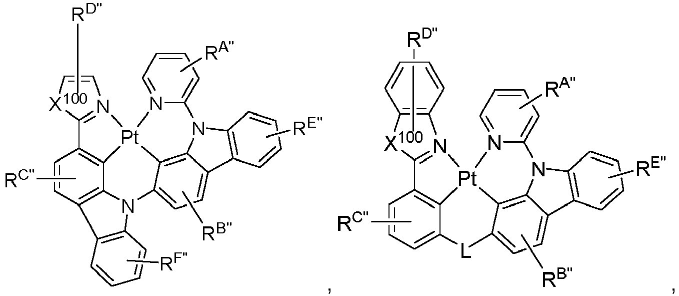 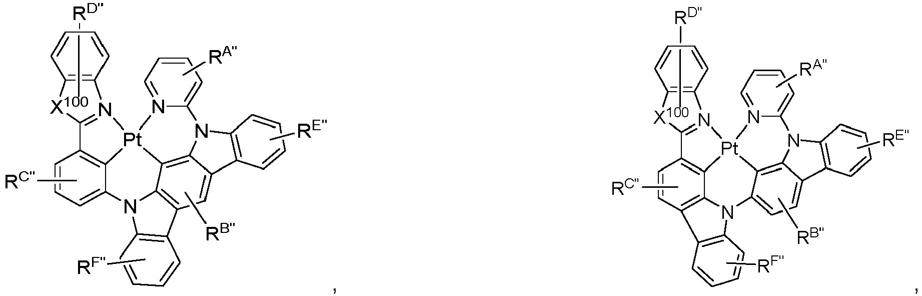 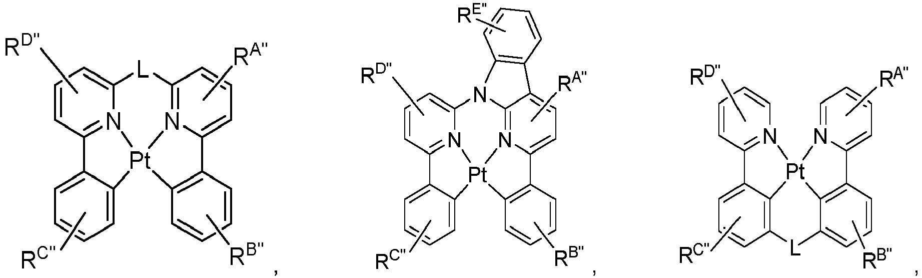 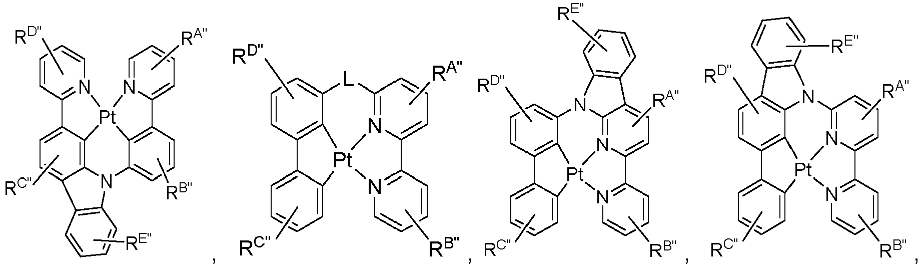 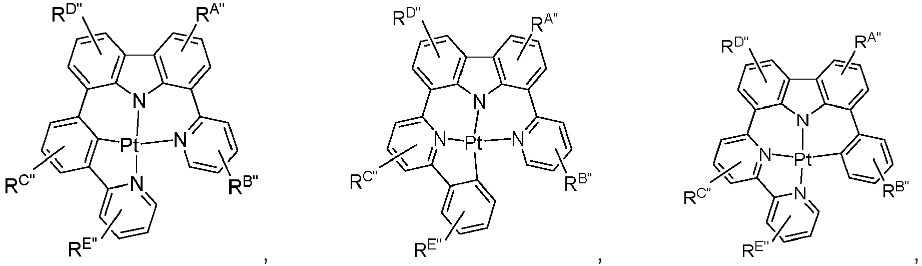 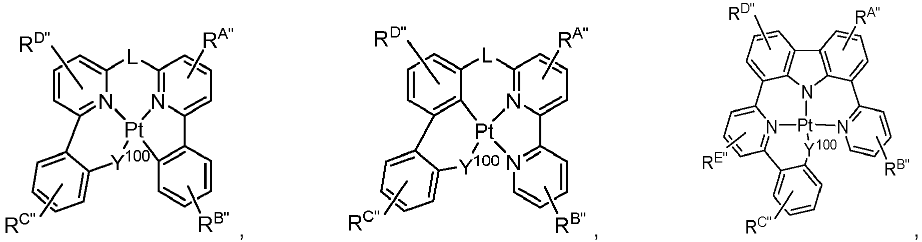 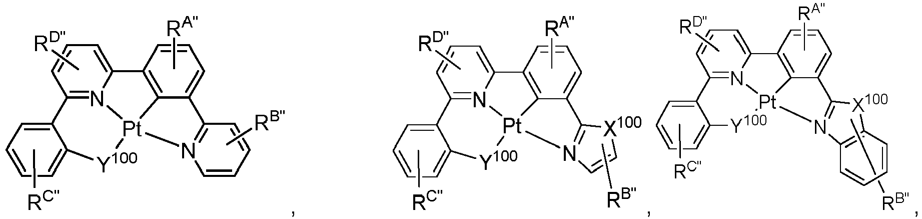 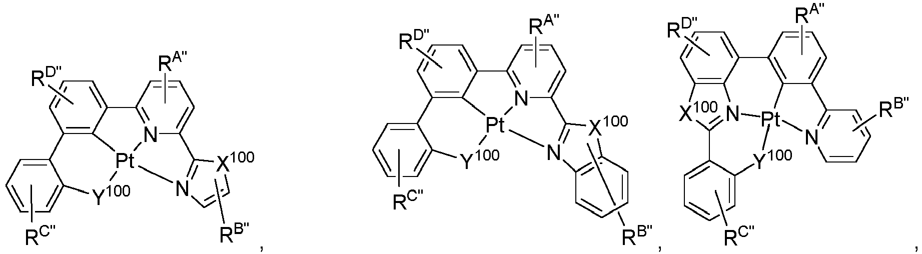 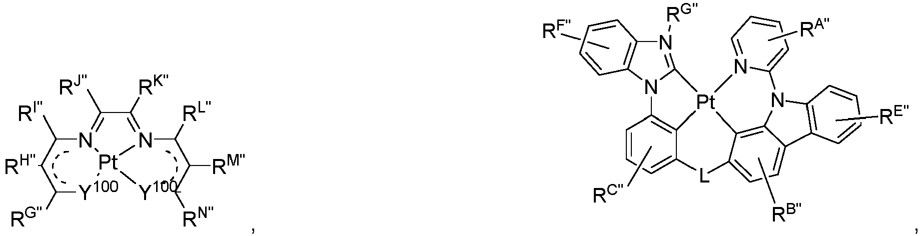 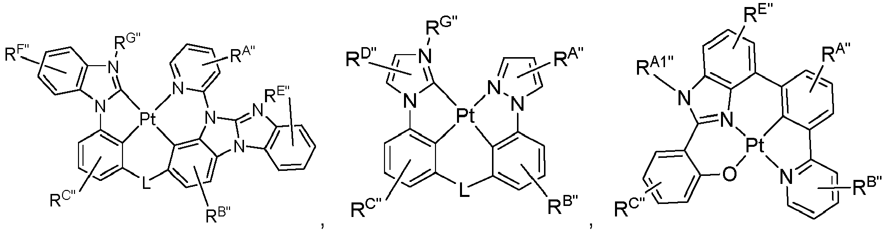 et 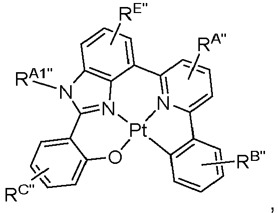 dans laquelle
les Y¹⁰⁰ sont chacun choisis indépendamment les uns des autres parmi le groupe constitué d'un NR", O, S et Se,
les L sont choisis indépendamment les uns des autres parmi le groupe constitué d'une liaison directe, de BR", BR"R‴, NR", PR", O, S, Se, C=O, C=S, C=Se, C=NR", C=CR"R‴, S=O, SO₂, CR", CR"R‴, SiR"R‴, GeR"R‴, d'un alkyle, d'un cycloalkyle, d'un aryle, d'un hétéroaryle et de combinaisons de ceux-ci,
X¹⁰⁰ pour chaque occurrence est choisi parmi le groupe constitué de O, S, Se, NR" et CR"R‴,
R^{A"}, R^{B"}, R^{C"}, R^{D"}, R^{E"} et R^{F"} représentent chacun, indépendamment les uns des autres, une mono-substitution, jusqu'au nombre maximal de substitutions ou aucune substitution,
R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"} et R^{N"} sont chacun, indépendamment les uns des autres, un hydrogène ou un substituant choisi parmi le groupe constitué du deutérium, d'un halogénure, d'un alkyle, d'un cycloalkyle, d'un hétéroalkyle, d'un arylalkyle, d'un alcoxy, d'un aryloxy, d'un amino, d'un silyle, d'un germyle, d'un boryle, d'un sélényle, d'un alcényle, d'un cycloalcényle, d'un hétéroalcényle, d'un alcynyle, d'un aryle, d'un hétéroaryle, d'un acyle, d'un carbonyle, d'un acide carboxylique, d'un ester, d'un nitrile, d'un isonitrile, d'un sulfanyle, d'un sulfinyle, d'un sulfonyle, d'un phosphino et de combinaisons de ceux-ci, et
deux éléments adjacents parmi R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"} et R^{N"} peuvent être facultativement réunis pour former un cycle.

14. OLED selon la revendication 10, dans laquelle l'émetteur phosphorescent est choisi parmi le groupe constitué des matériaux suivants d'émetteur phosphorescent bleu : 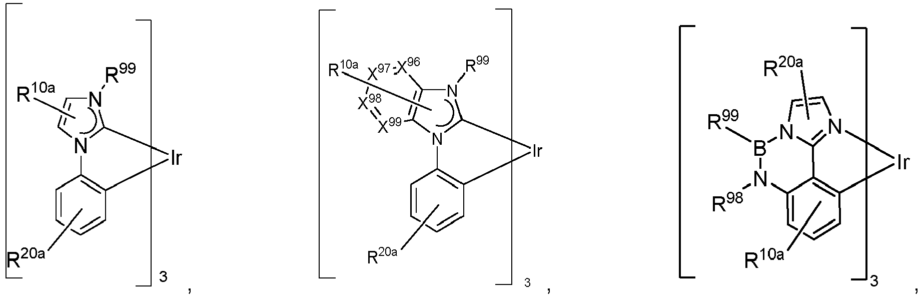 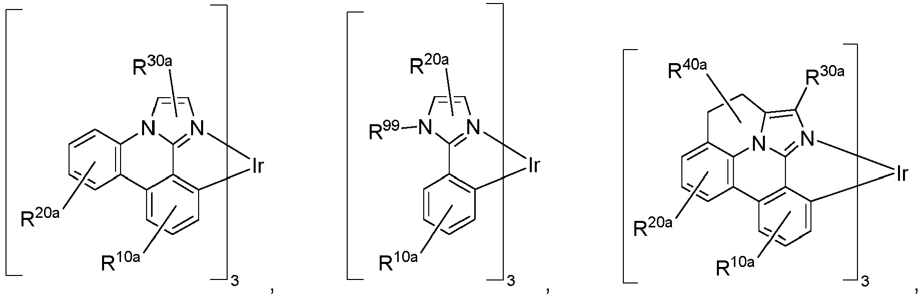 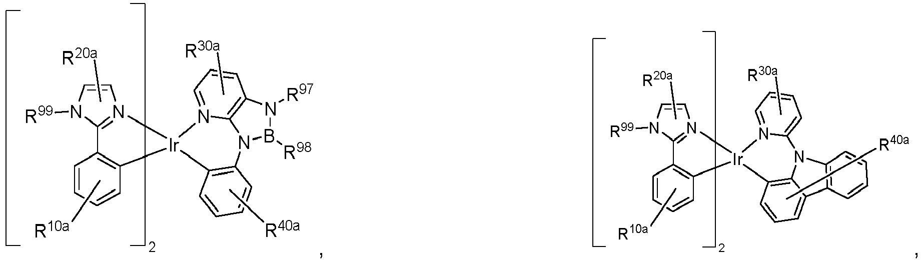 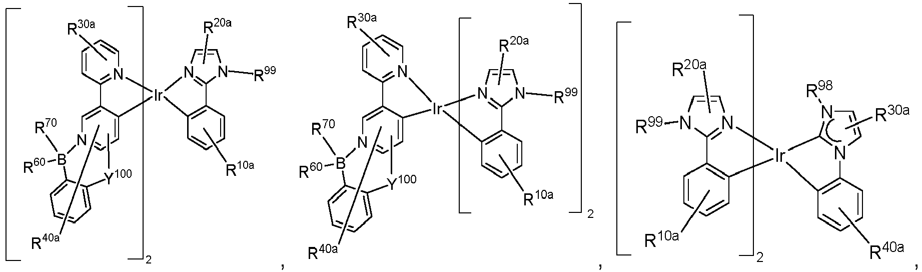 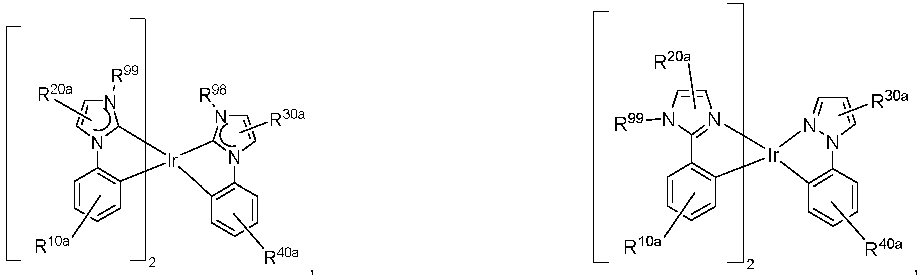 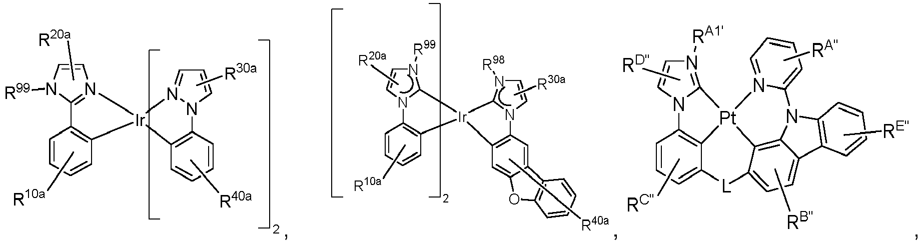 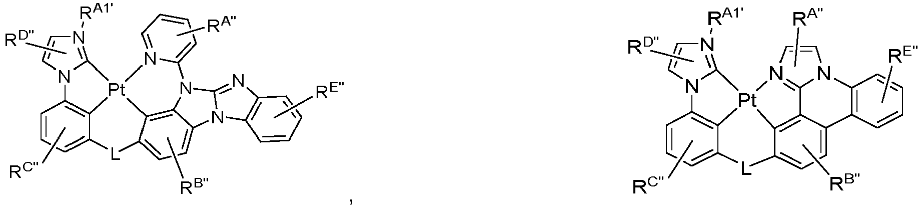 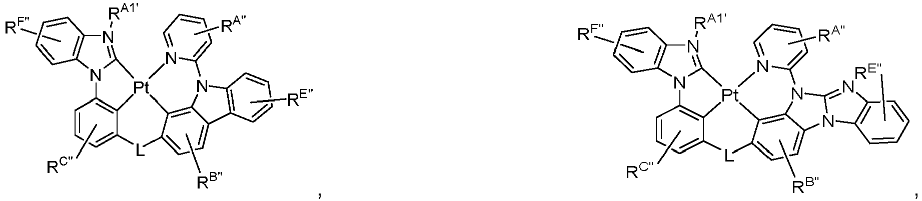 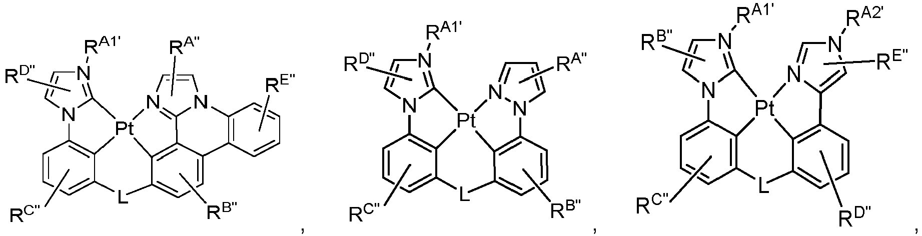 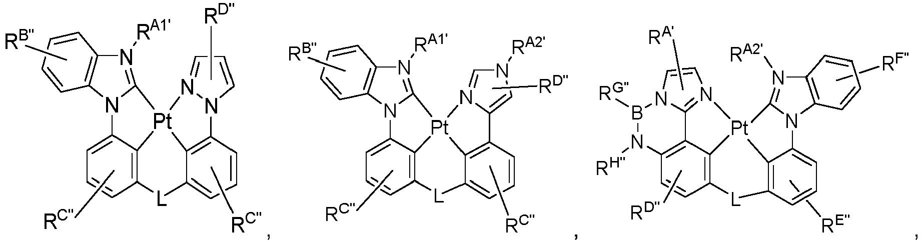 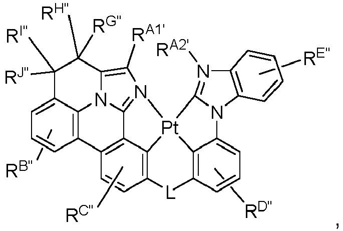 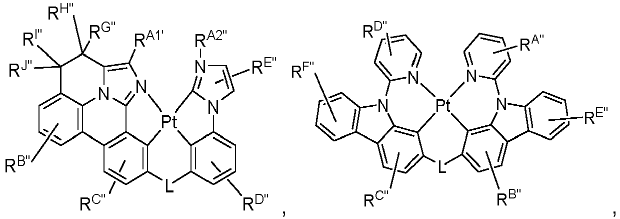 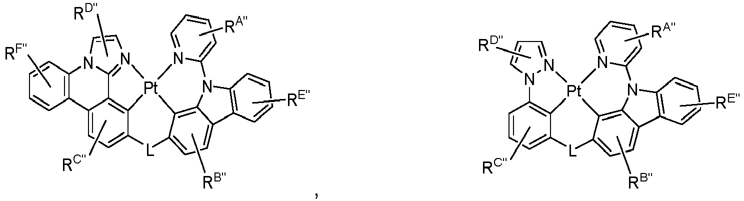 et

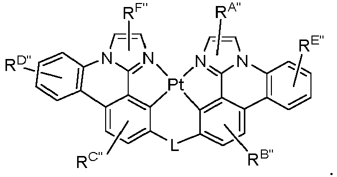

15. Produit de consommation comportant une OLED selon la revendication 1, dans lequel le produit de consommation est un élément parmi un écran plat, un moniteur informatique, un moniteur médical, un téléviseur, un panneau d'affichage, une lumière pour une signalisation et/ou un éclairage intérieur ou extérieur, un affichage tête haute, un écran entièrement ou partiellement transparent, un écran souple, une imprimante laser, un téléphone, un téléphone cellulaire, une tablette, un téléphone-tablette, un assistant numérique personnel (PDA), un dispositif portable, un ordinateur portable, un appareil de prise de vues numérique, un caméscope, un viseur, un micro-écran qui mesure moins de 2 pouces en diagonal, un affichage en 3D, un affichage de réalité virtuelle ou de réalité augmentée, un véhicule, un mur d'images comportant de multiples écrans en mosaïque, un écran de salle de spectacle ou de stade, un dispositif de luminothérapie et une enseigne.
